(19) Europäisches Patentamt
European Patent Office
Office européen des brevets

(11) EP 3 736 278 B1

(12) **EUROPEAN PATENT SPECIFICATION**

(45) Date of publication and mention of the grant of the patent:
**16.02.2022 Bulletin 2022/07**

(21) Application number: **20166235.0**

(22) Date of filing: **27.03.2020**

(51) International Patent Classification (IPC):
***C07F 5/00*** (2006.01) ***C07F 15/00*** (2006.01)
***C07F 15/06*** (2006.01) ***H01L 51/50*** (2006.01)
***H01L 51/00*** (2006.01)

(52) Cooperative Patent Classification (CPC):
**C07F 15/0033; C07F 5/00; C07F 15/0073; C07F 15/06; H01L 51/0085;** H01L 51/0067; H01L 51/5016; H01L 2251/5384

(54) **ORGANOMETALLIC COMPOUND AND ORGANIC LIGHT-EMITTING DEVICE INCLUDING THE SAME**

ORGANOMETALLISCHE VERBINDUNG UND ORGANISCHE LICHTEMITTIERENDE VORRICHTUNG DAMIT

COMPOSÉ ORGANOMÉTALLIQUE ET DISPOSITIF ÉLECTROLUMINESCENT ORGANIQUE L'INCLUANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.05.2019 KR 20190055158**

(43) Date of publication of application:
**11.11.2020 Bulletin 2020/46**

(73) Proprietor: **Samsung Display Co., Ltd.**
**Gyeonggi-Do (KR)**

(72) Inventors:
- **AHN, Eunsoo**
  **Yongin-si (KR)**
- **KO, Soobyung**
  **Yongin-si (KR)**
- **LEE, Hyunjung**
  **Yongin-si (KR)**
- **JEON, Mina**
  **Yongin-si (KR)**
- **KIM, Sungbum**
  **Yongin-si (KR)**
- **KIM, Haejin**
  **Yongin-si (KR)**
- **SHIN, Sujin**
  **Yongin-si (KR)**
- **LEE, Eunyoung**
  **Yongin-si (KR)**
- **LEE, Jaesung**
  **Yongin-si (KR)**
- **HAN, Junghoon**
  **Yongin-si (KR)**

(74) Representative: **Shearman, James Ward**
**Marks & Clerk LLP**
**15 Fetter Lane**
**London EC4A 1BW (GB)**

(56) References cited:
**US-A1- 2017 170 414**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 736 278 B1

## Description

BACKGROUND

1. Field

One or more embodiments relate to an organometallic compound and an organic light-emitting device including the same.

2. Description of the Related Art

Organic light-emitting devices are self emissive devices that produce full-color images, and, compared with a device of the related art, they have a wide viewing angle, a high contrast ratio, and a short response time, and show excellent characteristics in terms of luminance, driving voltage, and response speed.

In an example, an organic light-emitting device may include a first electrode disposed on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons.

These excitons transit from an excited state to a ground state, thereby generating light. US2017/170414 A1 discloses iridium complexes containing hexadentate ligands for use in OLEDs.

SUMMARY

One or more embodiments include a novel organometallic compound and an organic light-emitting device including the same.

Additional aspects will be set forth in part in the description which follows and, in part, will be apparent from the description, or may be learned by practice of the presented embodiments.

An aspect of the present disclosure provides an organometallic compound represented by Formula 1 below:

<Formula 1>

$M(L_1)_{n1}(L_2)_{n2}$

<Formula 2-1>

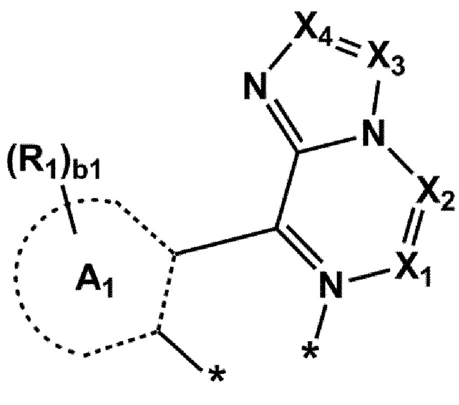

.

In Formula 1, M is selected from iridium (Ir), rhodium (Rh), cobalt (Co), and meitnerium (Mt),

$L_1$ is a ligand represented by Formula 2-1, and n1 is 1, 2, or 3, wherein, when n1 is 2 or more, two or more $L_1$(s) may be identical to or different from each other,
$L_2$ is an organic ligand, and n2 is 0, 1, or 2, wherein, when n2 is 2, two $L_2$(s) may be identical to or different from each other,
the sum of n1 and n2 is 2 or 3,

in Formula 2-1, ring $A_1$ is selected from a $C_5$-$C_{60}$ carbocyclic group and a $C_1$-$C_{60}$ heterocyclic group,
$X_1$ to $X_4$ are each independently $C(R_2)$ or N,
$R_1$ and $R_2$ are each independently selected from hydrogen, deuterium, -F, -Cl, - Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-N(Q_1)(Q_2)$, $-B(Q_1)(Q_2)$, $-P(Q_1)(Q_2)$, $-C(=O)(Q_1)$, $-S(=O)_2(Q_1)$, and $-P(=O)(Q_1)(Q_2)$,
b1 is an integer from 1 to 10,
at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group is selected from:
deuterium (-D), -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, - Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-Si(Q_{11})(Q_{12})(Q_{13})$, $-N(Q_{11})(Q_{12})$, $-B(Q_{11})(Q_{12})$, $-P(Q_{11})(Q_{12})$, $-C(=O)(Q_{11})$, $-S(=O)_2(Q_{11})$, and $-P(=O)(Q_{11})(Q_{12})$;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a C2-C60 alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-Si(Q_{21})(Q_{22})(Q_{23})$, $-N(Q_{21})(Q_{22})$, $-B(Q_{21})(Q_{22})$, $-P(Q_{21})(Q_{22})$, $-C(=O)(Q_{21})$, $-S(=O)_2(Q_{21})$, and $-P(=O)(Q_{21})(Q_{22})$; and
$-Si(Q_{31})(Q_{32})(Q_{33})$, -N(Q31)(Q32), $-B(Q_{31})(Q_{32})$, $-P(Q_{31})(Q_{32})$, $-C(=O)(Q_{31})$, $-S(=O)_2(Q_{31})$, and $-P(=O)(Q_{31})(Q_{32})$,
Q1 to $Q_3$, $Q_{11}$ to $Q_{13}$, $Q_{21}$ to $Q_{23}$, and $Q_{31}$ to $Q_{33}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, a $C_1$-$C_{60}$ alkyl group substituted with at least one selected from deuterium, -F, and a cyano group, a $C_6$-$C_{60}$ aryl group substituted with at least one selected from deuterium, -F, and a cyano group, a biphenyl group, and a terphenyl group, and
* indicates a binding site to M.

Another aspect of the present disclosure provides an organic light-emitting device including:

a first electrode;
a second electrode facing the first electrode;
an organic layer between the first electrode and the second electrode and including an emission layer; and
at least one organometallic compound represented by Formula 1.

At least some of the above and other features of the invention are set out in the claims.

BRIEF DESCRIPTION OF THE DRAWINGS

These and/or other aspects will become apparent and more readily appreciated from the following description of the embodiments, taken in conjunction with the accompanying drawings in which:

FIG. 1 is a schematic view of a structure of an organic light-emitting device according to an embodiment;
FIG. 2 is a schematic view of a structure of an organic light-emitting device according to another embodiment;
FIG. 3 is a schematic view of a structure of an organic light-emitting device according to another embodiment; and
FIG. 4 is a schematic view of a structure of an organic light-emitting device according to another embodiment.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

An aspect of the present disclosure provides an organometallic compound represented by Formula 1:

<Formula 1>

$M(L_1)_{n1}(L_2)_{n2}$

wherein M in Formula 1 is selected from iridium (Ir), rhodium (Rh), cobalt (Co), and meitnerium (Mt). For example, M in Formula 1 may be selected from iridium (Ir), rhodium (Rh) and cobalt (Co). For example, M in Formula 1 may be iridium (Ir). For example, M in Formula 1 may be rhodium (Rh). For example, M in Formula 1 may be cobalt (Co). [0043] [0044]

<Formula 2-1>

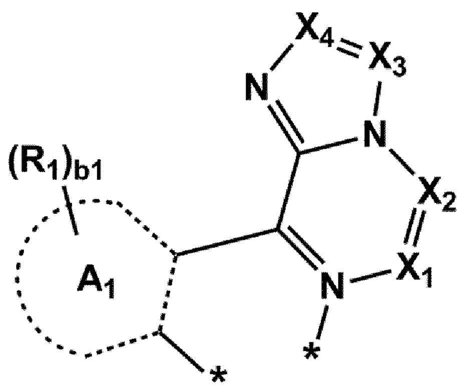

$L_1$ in Formula 1 is a ligand represented by Formula 2-1, and n1 is 1, 2, or 3, wherein, when n1 is 2 or more, two or more $L_1$(s) are identical to or different from each other,

$L_2$ in Formula 1 is an organic ligand, and n2 is 0, 1, or 2, wherein when n2 is 2, two $L_2$(s) are identical to or different from each other, and

the sum of n1 and n2 is 2 or 3.

In one embodiment, in Formula 1, n1 may be 1, n2 may be 1, and $L_2$ may be a tetradentate ligand.

In Formula 2-1, ring $A_1$ is selected from a $C_5$-$C_{60}$ carbocyclic group and a $C_1$-$C_{60}$ heterocyclic group. For example, in Formula 2-1, ring $A_1$ may be selected from a $C_5$-$C_{30}$ carbocyclic group and a $C_1$-$C_{20}$ heterocyclic group. For example, in Formula 2-1, ring $A_1$ may be selected from a $C_5$-$C_{20}$ carbocyclic group and a $C_1$-$C_{20}$ heterocyclic group. For example, in Formula 2-1, ring $A_1$ may be selected from a $C_5$-$C_{15}$ carbocyclic group and a $C_1$-$C_{15}$ heterocyclic group. For example, in Formula 2-1, ring $A_1$ may be selected from a $C_6$-$C_{15}$ carbocyclic group and a $C_1$-$C_{15}$ heterocyclic group. For example, in Formula 2-1, ring $A_1$ may be selected from a $C_6$-$C_{10}$ carbocyclic group and a $C_1$-$C_{10}$ heterocyclic group.

For example, in Formula 2-1, ring $A_1$ may be selected from a $C_6$-$C_{10}$ carbocyclic group and a $C_3$-$C_{10}$ heterocyclic group. For example, in Formula 2-1, ring $A_1$ may be selected from a $C_6$-$C_{10}$ carbocyclic group and a $C_3$-$C_5$ heterocyclic group.

In one embodiment, ring $A_1$ in Formula 2-1 may be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a pyrrole group, an indole group, an indene group, a benzosilole group, a benzothiophene group, a benzofuran group, a carbazole group, a fluorene group, a dibenzosilole group, a dibenzothiophene group, a dibenzofuran group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group and a benzoquinazoline group.

For example, ring $A_1$ may be a benzene group or a pyridine group, but embodiments of the present disclosure are not limited thereto.

$X_1$ to $X_4$ in Formula 2-1 are each independently $C(R_2)$ or N.

In one embodiment, $X_1$ to $X_4$ in Formula 2-1 may each independently be $C(R_2)$.

$R_1$ and $R_2$ in Formula 2-1 are each independently selected from hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ *(e.g.* $C_1$-$C_{20}$) alkyl group, a substituted or unsubstituted $C_2$-$C_{60}$ *(e.g.* $C_2$-$C_{20}$) alkenyl group, a substituted or unsubstituted $C_2$-$C_{60}$ (*e.g.* $C_2$-$C_{20}$) alkynyl group, a substituted or unsubstituted $C_1$-$C_{60}$ (*e.g.* $C_1$-$C_{20}$) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* $C_6$-$C_{30}$) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-N(Q_1)(Q_2)$, $-B(Q_1)(Q_2)$, $-P(Q_1)(Q_2)$, $-C(=O)(Q_1)$, $-S(=O)_2(Q_1)$, and $-P(=O)(Q_1)(Q_2)$.

In one embodiment, $R_1$ and $R_2$ in Formula 2-1 may each independently be selected from:

hydrogen, deuterium, -F, -Cl, -Br, -I, a hydroxyl group, a cyano group, a nitro group, an amidino group, a hydrazino group, a hydrazono group, a $C_1$-$C_{20}$ (*e.g.* $C_1$-$C_{10}$) alkyl group, a $C_2$-$C_{20}$ (*e.g.* $C_2$-$C_{10}$) alkenyl group, a $C_2$-$C_{20}$ (*e.g.* $C_2$-$C_{10}$) alkynyl group, and a $C_1$-$C_{20}$ (*e.g.* $C_1$-$C_{10}$) alkoxy group;

a $C_1$-$C_{20}$ (*e.g.* $C_1$-$C_{10}$) alkyl group, a $C_2$-$C_{20}$ (*e.g.* $C_2$-$C_{10}$) alkenyl group, a $C_2$-$C_{20}$ (*e.g.* $C_2$-$C_{10}$) alkynyl group, and a $C_1$-$C_{20}$ (*e.g.* $C_1$-$C_{10}$) alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazino group, a hydrazono group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and $-P(=O)(Q_{31})(Q_{32})$;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a

quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazino group, a hydrazono group, a $C_1$-$C_{20}$ (*e.g.* $C_1$-$C_{10}$) alkyl group, a $C_2$-$C_{20}$ (*e.g.* $C_2$-$C_{10}$) alkenyl group, a $C_2$-$C_{20}$ (*e.g.* $C_2$-$C_{10}$) alkynyl group, a $C_1$-$C_{20}$ (*e.g.* $C_1$-$C_{10}$) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and $-P(=O)(Q_{31})(Q_{32})$; and

$-Si(Q_1)(Q_2)(Q_3)$, $-N(Q_1)(Q_2)$, $-B(Q_1)(Q_2)$, $-C(=O)(Q_1)$, $-S(=O)_2(Q_1)$, $-P(Q_1)(Q_2)$, and $-P(=O)(Q_1)(Q_2)$, and

$Q_1$ to $Q_3$ and $Q_{31}$ to $Q_{33}$ may each independently be selected from:

hydrogen, deuterium, -F, -Cl, -Br, -I, a cyano group, a $C_1$-$C_{20}$ (*e.g.* $C_1$-$C_{10}$) alkyl group, a $C_2$-$C_{20}$ (*e.g.* $C_2$-$C_{10}$) alkenyl group, a $C_2$-$C_{20}$ (*e.g.* $C_2$-$C_{10}$) alkynyl group, a $C_1$-$C_{20}$ (*e.g.* $C_1$-$C_{10}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{20}$ aryl group, a $C_1$-$C_{20}$ (*e.g.* $C_1$-$C_{10}$) heteroaryl group, a monovalent non-aromatic condensed polycyclic group, and a monovalent non-aromatic condensed heteropolycyclic group;

a $C_1$-$C_{20}$ (*e.g.* $C_1$-$C_{10}$) alkyl group substituted with at least one selected from deuterium, -F, and a cyano group;

a $C_6$-$C_{20}$ aryl group substituted with at least one selected from deuterium, -F, and a cyano group; and

a biphenyl group and a terphenyl group.

For example, $R_1$ may be hydrogen or -F, but embodiments of the present disclosure are not limited thereto. For example, $R_1$ may be -F, but embodiments of the present disclosure are not limited thereto.

In one embodiment, i) in Formula 2-1, $X_1$ and $X_2$ may each independently be $C(R_2)$, and $R_2$ may be hydrogen; or ii) in Formula 2-1, $X_3$ and $X_4$ may each independently be $C(R_2)$, and $R_2$ may be a methyl group, a t-butyl group, or an isopropyl group.

In Formula 2-1, b1 is an integer from 1 to 10 (*e.g.* 1 to 5), wherein, when b1 is 2 or more, two or more $R_1$(s) are identical to or different from each other, and

in Formula 2-1, two neighboring groups selected from $R_1$(s) in the number of b1 may optionally be linked to form a substituted or unsubstituted $C_5$-$C_{30}$ carbocyclic group or a substituted or unsubstituted $C_1$-$C_{30}$ heterocyclic group.

In one embodiment, $L_1$ may be a ligand selected from groups represented by Formulae 2-1(1) and 2-1(2):

<Formula 2-1(1)>

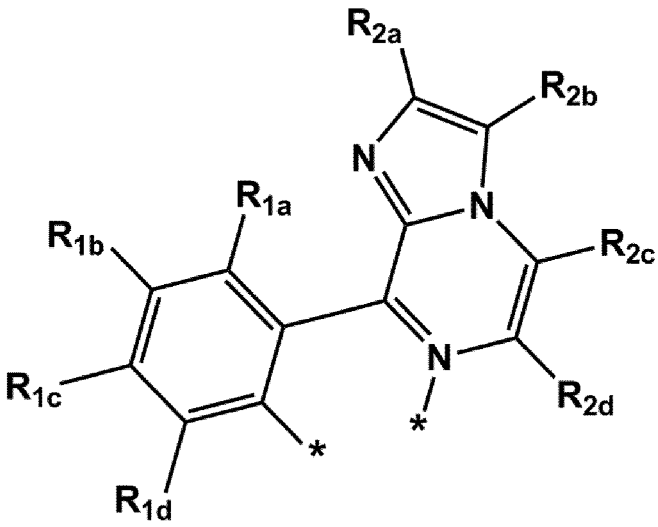

<Formula 2-1(2)>

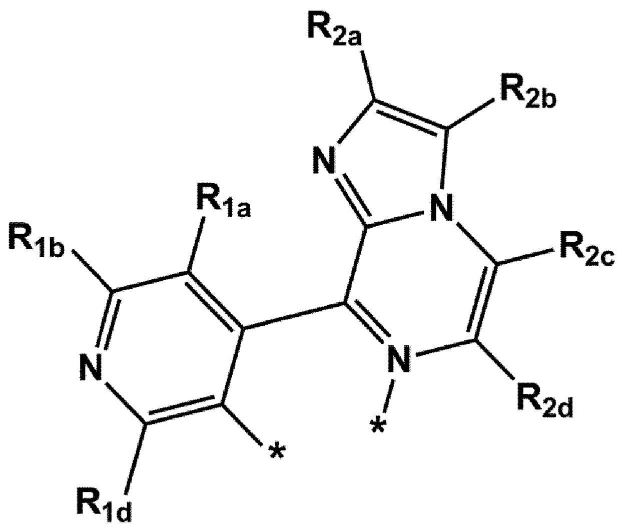

.

In Formulae 2-1 (1) and 2-1(2),

$R_{1a}$ to $R_{1d}$, and $R_{2a}$ to $R_{2d}$ are each independently the same as defined in connection with $R_1$ and $R_2$, and
* indicates a binding site to M.

For example, in Formulae 2-1(1) and 2-1(2), $R_{1b}$ and $R_{1d}$ may each independently be hydrogen or -F, but embodiments of the present disclosure are not limited thereto.

In one embodiment, $L_2$ may be a ligand represented by Formula 2-2 or 2-3:

<Formula 2-2>

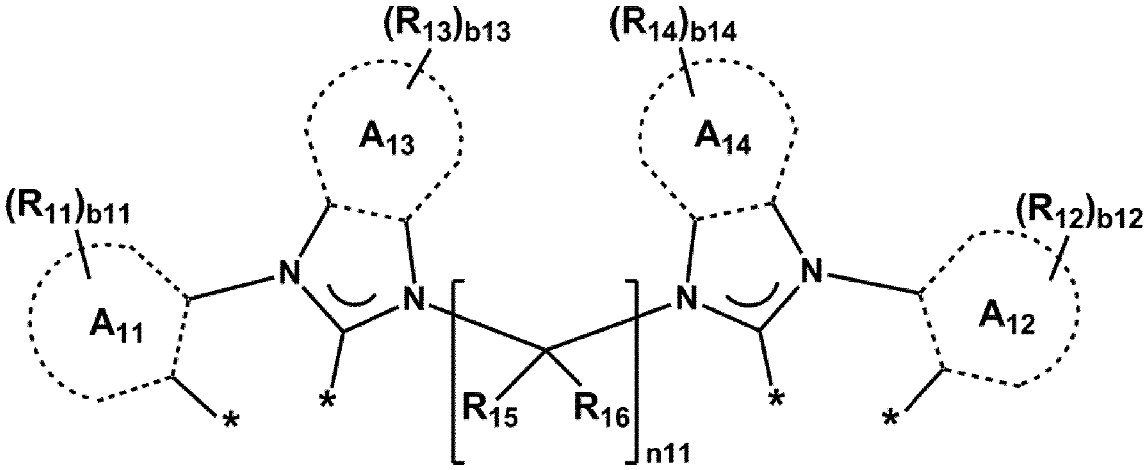

<Formula 2-3>

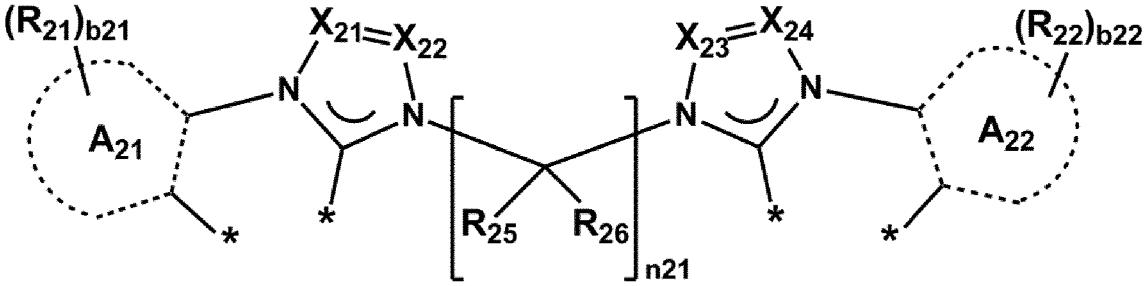

In Formula 2-2 or 2-3,

$X_{21}$ and $X_{22}$ are each independently $C(R_{23})$ or N,
$X_{23}$ and $X_{24}$ are each independently $C(R_{24})$ or N,
ring $A_{11}$ to ring $A_{14}$, ring $A_{21}$, ring $A_{22}$, $R_{11}$ to $R_{16}$, $R_{21}$ to $R_{26}$, b11 to b14, b21, b22, and * are each independently the same as defined in connection with $A_1$, $R_1$, b1, and *, and
n11 and n21 are each independently an integer from 2 to 6.

In one embodiment, ring $A_{11}$ to ring $A_{14}$, ring $A_{21}$, and ring $A_{22}$ in Formula 2-2 or 2-3 may each independently be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a pyrrole group, an indole group, an indene group, a benzosilole group, a benzothiophene group, a benzofuran group, a carbazole group, a fluorene group, a dibenzosilole group, a dibenzothiophene group, a dibenzofuran group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, and a benzoquinazoline group.

For example, ring $A_{11}$ to ring $A_{14}$ in Formula 2-2 may each independently be selected from a benzene group, a pyridine group, and a pyrazine group, but embodiments of the present disclosure are not limited thereto.

For example ring $A_{11}$ and ring $A_{12}$ in Formula 2-2 may each independently be a benzene group, but embodiments of the present disclosure are not limited thereto.

For example, ring $A_{21}$ and ring $A_{22}$ in Formula 2-3 may each independently be a benzene group, but embodiments of the present disclosure are not limited thereto.

In one embodiment, $X_{21}$ and $X_{22}$ in Formula 2-2 may each independently be C(R23), and $X_{23}$ and $X_{24}$ in Formula

2-3 may each independently be C(R24).

In one embodiment, $R_{11}$ to $R_{16}$ and $R_{21}$ to $R_{26}$ in Formula 2-2 or 2-3 may each independently be selected from:

hydrogen, deuterium, -F, -Cl, -Br, -I, a hydroxyl group, a cyano group, a nitro group, an amidino group, a hydrazino group, a hydrazono group, a $C_1$-$C_{20}$ (e.g. $C_1$-$C_{10}$) alkyl group, a $C_2$-$C_{20}$ (*e.g.* $C_2$-$C_{10}$) alkenyl group, a $C_2$-$C_{20}$ (*e.g.* $C_2$-$C_{10}$) alkynyl group, and a $C_1$-$C_{20}$ (*e.g.* $C_1$-$C_{10}$) alkoxy group;

a $C_1$-$C_{20}$ (*e.g.* $C_1$-$C_{10}$) alkyl group, a $C_2$-$C_{20}$ (*e.g.* $C_2$-$C_{10}$) alkenyl group, a $C_2$-$C_{20}$ (*e.g.* $C_2$-$C_{10}$) alkynyl group, and a $C_1$-$C_{20}$ (*e.g.* $C_1$-$C_{10}$) alkoxy group, each substituted with at least one selected from deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amidino group, a hydrazino group, a hydrazono group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, -$Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and - $P(=O)(Q_{31})(Q_{32})$;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amidino group, a hydrazino group, a hydrazono group, a $C_1$-$C_{20}$ *(e.g.* $C_1$-$C_{10}$) alkyl group, a $C_2$-$C_{20}$ *(e.g.* $C_2$-$C_{10}$) alkenyl group, a $C_2$-$C_{20}$ (*e.g.* $C_2$-$C_{10}$) alkynyl group, a $C_1$-$C_{20}$ (*e.g.* $C_1$-$C_{10}$) alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and - $P(=O)(Q_{31})(Q_{32})$; and

$-Si(Q_1)(Q_2)(Q_3)$, $-N(Q_1)(Q_2)$, $-B(Q_1)(Q_2)$, $-C(=O)(Q_1)$, $-S(=O)_2(Q_1)$, $-P(Q_1)(Q_2)$, and $-P(=O)(Q_1)(Q_2)$, and

$Q_1$ to $Q_3$ and $Q_{31}$ to $Q_{33}$ may each independently be selected from:

hydrogen, deuterium, -F, -Cl, -Br, -I, a cyano group, a $C_1$-$C_{20}$ (e.g. $C_1$-$C_{10}$) alkyl group, a $C_2$-$C_{20}$ (*e.g.* $C_2$-$C_{10}$) alkenyl group, a $C_2$-$C_{20}$ (*e.g.* $C_2$-$C_{10}$) alkynyl group, a $C_1$-$C_{20}$ (*e.g.* $C_1$-$C_{10}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{20}$ aryl group, a $C_1$-$C_{20}$ heteroaryl group, a monovalent non-aromatic condensed polycyclic group, and a monovalent non-aromatic condensed heteropolycyclic group;
a $C_1$-$C_{20}$ (*e.g.* $C_1$-$C_{10}$) alkyl group substituted with at least one selected from deuterium, -F, and a cyano group;
a $C_6$-$C_{20}$ aryl group substituted with at least one selected from deuterium, -F, and a cyano group; and
a biphenyl group and a terphenyl group.

For example $R_{11}$ and $R_{12}$ in Formula 2-2 may each independently be hydrogen, -F, -Cl, -Br, -I, a methyl group, or an isopropyl group, but embodiments of the present disclosure are not limited thereto.

For example, $R_{13}$ to $R_{16}$ in Formula 2-2 may each independently be hydrogen, but embodiments of the present disclosure are not limited thereto.

For example, $R_{21}$ and $R_{22}$ in Formula 2-3 may each independently be hydrogen, -F, -Cl, -Br, -I, a methyl group, or an isopropyl group, but embodiments of the present disclosure are not limited thereto.

For example, $R_{25}$ and $R_{26}$ in Formula 2-3 may each independently be hydrogen, but embodiments of the present disclosure are not limited thereto.

For example, n11 in Formula 2-2 may be 4, and n21 in Formula 2-3 may be 4, but embodiments of the present disclosure are not limited thereto.

For example, in Formula 2-3, $X_{21}$ and $X_{22}$ may each independently be C($R_{23}$), X23 and $X_{24}$ may each independently be C(R24), $R_{23}$ and $R_{24}$ may be identical to each other, and $R_{23}$ and $R_{24}$ may each independently be hydrogen or a methyl group, but embodiments of the present disclosure are not limited thereto.

In one embodiment, $L_2$ may be a ligand selected from groups represented by Formulae 2-2(1) to 2-2(3) and 2-3(1):

<Formula 2-2(1)>

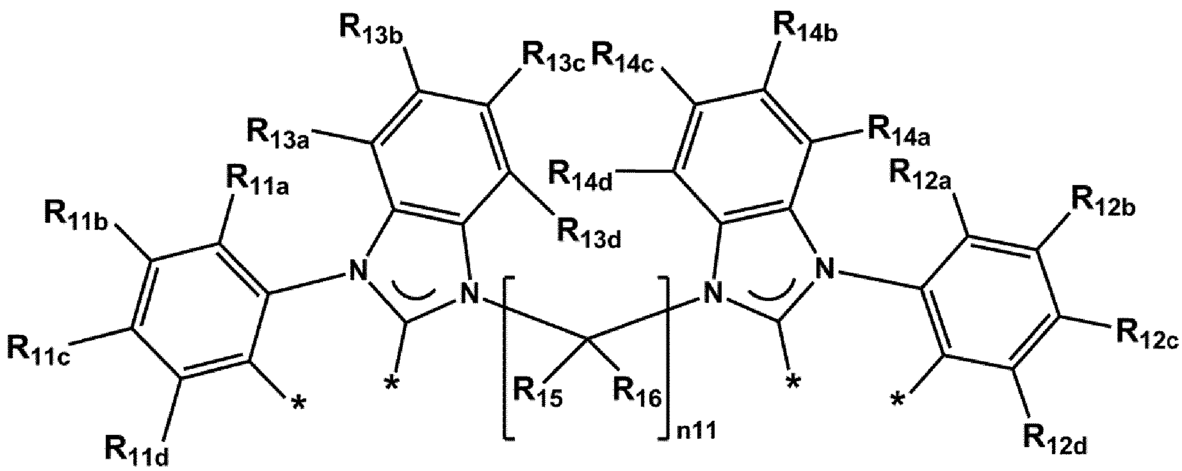

<Formula 2-2(2)>

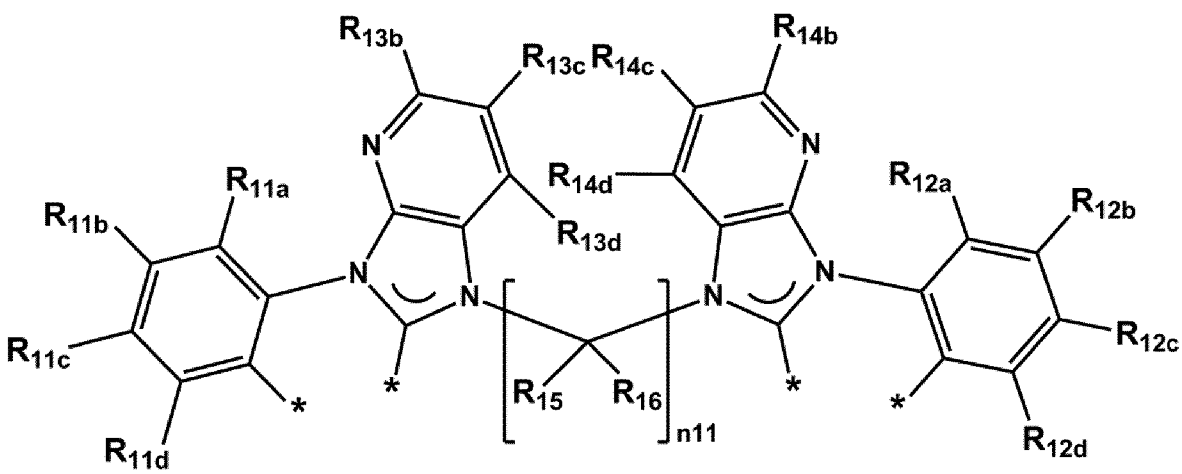

<Formula 2-2(3)>

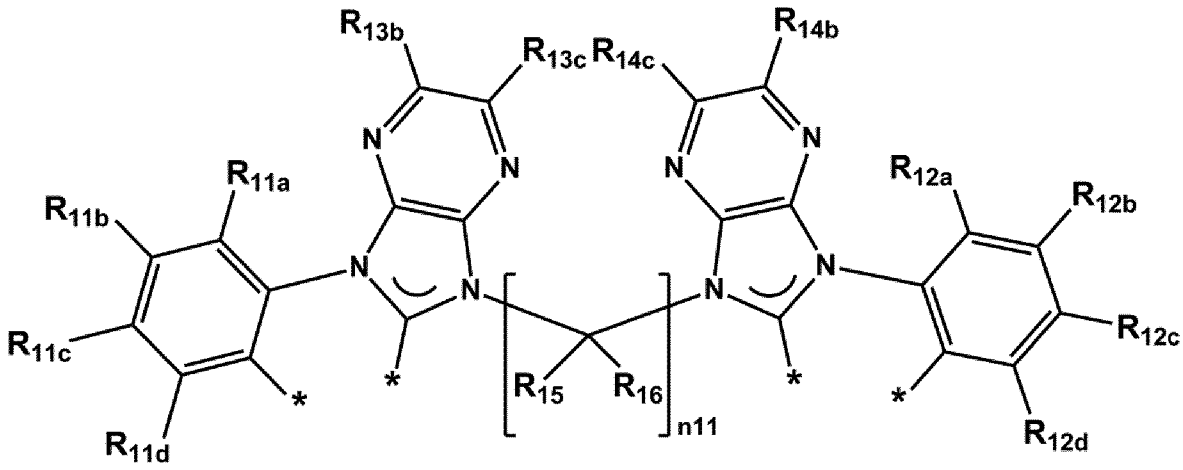

<Formula 2-3(1)>

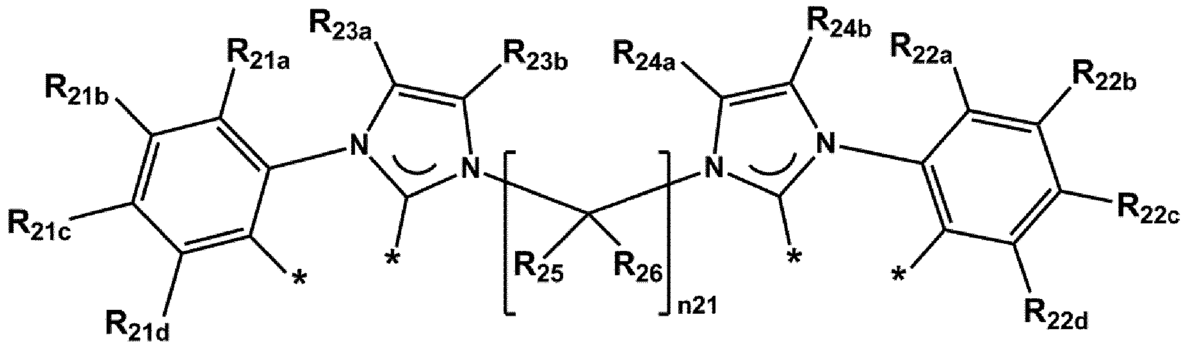

In Formulae 2-2(1) to 2-2(3) and 2-3(1),

descriptions of $R_{11a}$ to $R_{11d}$, $R_{12a}$ to $R_{12d}$, $R_{13a}$ to $R_{13d}$, $R_{14a}$ to $R_{14d}$, $R_{21a}$ to $R_{21d}$, $R_{22a}$ to $R_{22d}$, $R_{23a}$, $R_{23b}$, $R_{24a}$, R24b, n11, and n21 may be understood by referring to corresponding description provided in connection with $R_{11}$ to $R_{16}$, $R_{21}$ to $R_{26}$, n11, and n21, and

* indicates a binding site to M.

In one embodiment, the organometallic compound may be selected from Compounds BD1 to BD59, but embodiments of the present disclosure are not limited thereto:

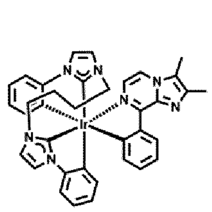

BD1

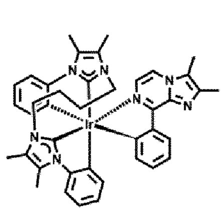

BD2

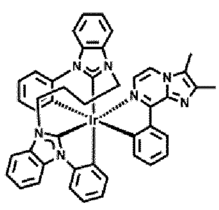

BD3

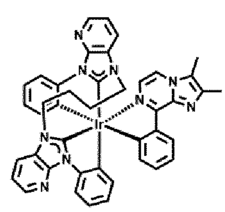

BD4

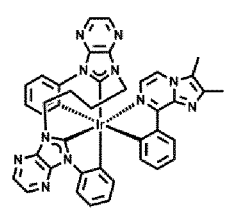

BD5

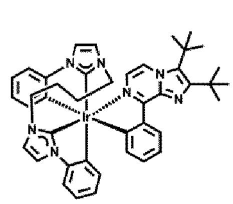
BD6
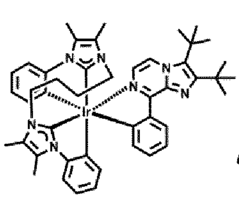
BD7
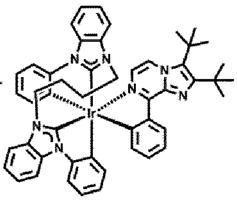
BD8
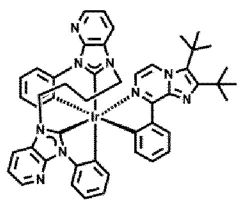
BD9
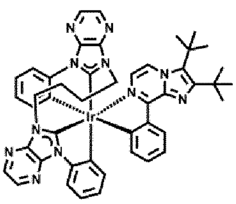
BD10

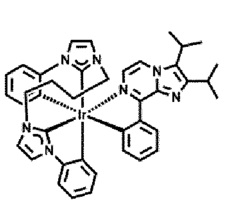
BD11
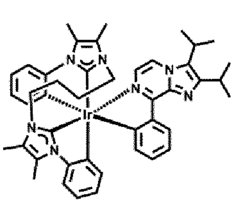
BD12
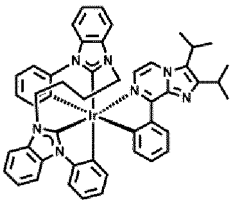
BD13
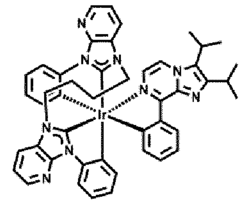
BD14
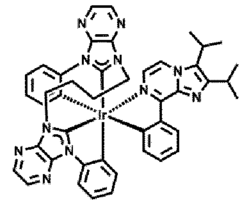
BD15

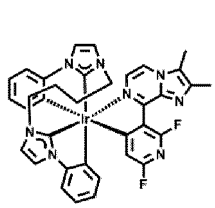
BD16
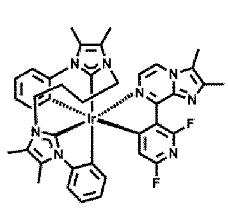
BD17
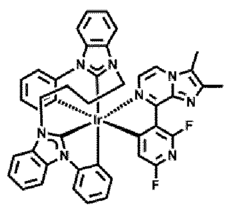
BD18
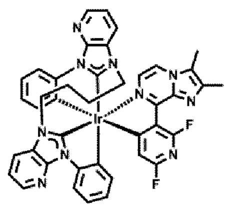
BD19
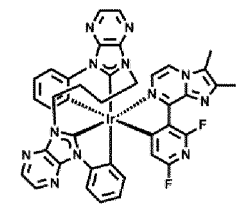
BD20

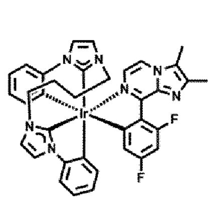
BD21
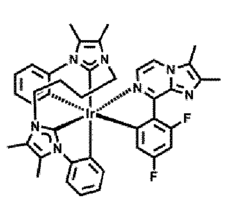
BD22
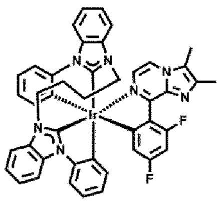
BD23
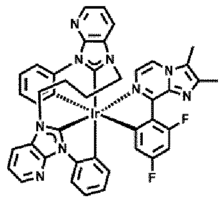
BD24
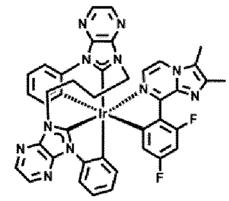
BD25

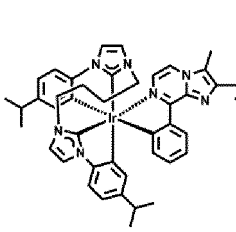
BD26
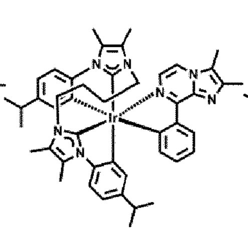
BD27
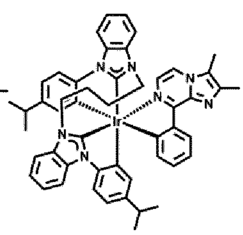
BD28
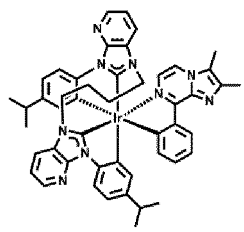
BD29
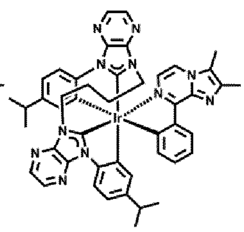
BD30

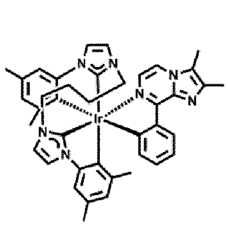

BD31

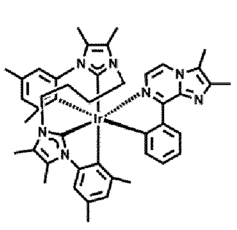

BD32

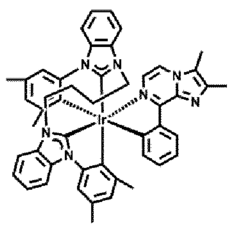

BD33

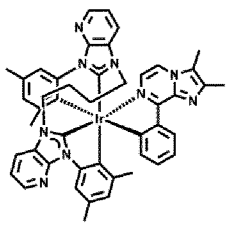

BD34

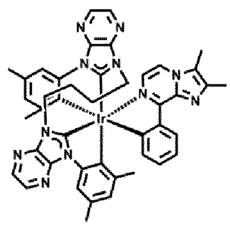

BD35

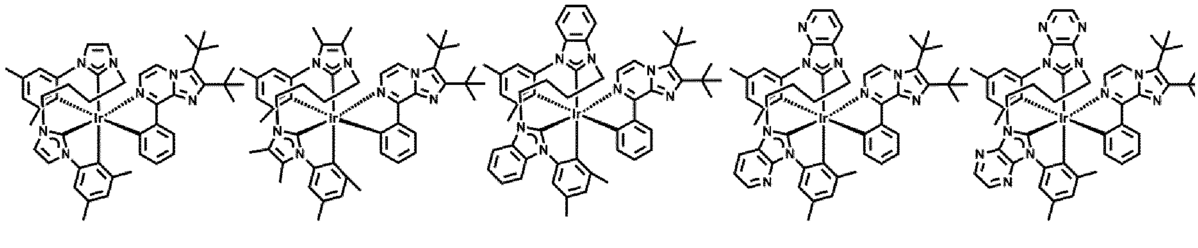

BD36 BD37 BD38 BD39 BD40

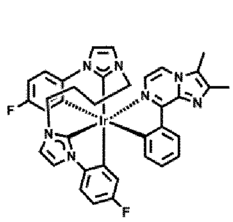

BD41

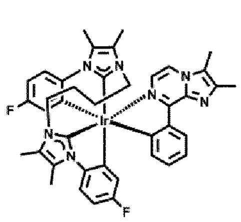

BD42

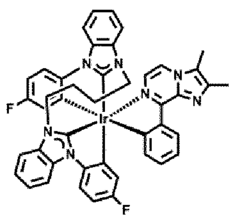

BD43

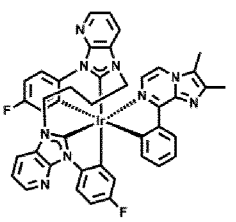

BD44

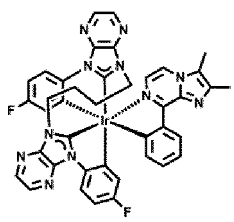

BD45

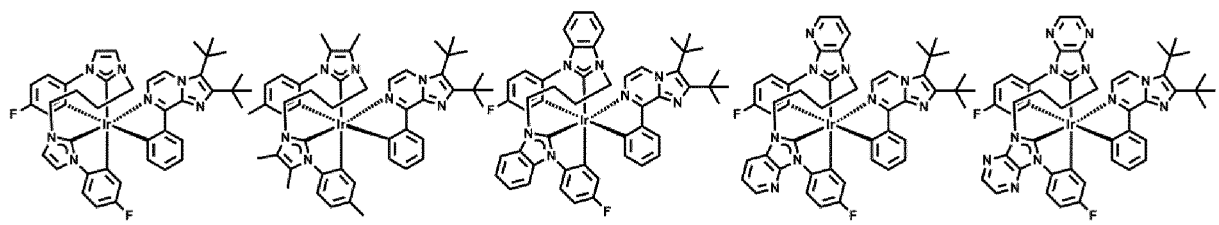

BD46 BD47 BD48 BD49 BD50

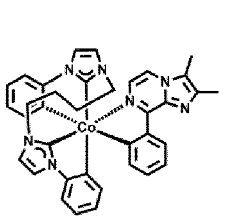

BD51

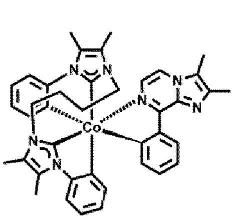

BD52

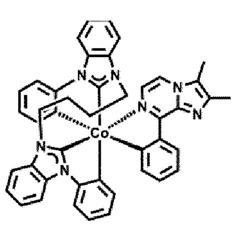

BD53

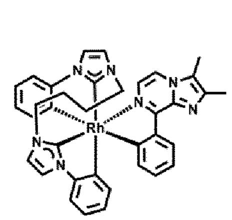

BD54

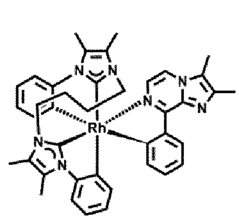

BD55

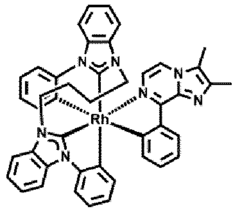 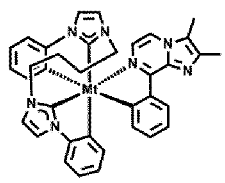 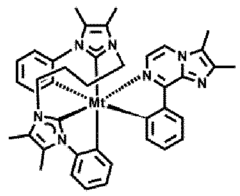 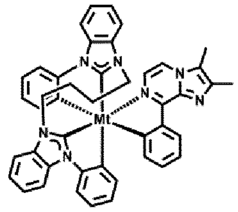

BD56 BD57 BD58 BD59

Since the organometallic compound represented by Formula 1 includes an imidazopyrazine-based ligand represented by Formula 2-1, electron donating may be improved. In this manner, bond dissociation energy (BDE) of the compound may be improved to stabilize a bond between a metal and a ligand. Therefore, the lifespan of an electronic device (for example, an organic light-emitting device) including the organometallic compound may be improved.

In addition, since the organometallic compound represented by Formula 1 may include an imidazole-based tetradentate ligand represented by Formula 2-2 or 2-3, electron donating may be improved. In this manner, BDE of the compound may be improved to stabilize a bond between a metal and a ligand. Therefore, the lifespan of an electronic device (for example, an organic light-emitting device) including the organometallic compound may be improved.

The organometallic compound may emit blue light. For example, the organometallic compound may emit blue light having a wavelength of maximum emission of about 440 nm or more and about 490 nm or less (bottom emission $CIE_{x,y}$ color coordinates 0.05, 0.3 - 0.18, 0.08), but embodiments of the present disclosure are not limited thereto. Therefore, the organometallic compound represented by Formula 1 may be suitably used to manufacture an organic light-emitting device that emits blue light.

A synthesis method for the organometallic compound represented by Formula 1 would be apparent to those of ordinary skill in the art by referring to the following examples.

At least one of the organometallic compound represented by Formula 1 may be used between a pair of electrodes of an organic light-emitting device. For example, the organometallic compound may be included in an emission layer. The organometallic compound included in the emission layer may serve as a dopant. In one embodiment, the organometallic compound represented by Formula 1 may be used as a material for a capping layer located outside a pair of electrodes of an organic light-emitting device.

Accordingly, another aspect of the present disclosure provides an organic light-emitting device including: a first electrode; a second electrode facing the first electrode; an organic layer disposed between the first electrode and the second electrode and including an emission layer; and at least one organometallic compound represented by Formula 1.

In one or more embodiments, the organic layer may include the at least one organometallic compound represented by Formula 1. The expression "(an organic layer) includes at least one organometallic compound represented by Formula 1" as used herein may include a case in which "(an organic layer) includes identical organometallic compounds represented by Formula 1" and a case in which (an organic layer) includes two or more different organometallic compounds represented by Formula 1".

For example, the organic layer may include, as the organometallic compound, only Compound BD1. In this regard, Compound BD1 may exist only in the emission layer of the organic light-emitting device. In one or more embodiments, the organic layer may include, as the organometallic compound, Compound BD1 and Compound BD2. In this regard, Compound BD1 and Compound BD2 may exist in an identical layer (for example, Compound BD1 and Compound BD2 may all exist in an emission layer), or different layers (for example, Compound BD1 may exist in an emission layer and Compound BD2 may exist in an electron transport region).

In one embodiment, the first electrode may be an anode,

the second electrode may be a cathode,
the organic layer may further include a hole transport region between the first electrode and the emission layer and an electron transport region between the emission layer and the second electrode,
the hole transport region may include a hole injection layer, a hole transport layer, an emission auxiliary layer, an electron blocking layer, or any combination thereof, and
the electron transport region may include a buffer layer, a hole blocking layer, an electron control layer, an electron transport layer, an electron injection layer, or any combination thereof.

The term "organic layer" as used herein refers to a single layer and/or a plurality of layers disposed between the first electrode and the second electrode of the organic light-emitting device. A material included in the "organic layer" is not limited to an organic compound.

In one embodiment, the emission layer may include the organometallic compound.

In one embodiment, the emission layer may include at least one selected from a second compound and a third compound,

the organometallic compound, the second compound, and the third compound may be different from each other,
when the emission layer includes the second compound and the third compound, the second compound and the third compound may form an exciplex, and
the organometallic compound and the second compound and/or the third compound may not form an exciplex.

For example, the emission layer may include both the second compound and the third compound. For example, the emission layer may include the second compound and may not include the third compound, or may include third compound and may not include the second compound.

In one embodiment, the second compound may be represented by Formula 3, and
the third compound may be represented by Formula 4: [00153] [00154]

<Formula 3>

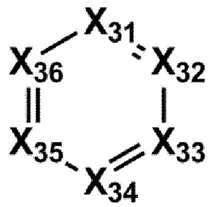

<Formula 4>

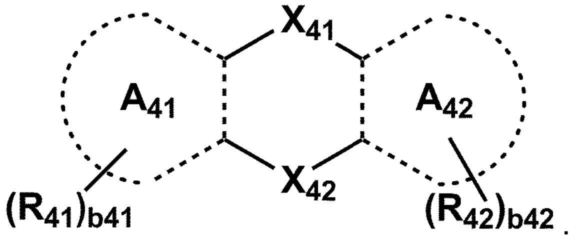

In Formulae 3 and 4,

$X_{31}$ is selected from $C(R_{31})$ and N, $X_{32}$ is selected from $C(R_{32})$ and N, $X_{33}$ is selected from $C(R_{33})$ and N, $X_{34}$ is selected from $C(R_{34})$ and N, $X_{35}$ is selected from $C(R_{35})$ and N, and $X_{36}$ is selected from $C(R_{36})$ and N, wherein at least one selected from $X_{31}$ to $X_{36}$ is N,
$R_{31}$ to $R_{36}$ are each independently selected from a group represented by $*-(L_{31})_{a31}-(R_{37})_{b37}$, hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ (*e.g.* $C_1$-$C_{20}$) alkyl group, a substituted or unsubstituted $C_2$-$C_{60}$ (*e.g.* $C_2$-$C_{20}$) alkenyl group, a substituted or unsubstituted $C_2$-$C_{60}$ (*e.g.* $C_2$-$C_{20}$) alkynyl group, a substituted or unsubstituted $C_1$-$C_{60}$ (*e.g.* $C_1$-$C_{20}$) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* C6-C30) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted $C_1$-$C_{60}$ (*e.g.* $C_1$-$C_{20}$) heteroaryloxy group, a substituted or unsubstituted $C_1$-$C_{60}$ (*e.g.* $C_1$-$C_{20}$) heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-B(Q_1)(Q_2)$, - $N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, and - $P(=S)(Q_1)(Q_2)$, wherein at least one selected from $R_{31}$ to $R_{36}$ is a group represented by $*-(L_{31})_{a31}-(R_{37})_{b37}$,
$L_{31}$ is selected from a substituted or unsubstituted $C_5$-$C_{60}$ (e.g. $C_5$-$C_{30}$) carbocyclic group and a substituted or unsubstituted $C_1$-$C_{60}$ (e.g. $C_1$-$C_{20}$) heterocyclic group,
a31 is an integer from 0 to 6,
$R_{37}$ is selected from a substituted or unsubstituted $C_1$-$C_{60}$ (*e.g.* $C_1$-$C_{20}$) alkyl group, a substituted or unsubstituted

$C_2$-$C_{60}$ (*e.g.* $C_2$-$C_{20}$) alkenyl group, a substituted or unsubstituted $C_2$-$C_{60}$ (*e.g.* $C_2$-$C_{20}$) alkynyl group, a substituted or unsubstituted $C_1$-$C_{60}$ (*e.g.* $C_1$-$C_{20}$) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* $C_6$-$C_{30}$) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted $C_1$-$C_{60}$ (*e.g.* $C_1$-$C_{20}$) heteroaryloxy group, a substituted or unsubstituted $C_1$-$C_{60}$ *(e.g.* $C_1$-$C_{20}$) heteroarylthio group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -B($Q_1$)($Q_2$), -N($Q_1$)($Q_2$), -P($Q_1$)($Q_2$), -C(=O)($Q_1$), -S(=O)($Q_1$), -S(=O)$_2$($Q_1$), -P(=O)($Q_1$)($Q_2$), and -P(=S)($Q_1$)($Q_2$),

b37 is an integer from 1 to 10,

$A_{41}$ and $A_{42}$ are each independently selected from a $C_5$-$C_{60}$ (e.g. $C_5$-$C_{30}$) carbocyclic group and a $C_1$-$C_{60}$ (e.g. $C_1$-$C_{20}$) heterocyclic group,

$X_{41}$ is selected from a single bond, O, S, B(R43), N(R43), C(R43)(R44), and Si(R43)(R44), and $X_{42}$ is selected from a single bond, O, S, B($R_{45}$), N($R_{45}$), C($R_{45}$)($R_{46}$), and Si(R45)(R46), wherein $X_{41}$ and $X_{42}$ are not a single bond at the same time,

$R_{41}$ to $R_{46}$ are each independently selected from a group represented by *-($L_{41}$)$_{a41}$-($R_{47}$)$_{b47}$, hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ (e.g. $C_1$-$C_{20}$) alkyl group, a substituted or unsubstituted $C_2$-$C_{60}$ *(e.g.* $C_2$-$C_{20}$) alkenyl group, a substituted or unsubstituted $C_2$-$C_{60}$ *(e.g.* $C_2$-$C_{20}$) alkynyl group, a substituted or unsubstituted $C_1$-$C_{60}$ (e.g. $C_1$-$C_{20}$) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* C6-C30) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted $C_1$-$C_{60}$ (*e.g.* $C_1$-$C_{20}$) heteroaryloxy group, a substituted or unsubstituted $C_1$-$C_{60}$ (*e.g.* $C_1$-$C_{20}$) heteroarylthio group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -B($Q_1$)($Q_2$), - N($Q_1$)($Q_2$), -P($Q_1$)($Q_2$), -C(=O)($Q_1$), -S(=O)($Q_1$), -S(=O)$_2$($Q_1$), -P(=O)($Q_1$)($Q_2$), and - P(=S)($Q_1$)($Q_2$), wherein at least one selected from $R_{41}$ to $R_{46}$ is a group represented by *-($L_{41}$)$_{a41}$-($R_{47}$)$_{b47}$,

$L_{41}$ is selected from a substituted or unsubstituted $C_5$-$C_{60}$ (*e.g.* $C_5$-$C_{30}$) carbocyclic group and a substituted or unsubstituted $C_1$-$C_{60}$ (*e.g.* $C_1$-$C_{20}$) heterocyclic group,

a41 is an integer from 0 to 6,

$R_{47}$ is selected from a substituted or unsubstituted $C_1$-$C_{60}$ (*e.g.* $C_1$-$C_{20}$) alkyl group, a substituted or unsubstituted $C_2$-$C_{60}$ (*e.g.* $C_2$-$C_{20}$) alkenyl group, a substituted or unsubstituted $C_2$-$C_{60}$ (*e.g.* $C_2$-$C_{20}$) alkynyl group, a substituted or unsubstituted $C_1$-$C_{60}$ (*e.g.* $C_1$-$C_{20}$) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* $C_6$-$C_{30}$) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted $C_1$-$C_{60}$ (*e.g.* $C_1$-$C_{20}$) heteroaryloxy group, a substituted or unsubstituted $C_1$-$C_{60}$ (*e.g.* $C_1$-$C_{20}$) heteroarylthio group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -B($Q_1$)($Q_2$), -N($Q_1$)($Q_2$), -P($Q_1$)($Q_2$), -C(=O)($Q_1$), -S(=O)($Q_1$), -S(=O)$_2$($Q_1$), -P(=O)($Q_1$)($Q_2$), and -P(=S)($Q_1$)($Q_2$);

b47 is an integer from 1 to 10,

$Q_1$ to $Q_3$ are each independently selected from hydrogen, deuterium, -F, -Cl, - Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-C30) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic condensed polycyclic group, a monovalent non-aromatic condensed heteropolycyclic group, a biphenyl group, and a terphenyl group, and

* indicates a binding site to a neighboring atom.

For example, $X_{31}$ may be C($R_{31}$), $X_{33}$ may be C($R_{33}$), and $X_{35}$ may be C(R35); or $X_{32}$ may be C($R_{32}$), $X_{34}$ may be C($R_{34}$), and $X_{36}$ may be C($R_{36}$).

For example, a41 may be 1 or more.

For example, the second compound may be selected from Compounds ETH1 to ETH80, and the third compound may be selected from Compounds HTH1 to HTH28:

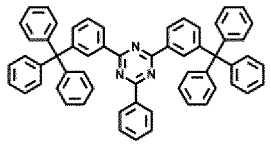
ETH1

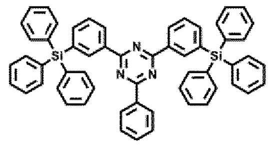
ETH2

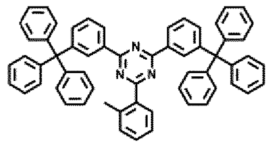
ETH3

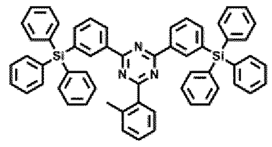
ETH4

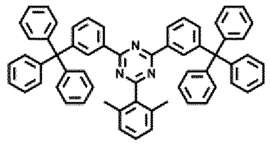
ETH5

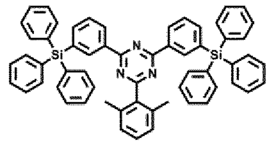
ETH6

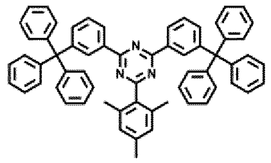
ETH7

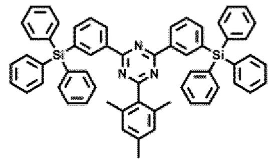
ETH8

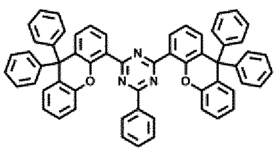
ETH9

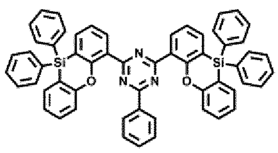
ETH10

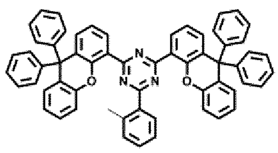
ETH11

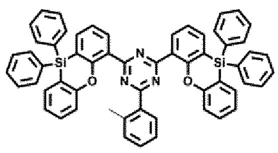
ETH12

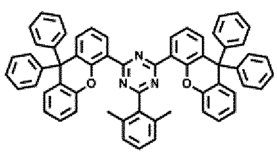
ETH13

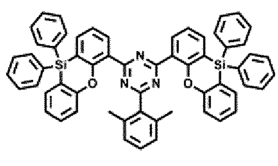
ETH14

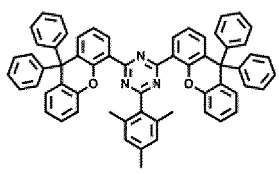
ETH15

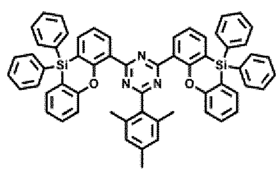
ETH16

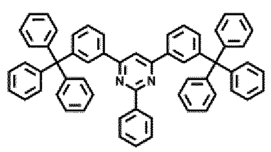
ETH17

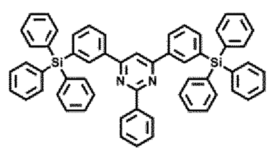
ETH18

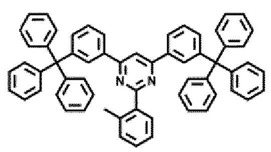
ETH19

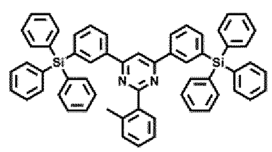
ETH20

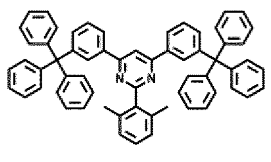
ETH21

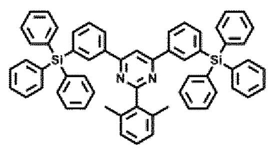
ETH22

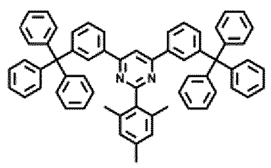
ETH23

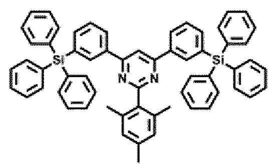
ETH24

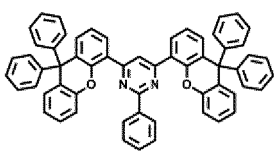
ETH25

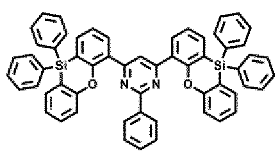
ETH26

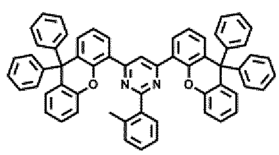
ETH27

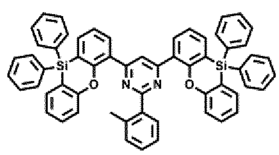
ETH28

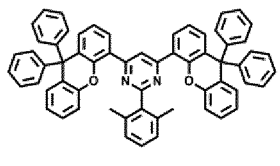
ETH29

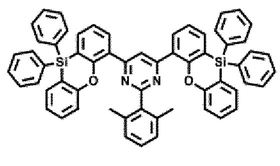
ETH30

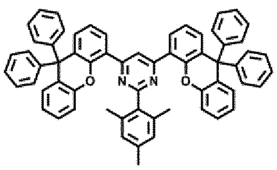
ETH31

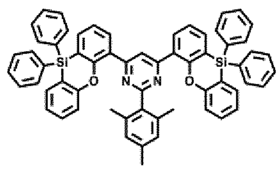
ETH32

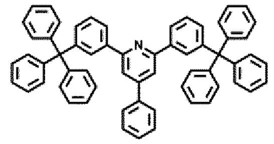
ETH33

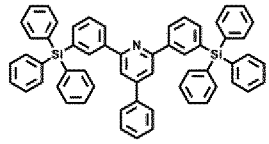
ETH34

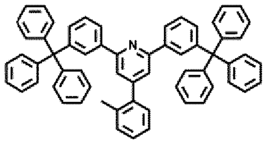
ETH35

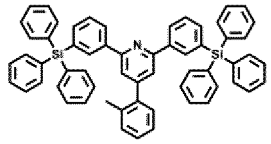
ETH36

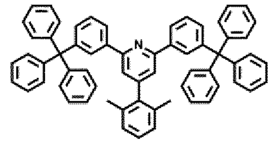
ETH37

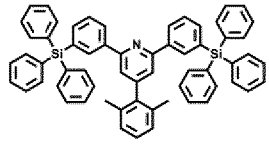
ETH38

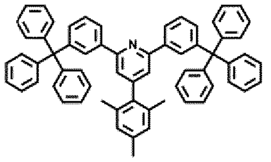
ETH39

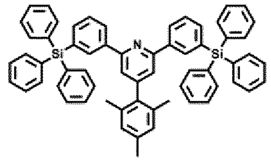
ETH40

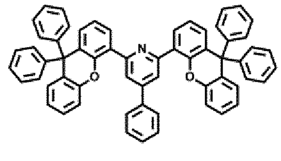
ETH41

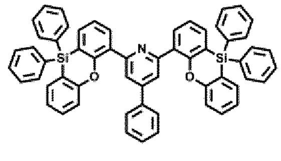
ETH42

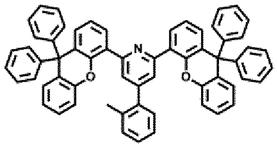
ETH43

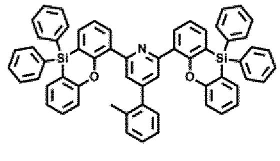
ETH44

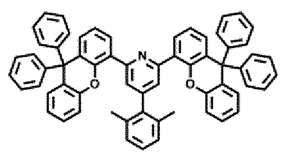
ETH45

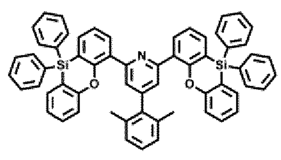
ETH46

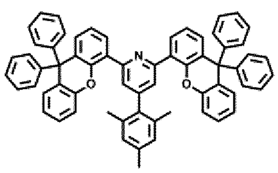
ETH47

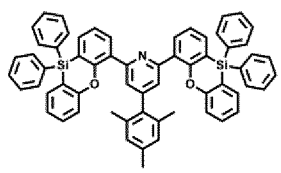
ETH48

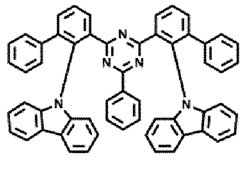
ETH49

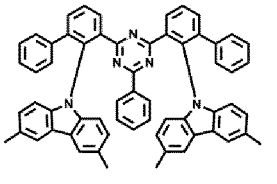
ETH50

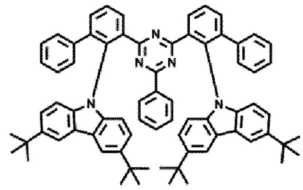
ETH51

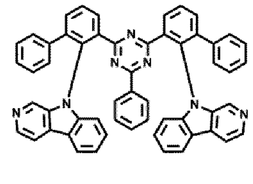
ETH52

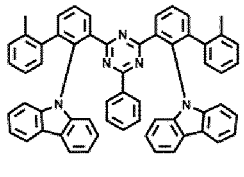
ETH53

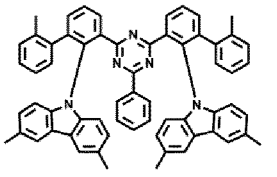
ETH54

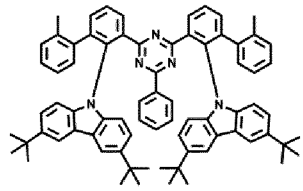
ETH55

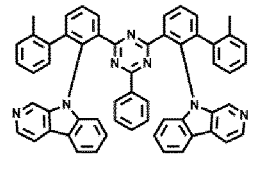
ETH56

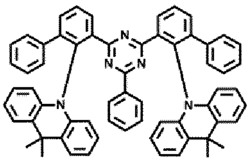
ETH57

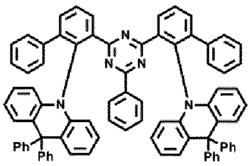
ETH58

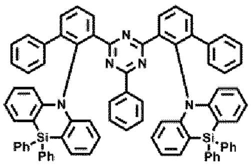
ETH59

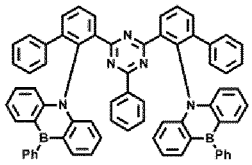
ETH60

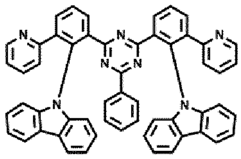
ETH61

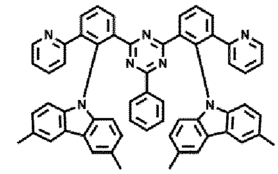
ETH62

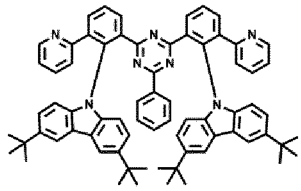
ETH63

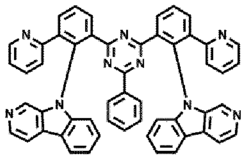
ETH64

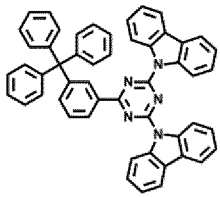
ETH65

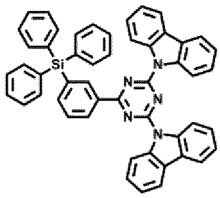
ETH66

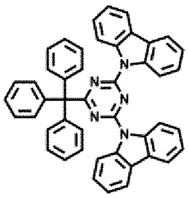
ETH67

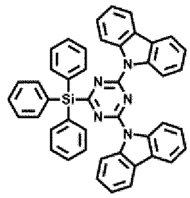
ETH68

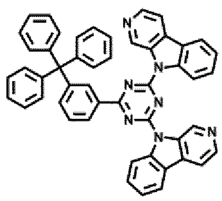
ETH69

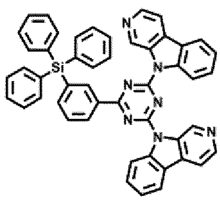
ETH70

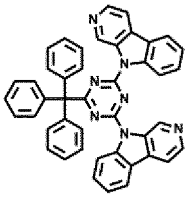
ETH71

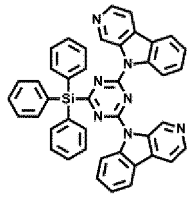
ETH72

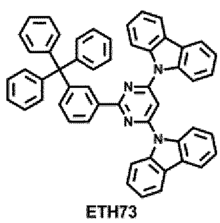
ETH73

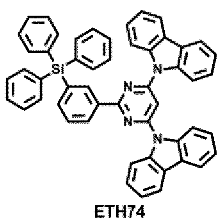
ETH74

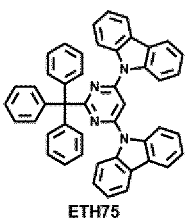
ETH75

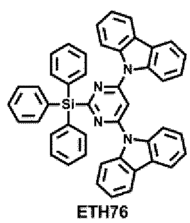
ETH76

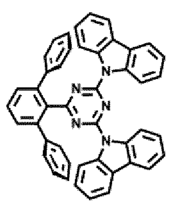
ETH77

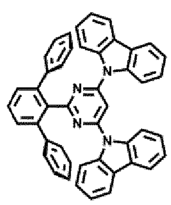
ETH78

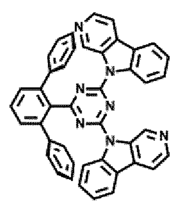
ETH79

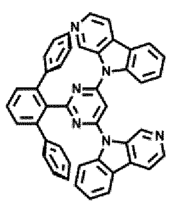
ETH80

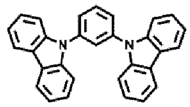
HTH1

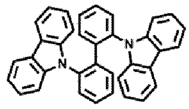
HTH2

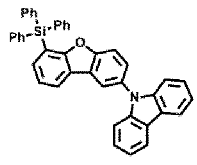
HTH3

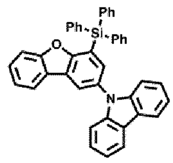
HTH4

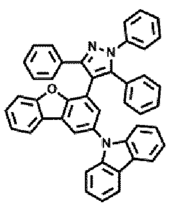
HTH5

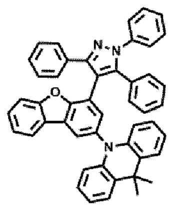
HTH6

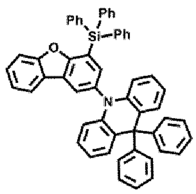
HTH7

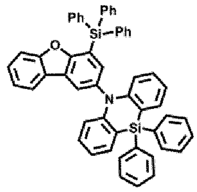
HTH8

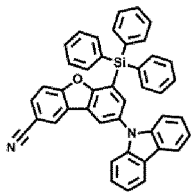
HTH9

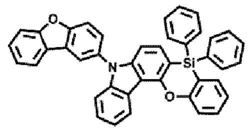
HTH10

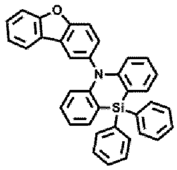
HTH11

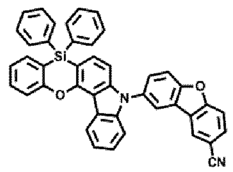
HTH12

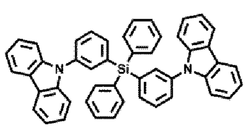
HTH13

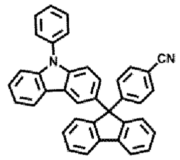
HTH14

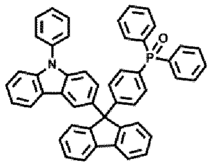
HTH15

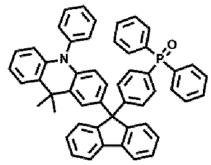
HTH16

[00181]

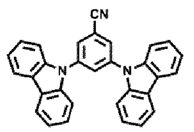
HTH17

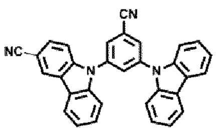
HTH18

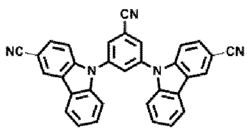
HTH19

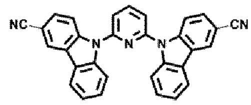
HTH20

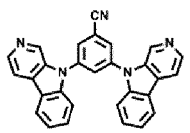
HTH21

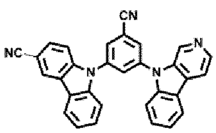
HTH22

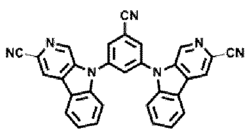
HTH23

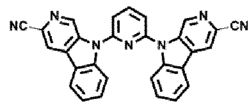
HTH24

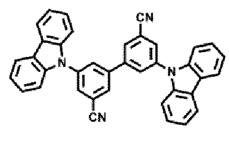
HTH25

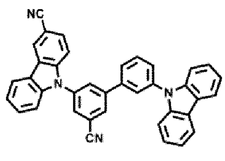
HTH26

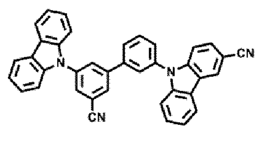
HTH27

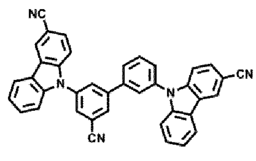
HTH28

[00182]

In one embodiment, a decay time of delayed fluorescence in a time-resolved electroluminescence (TREL) spectrum of the organic light-emitting device may be about 50 ns or more.

As described above, the second compound and the third compound may form an exciplex, and a wavelength ($\lambda_{max}$) of maximum emission in a photoluminescence (PL) spectrum of the exciplex may be about 390 nm or more and about 500 nm or less.

In addition, the wavelength of maximum emission in the PL spectrum of the exciplex may suppress the wavelength of maximum emission of the organometallic compound in a range of about 5 nm to about 10 nm.

Furthermore, a difference in absolute value between a lowest unoccupied molecular orbital (LUMO) energy level of the organometallic compound and a LUMO energy level of the second compound or the third compound may be in a range of about 0.1 eV to about 10 eV.

Furthermore, a difference in absolute value between a highest occupied molecular orbital (HOMO) energy level of the organometallic compound and a HOMO energy level of the second compound or the third compound may be about 1.25 eV or less.

Another aspect of the present disclosure provides a flat display apparatus including the organic light-emitting device and a thin-film transistor.

In one embodiment, the thin-film transistor may include a source electrode and a drain electrode, and the first electrode of the organic light-emitting device may be electrically connected to the source electrode or the drain electrode.

[Description of FIG. 1]

FIG. 1 is a schematic cross-sectional view of an organic light-emitting device 10 according to an embodiment. The organic light-emitting device 10 includes a first electrode 110, an organic layer 150, and a second electrode 190.

Hereinafter, the structure of the organic light-emitting device 10 according to an embodiment and a method of manufacturing the organic light-emitting device 10 will be described in connection with FIG. 1.

[First electrode 110]

In FIG. 1, a substrate may be additionally disposed under the first electrode 110 or above the second electrode 190. The substrate may be a glass substrate or a plastic substrate, each having excellent mechanical strength, thermal stability, transparency, surface smoothness, ease of handling, and water resistance.

The first electrode 110 may be formed by depositing or sputtering a material for forming the first electrode 110 on the substrate. When the first electrode 110 is an anode, the material for forming the first electrode 110 may be selected from materials with a high work function to facilitate hole injection.

The first electrode 110 may be a reflective electrode, a semi-transmissive electrode, or a transmissive electrode. When the first electrode 110 is a transmissive electrode, a material for forming the first electrode 110 may be selected from indium tin oxide (ITO), indium zinc oxide (IZO), tin oxide ($SnO_2$), zinc oxide (ZnO), and any combinations thereof, but embodiments of the present disclosure are not limited thereto. In one or more embodiments, when the first electrode 110 is a semi-transmissive electrode or a reflective electrode, a material for forming the first electrode 110 may be selected from magnesium (Mg), silver (Ag), aluminium (Al), aluminium-lithium (Al-Li), calcium (Ca), magnesium-indium (Mg-In), magnesium-silver (Mg-Ag), and any combinations thereof, but embodiments of the present disclosure are not limited thereto.

The first electrode 110 may have a single-layered structure, or a multi-layered structure including two or more layers. For example, the first electrode 110 may have a three-layered structure of ITO/Ag/ITO, but the structure of the first electrode 110 is not limited thereto.

[Organic layer 150]

The organic layer 150 may be disposed on the first electrode 110. The organic layer 150 may include an emission layer.

The organic layer 150 may further include a hole transport region between the first electrode 110 and the emission layer and an electron transport region between the emission layer and the second electrode 190.

[Hole transport region in organic layer 150]

The hole transport region may have i) a single-layered structure including a single layer including a single material, ii) a single-layered structure including a single layer including a plurality of different materials, or iii) a multi-layered structure having a plurality of layers including a plurality of different materials.

The hole transport region may include at least one layer selected from a hole injection layer, a hole transport layer, an emission auxiliary layer, and an electron blocking layer.

For example, the hole transport region may have a single-layered structure including a single layer including

a plurality of different materials, or a multi-layered structure having a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein for each structure, constituting layers are sequentially stacked from the first electrode 110 in this stated order, but the structure of the hole transport region is not limited thereto.

The hole transport region may include at least one selected from m-MTDATA, TDATA, 2-TNATA, NPB (NPD), β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, and a compound represented by Formula 202:

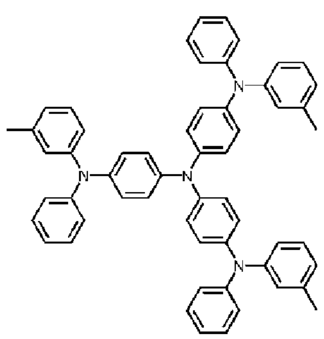

m-MTDATA

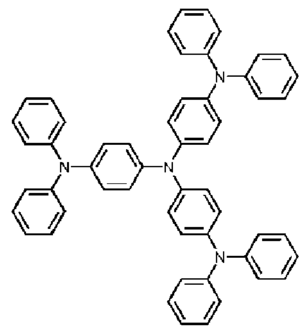

TDATA

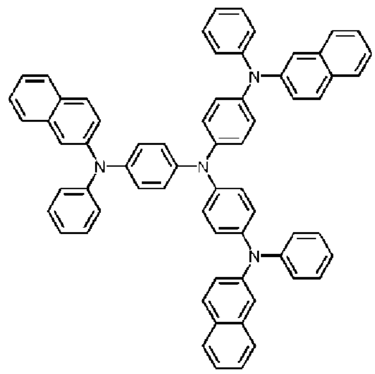

2-TNATA

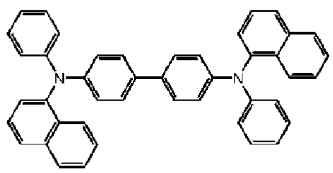

NPB

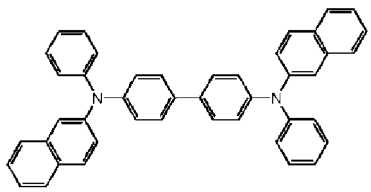

β-NPB

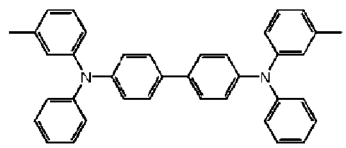

TPD

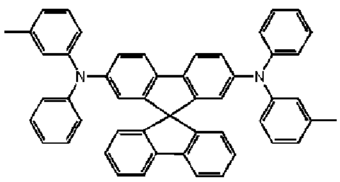

Spiro-TPD

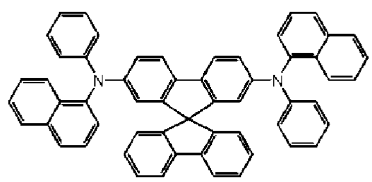

Spiro-NPB

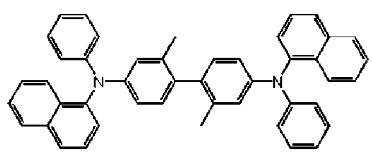

methylated NPB

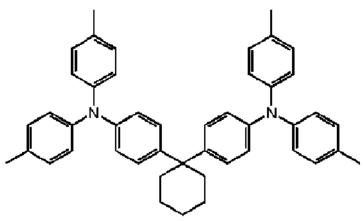

TAPC

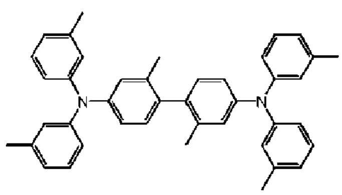

HMTPD

<Formula 201>

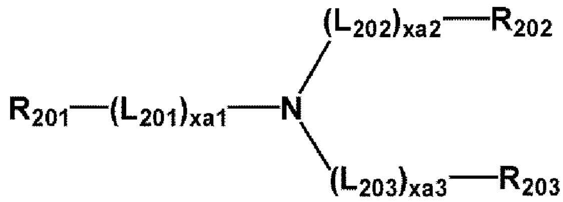

<Formula 202>

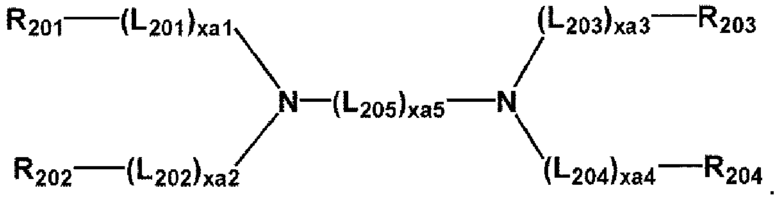

In Formulae 201 and 202,

$L_{201}$ to $L_{204}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ (*e.g.* $C_6$-$C_{32}$) arylene group, a substituted or unsubstituted $C_1$-$C_{60}$ (*e.g.* $C_1$-$C_{20}$) heteroarylene group, a substituted or unsubstituted divalent non-aromatic condensed polycyclic group, and a substituted or unsubstituted divalent non-aromatic condensed heteropolycyclic group,

$L_{205}$ may be selected from *-O-*', *-S-*', *-N($Q_{201}$)-*', a substituted or unsubstituted $C_1$-$C_{20}$ alkylene group, a substituted or unsubstituted $C_2$-$C_{20}$ alkenylene group, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ (e.g. $C_6$-$C_{32}$) arylene group, a substituted or unsubstituted $C_1$-$C_{60}$ (*e.g.* $C_1$-$C_{20}$) heteroarylene group, a substituted or unsubstituted divalent non-aromatic condensed polycyclic group, and a substituted or unsubstituted divalent non-aromatic condensed heteropolycyclic group,

xa1 to xa4 may each independently be an integer from 0 to 3,

xa5 may be an integer from 1 to 10, and

$R_{201}$ to $R_{204}$ and $Q_{201}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{32}$) aryl group, a substituted or unsubstituted C6-C60 (*e.g.* $C_6$-$C_{32}$) aryloxy group, a substituted or unsubstituted $C_6$-$C_{60}$ (*e.g.* $C_6$-$C_{32}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group, and a substituted or unsubstituted monovalent non-aromatic condensed heteropolycyclic group.

For example, in Formula 202, $R_{201}$ and $R_{202}$ may optionally be linked via a single bond, a dimethyl-methylene group, or a diphenyl-methylene group, and $R_{203}$ and $R_{204}$ may optionally be linked via a single bond, a dimethyl-methylene group, or a diphenyl-methylene group.

In one embodiment, in Formulae 201 and 202,

$L_{201}$ to $L_{205}$ may each independently be selected from:

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a

benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, $-Si(Q_{31})(Q_{32})(Q_{33})$, and $-N(Q_{31})(Q_{32})$, and

$Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, $R_{201}$ to $R_{204}$ and $Q_{201}$ may each independently be selected from:

a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and

a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a

dibenzosilolyl group, a pyridinyl group, $-Si(Q_{31})(Q_{32})(Q_{33})$, and $-N(Q_{31})(Q_{32})$, and
$Q_{31}$ to $Q_{33}$ are the same as described above.

In one or more embodiments, at least one selected from $R_{201}$ to $R_{203}$ in Formula 201 may each independently be selected from:

a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one or more embodiments, in Formula 202, i) $R_{201}$ and $R_{202}$ may be linked via a single bond, and/or ii) $R_{203}$ and $R_{204}$ may be linked via a single bond.
In one or more embodiments, at least one selected from $R_{201}$ to $R_{204}$ in Formula 202 may be selected from:

a carbazolyl group; and
a carbazolyl group substituted with at least one selected from deuterium, -F, - Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

The compound represented by Formula 201 may be represented by Formula 201A:

<Formula 201A>

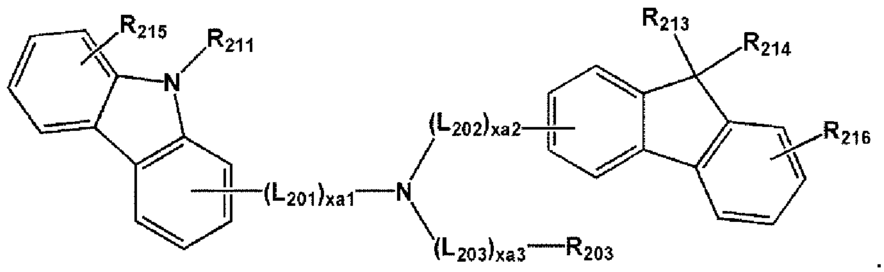

For example, the compound represented by Formula 201 may be represented by Formula 201A(1), but embodiments of the present disclosure are not limited thereto:

<Formula 201A(1)>

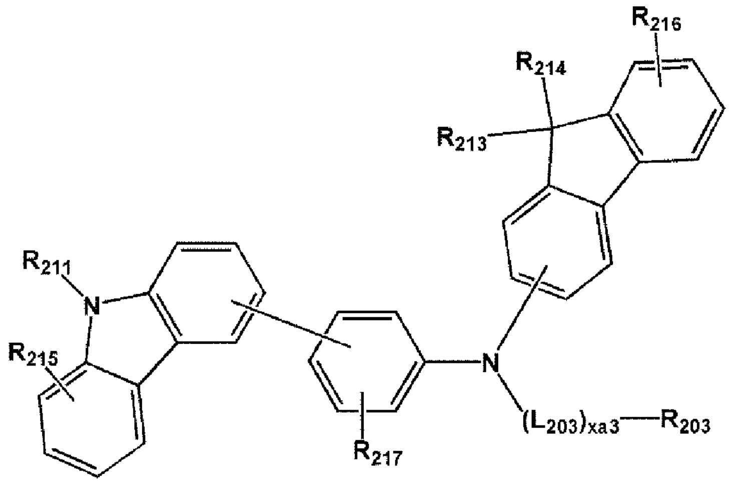

In one embodiment, the compound represented by Formula 201 may be represented by Formula 201A-1, but embodiments of the present disclosure are not limited thereto:

<Formula 201A-1>

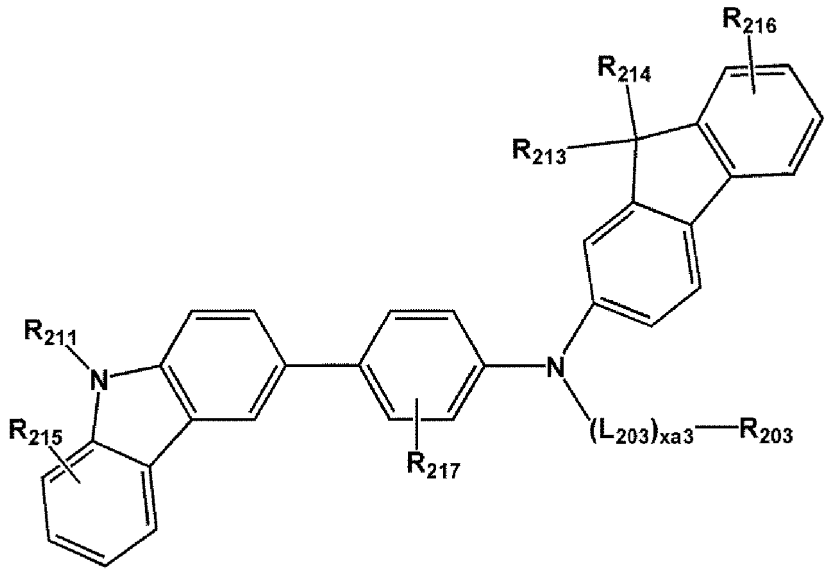

.

In one embodiment, the compound represented by Formula 202 may be represented by Formula 202A:

<Formula 202A>

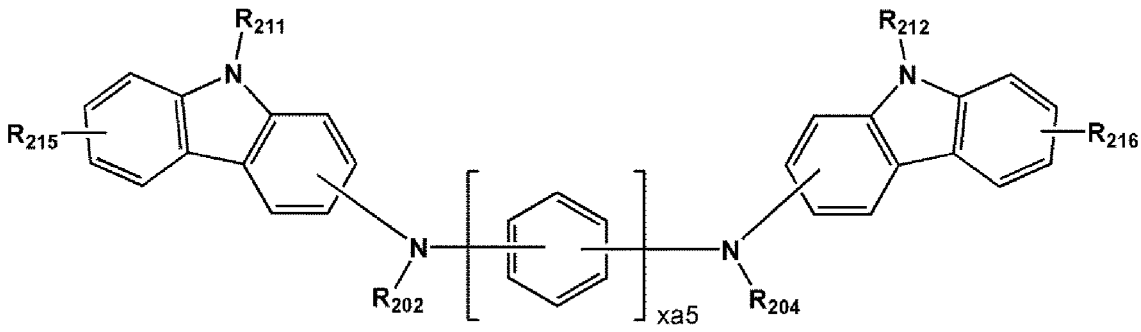

In one or more embodiments, the compound represented by Formula 202 may be represented by Formula 202A-1:

<Formula 202A-1>

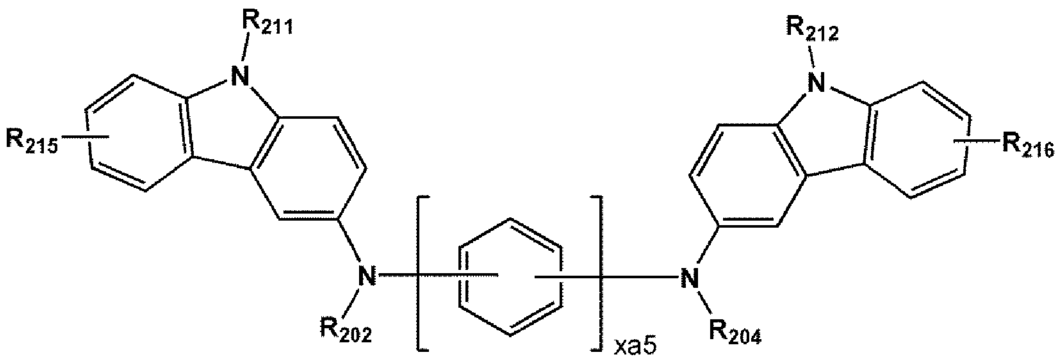

In Formulae 201A, 201A(1), 201A-1, 202A, and 202A-1,

$L_{201}$ to $L_{203}$, xa1 to xa3, xa5, and $R_{202}$ to $R_{204}$ are the same as described above,
$R_{211}$ and $R_{212}$ may each independently be the same as defined in connection with $R_{203}$, and
$R_{213}$ to $R_{217}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39, but embodiments of the present disclosure are not limited thereto:

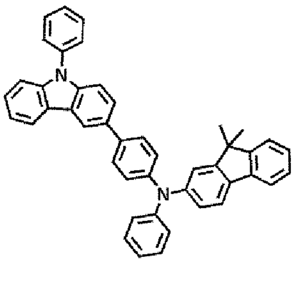

**HT1**

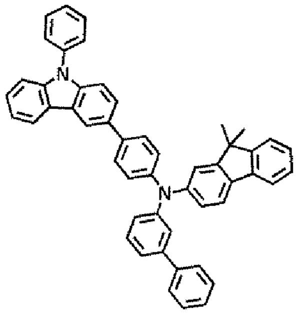

**HT2**

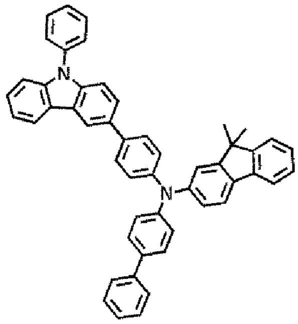

**HT3**

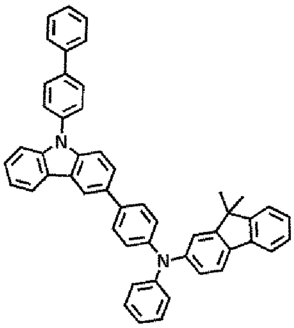

**HT4**

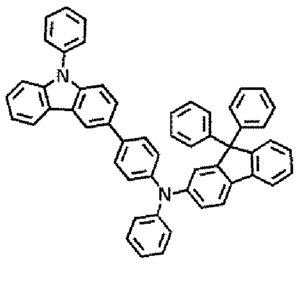

**HT5**

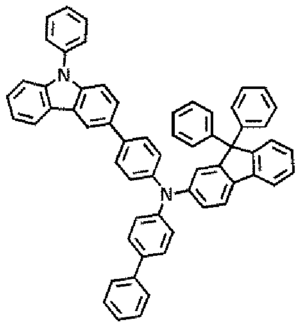

**HT6**

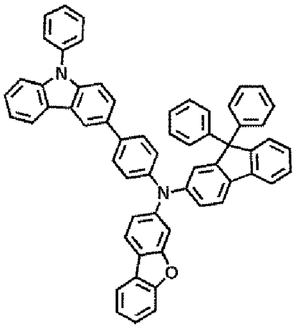

**HT7**

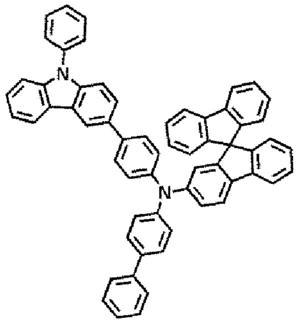

**HT8**

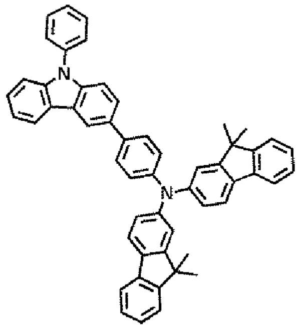

**HT9**

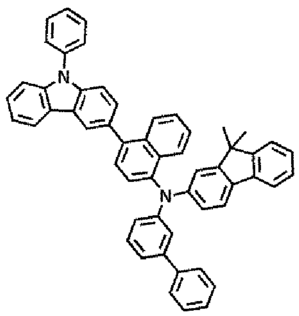

**HT10**

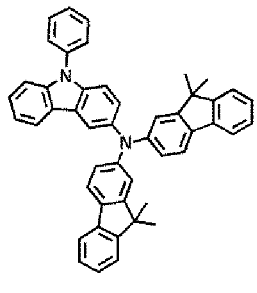

**HT11**

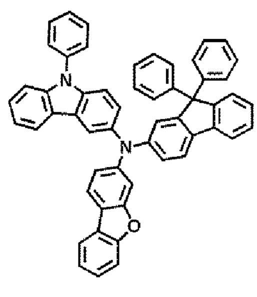

**HT12**

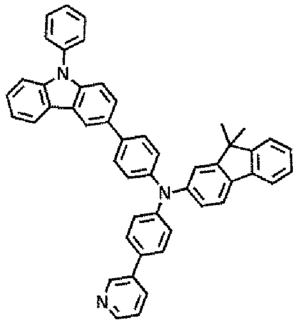
HT13

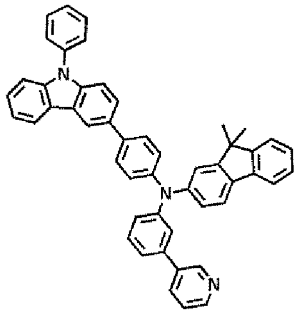
HT14

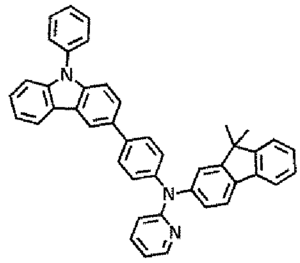
HT15

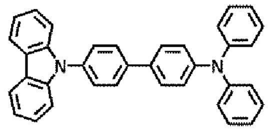
HT16

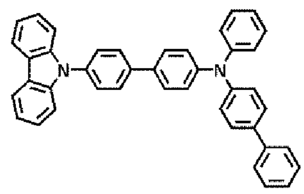
HT17

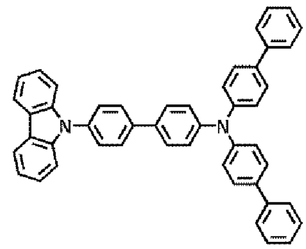
HT18

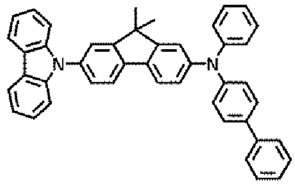
HT19

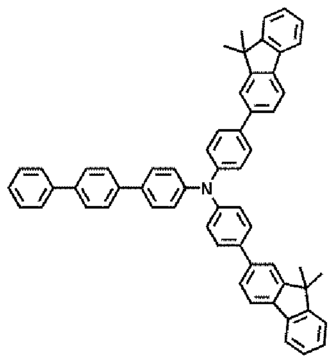
HT20

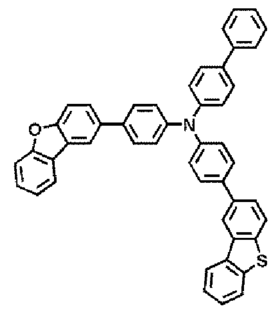
HT21

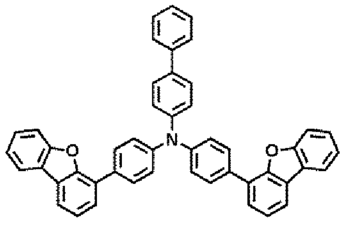
HT22

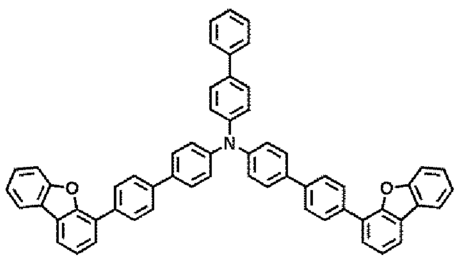
HT23

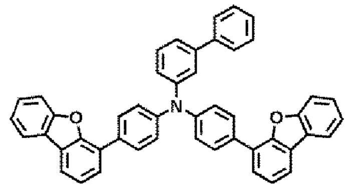
HT24

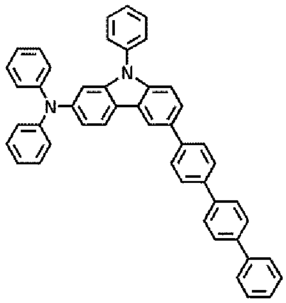

HT25

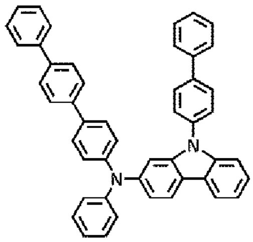

HT26

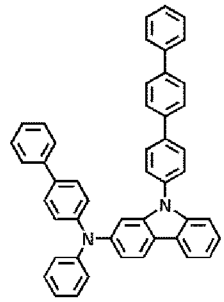

HT27

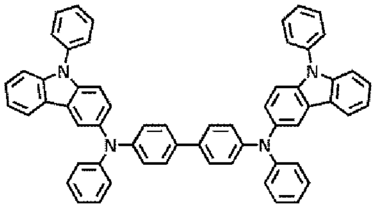

HT28

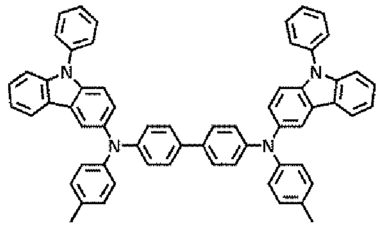

HT29

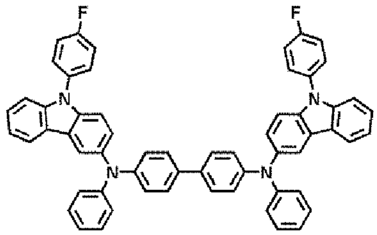

HT30

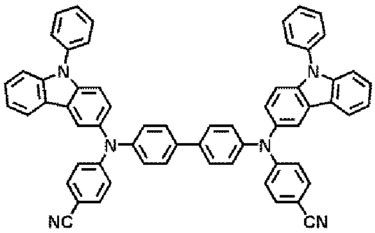

HT31

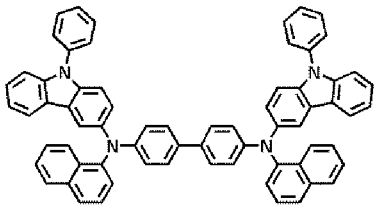

HT32

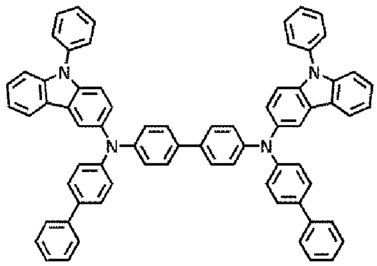

HT33

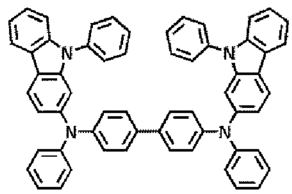

HT34

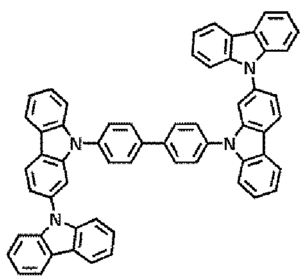

HT35

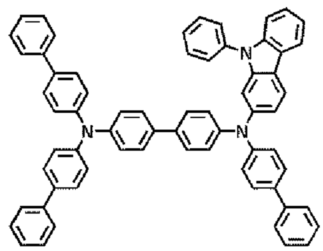

HT36

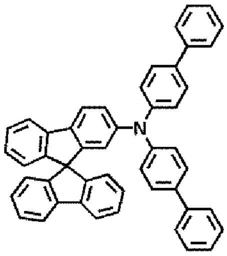

HT37

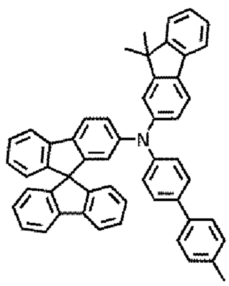

HT38

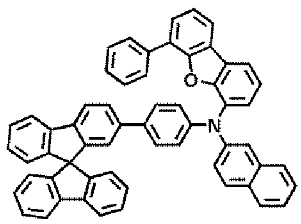

HT39

A thickness of the hole transport region may be from about 100 Å to about 10,000 Å, for example, about 100 Å to about 7,000 Å, about 100 Å to about 5,000 Å, about 100 Å to about 3,000 Å, or about 100 Å to about 1,000 Å. When the hole transport region includes at least one selected from a hole injection layer and a hole transport layer, a thickness of the hole injection layer may be from about 100 Å to about 9,000 Å, for example, about 100 Å to about 7,000 Å, about 100 Å to about 5,000 Å, about 100 Å to about 3,000 Å, about 100 Å to about 2,000 Å, about 100 Å to about 1,000 Å or about 500 Å to about 700 Å, and a thickness of the hole transport layer may be from about 50 Å to about 2,000 Å, for example about 100 Å to about 1,500 Å or about 200 Å to about 400 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block the flow of electrons from an electron transport region. The emission auxiliary layer and the electron blocking layer may include the materials as described above.

[p-dopant]

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant.

In one embodiment, the p-dopant may have a lowest unoccupied molecular orbital (LUMO) energy level of less than -3.5 eV.

The p-dopant may include at least one selected from a quinone derivative, a metal oxide, and a cyano group-containing compound, but embodiments of the present disclosure are not limited thereto.

In one embodiment, the p-dopant may include at least one selected from:

a quinone derivative, such as tetracyanoquinodimethane (TCNQ) and 2,3,5,6-tetrafluoro-7,7,8,8-tetracyanoquinodimethane (F4-TCNQ);
a metal oxide, such as tungsten oxide or molybdenum oxide;
1,4,5,8,9,11-hexaazatriphenylene-hexacarbonitrile (HAT-CN); and
a compound represented by Formula 221,
but embodiments of the present disclosure are not limited thereto:

<HAT-CN>

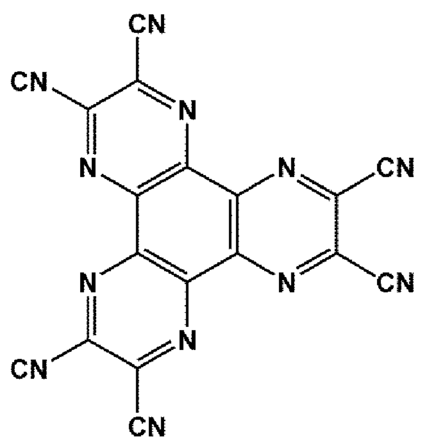

<F4-TCNQ>

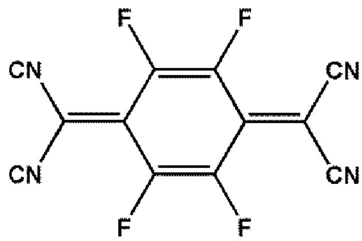

<Formula 221>

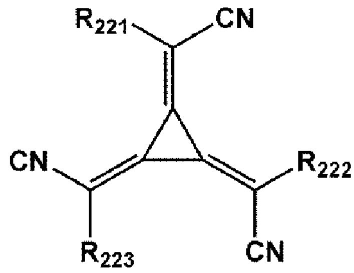

In Formula 221,

$R_{221}$ to $R_{223}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{32}$) aryl group, a substituted or unsubstituted $C_1$-$C_{60}$ (*e.g.* $C_1$-$C_{20}$) heteroaryl group, a substituted or unsubstituted monovalent non-aromatic condensed polycyclic group, and a substituted or unsubstituted monovalent non-aromatic condensed heteropolycyclic group, wherein at least one selected from $R_{221}$ to $R_{223}$ may have at least one substituent selected from a cyano group, -F, -Cl, -Br, -I, a $C_1$-$C_{20}$ alkyl group substituted with -F, a $C_1$-$C_{20}$ alkyl group substituted with -Cl, a $C_1$-$C_{20}$ alkyl group substituted with -Br, and a $C_1$-$C_{20}$ alkyl group substituted with -I.

[Emission layer in organic layer 150]

When the organic light-emitting device 10 is a full-color organic light-emitting device, the emission layer may be patterned into a red emission layer, a green emission layer, or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other. In one or more embodiments, the emission layer may include two or more materials selected from a red light-emitting material, a green light-emitting material, and a blue light-emitting material, in which the two or more materials are mixed with each other in a single layer to emit white light.

The emission layer may include a host and a dopant, and the dopant may include at least one selected from a phosphorescent dopant and a fluorescent dopant. In addition, the phosphorescent dopant may include the organometallic compound represented by Formula 1.

In the emission layer, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 100 Å to about 800 Å, about 150 Å to about 800 Å, about 150 Å to about 700 Å, about 150 Å to about 650 Å, about 200 Å to about 600 Å or about 200 Å to about 400 Å. When the thickness of the emission layer is within this range, excellent light-emission characteristics may be obtained without a substantial increase in driving voltage.

[Host in emission layer]

The host may include the second compound or the third compound.

In addition, the host may include a compound represented by Formula 301:

<Formula 301>

$$[Ar_{301}]_{xb11}-[(L_{301})_{xb1}-R_{301}]_{xb21}$$

In Formula 301,

$Ar_{301}$ may be a substituted or unsubstituted $C_5$-$C_{60}$ carbocyclic group or a substituted or unsubstituted $C_1$-$C_{60}$ heterocyclic group,

xb11 may be 1, 2, or 3,

$L_{301}$ may be selected from a substituted or unsubstituted $C_3$-$C_{10}$ cycloalkylene group, a substituted or unsubstituted

$C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group,

xb1 may be an integer from 0 to 5,

$R_{301}$ may be selected from deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, - $Si(Q_{301})(Q_{302})(Q_{303})$, -N(Q301)(Q302), $-B(Q_{301})(Q_{302})$, $-C(=O)(Q_{301})$, $-S(=O)_2(Q_{301})$, and - $P(=O)(Q_{301})(Q_{302})$,

xb21 may be an integer from 1 to 5, and

$Q_{301}$ to $Q_{303}$ may each independently be selected from a $C_1$-$C_{10}$ alkyl group, a $C_1$-$C_{10}$ alkoxy group, a phenyl group, a biphenyl group, a terphenyl group, and a naphthyl group, but embodiments of the present disclosure are not limited thereto.

For example, $Ar_{301}$ may be a substituted or unsubstituted $C_6$-$C_{32}$ carbocyclic group or a substituted or unsubstituted $C_1$-$C_{12}$ heterocyclic group, but embodiments are not limited thereto.

In one embodiment $Ar_{301}$ in Formula 301 may be selected from:

a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and

a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and $-P(=O)(Q_{31})(Q_{32})$, and

$Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group, but embodiments of the present disclosure are not limited thereto.

When xb11 in Formula 301 is 2 or more, two or more $Ar_{301}$ (s) may be linked via a single bond.

In one or more embodiments, the compound represented by Formula 301 may be represented by Formula 301-1 or 301-2:

<Formula 301-1>

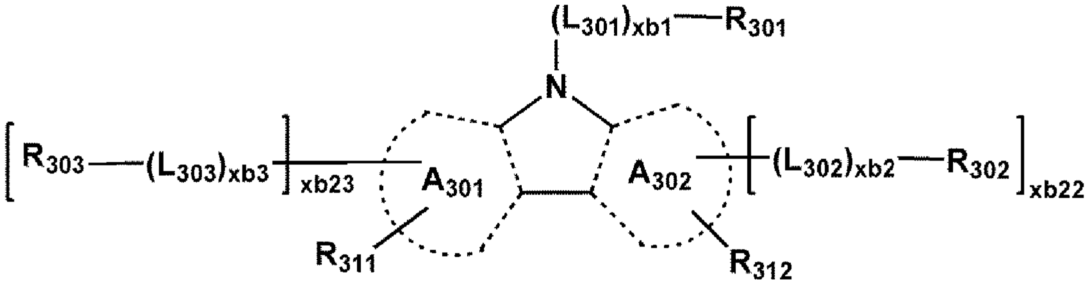

<Formula 301-2>

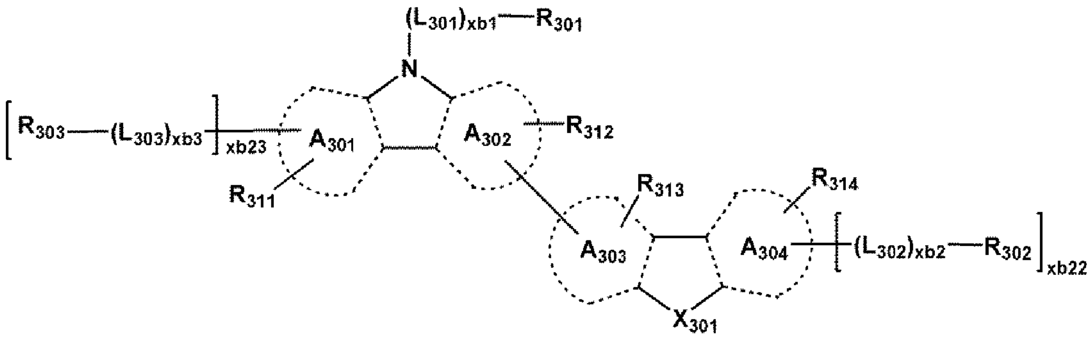

.

In Formulae 301-1 and 301-2,

ring A301 to ring A304 may each independently be selected from a benzene ring, a naphthalene ring, a phenanthrene ring, a fluoranthene ring, a triphenylene ring, a pyrene ring, a chrysene ring, a pyridine ring, a pyrimidine ring, an indene ring, a fluorene ring, a spiro-bifluorene ring, a benzofluorene ring, a dibenzofluorene ring, an indole ring, a carbazole ring, a benzocarbazole ring, a dibenzocarbazole ring, a furan ring, a benzofuran ring, a dibenzofuran ring, a naphthofuran ring, a benzonaphthofuran ring, a dinaphthofuran ring, a thiophene ring, a benzothiophene ring, a dibenzothiophene ring, a naphthothiophene ring, a benzonaphthothiophene ring, and a dinaphthothiophene ring,

X301 may be O, S, or N-[$(L_{304})_{xb4}$-$R_{304}$],

$R_{311}$ to $R_{314}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group -Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), and -P(=O)($Q_{31}$)($Q_{32}$),

xb22 and xb23 may each independently be 0, 1, or 2,

$L_{301}$, xb1, R301, and $Q_{31}$ to $Q_{33}$ are the same as described above,

$L_{302}$ to $L_{304}$ may each independently be the same as defined in connection with $L_{301}$

xb2 to xb4 may each independently be the same as defined in connection with xb1, and

R302 to R304 may each independently be the same as defined in connection with $R_{301}$.

For example, $L_{301}$ to $L_{304}$ in Formulae 301, 301-1, and 301-2 may each independently be selected from: a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{30}$ arylene group, a substituted or unsubstituted $C_1$-$C_{20}$ heteroarylene group, a substituted or unsubstituted divalent non-aromatic condensed polycyclic group, and a substituted or unsubstituted divalent non-aromatic condensed heteropolycyclic group, but embodiments are not limited thereto.

For example, in Formulae 301, 301-1, and 301-2, $L_{301}$ to $L_{304}$ may each independently be selected from:

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and $-P(=O)(Q_{31})(Q_{32})$, and

$Q_{31}$ to $Q_{33}$ are the same as described above.

As another example, $R_{301}$ to $R_{304}$ in Formulae 301, 301-1, and 301-2 may each independently be selected from: deuterium, -F, -Cl, -Br, -I, a hydroxyl group, a cyano group, a nitro group, an amidino group, a hydrazino group, a hydrazono group, a substituted or unsubstituted $C_1$-$C_{60}$ (*e.g.* $C_1$-$C_{10}$) alkyl group, a substituted or unsubstituted $C_2$-$C_{60}$ (*e.g.* $C_2$-$C_{10}$) alkenyl group, a substituted or unsubstituted $C_2$-$C_{60}$ (*e.g.* $C_2$-$C_{10}$) alkynyl group, a substituted or unsubstituted $C_1$-$C_{60}$ (*e.g.* $C_1$-$C_{10}$) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_1$-$C_{20}$ heteroaryl group, a substituted or unsubstituted monovalent non-aromatic condensed polycyclic group, a substituted or unsubstituted monovalent non-aromatic condensed heteropolycyclic group, $-Si(Q_{301})(Q_{302})(Q_{303})$, $-N(Q_{301})(Q_{302})$, $-B(Q_{301})(Q_{302})$, $-C(=O)(Q_{301})$, $-S(=O)_2(Q_{301})$, and $-P(=O)(Q_{301})(Q_{302})$, but embodiments are not limited thereto.

In one embodiment, $R_{301}$ to $R_{304}$ in Formulae 301, 301-1, and 301-2 may each independently be selected from:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and $-P(=O)(Q_{31})(Q_{32})$, and $Q_{31}$ to $Q_{33}$ are the same as described above.

In one embodiment, the host may include an alkaline earth-metal complex. For example, the host may include a complex selected from a Be complex (for example, Compound H55), a Mg complex, and a Zn complex. For example, the host may be selected from a Be complex (for example, Compound H55), a Mg complex, and a Zn complex.

In one or more embodiments, the host may include at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds H1 to H55, but embodiments of the present disclosure are not limited thereto:

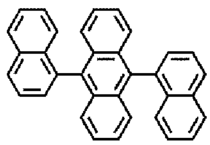
H1

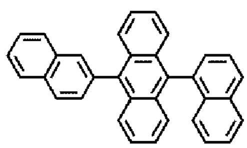
H2

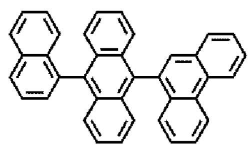
H3

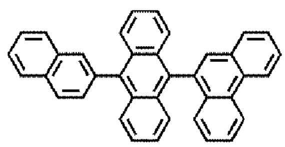
H4

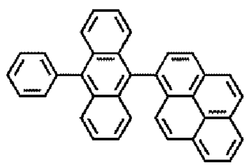
H5

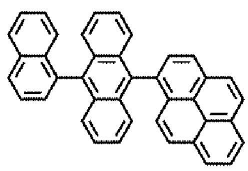
H6

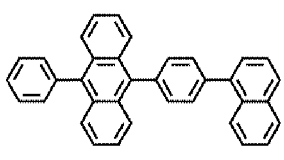
H7

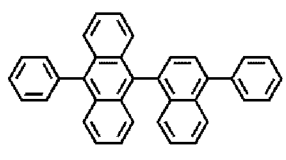
H8

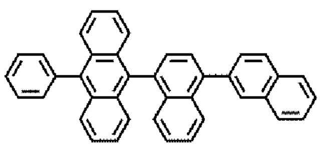
H9

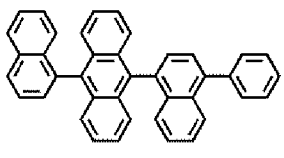
H10

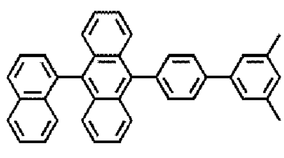
H11

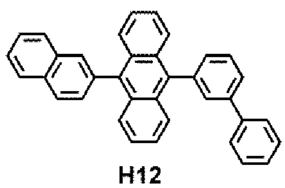
H12

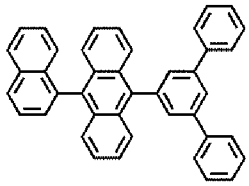
H13

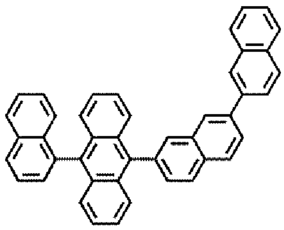
H14

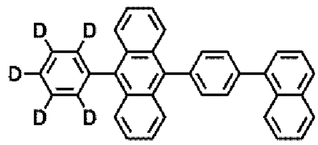
H15

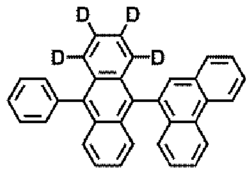
H16

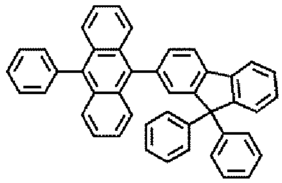
H17

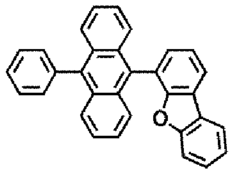
H18

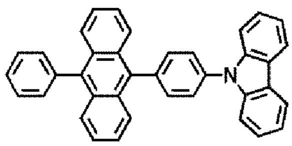
H19

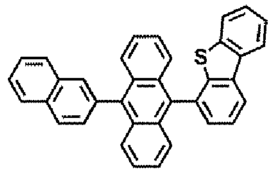
H20

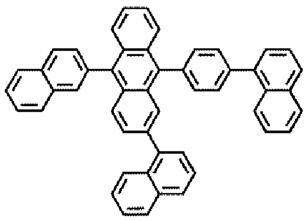
H21

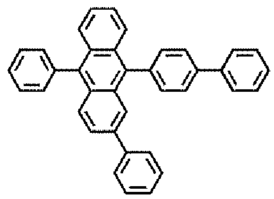
H22

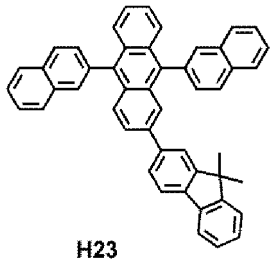
H23

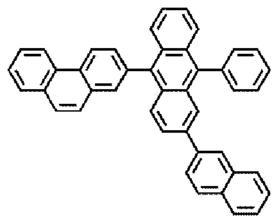
H24

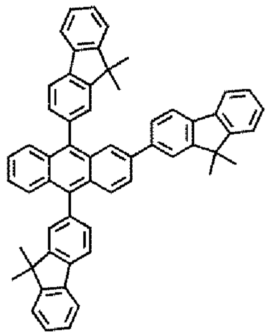
H25

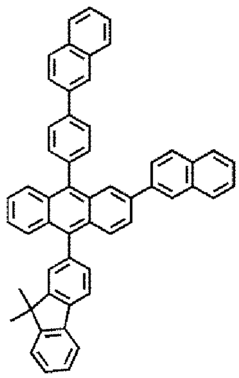
H26

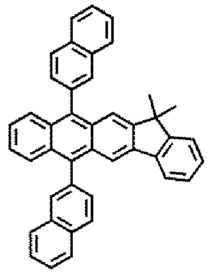
H27

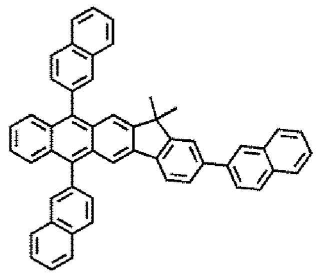
H28

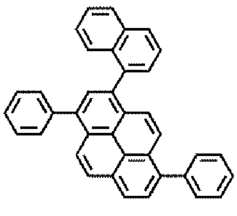
H29

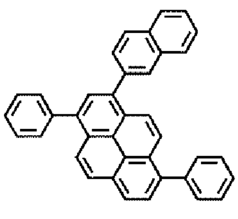
H30

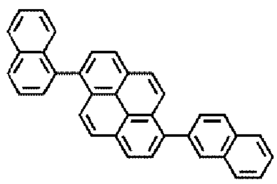
H31

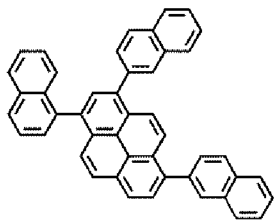
H32

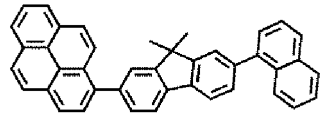
H33

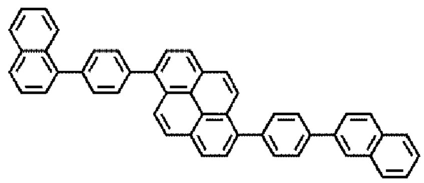
H34

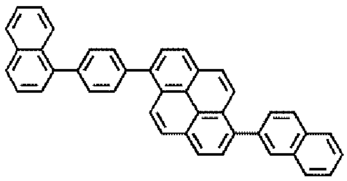
H35

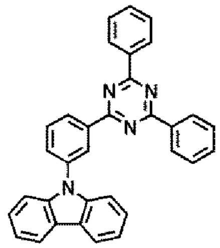
H36

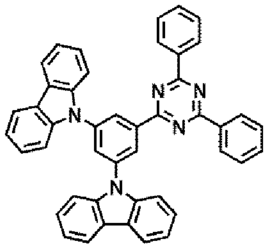
H37

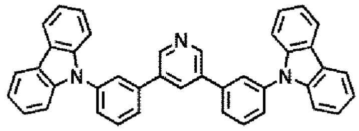
H38

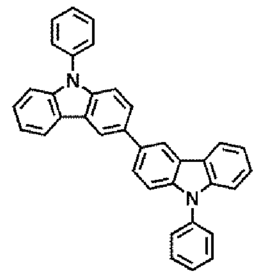
H39

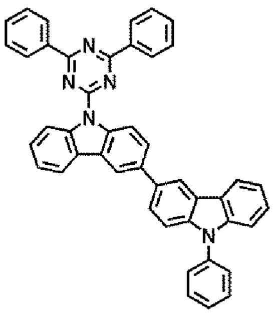
H40

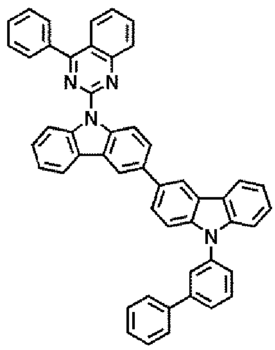
H41

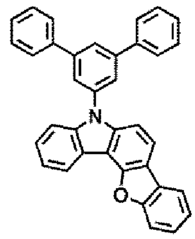
H42

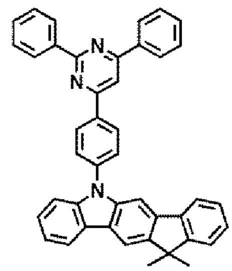
H43

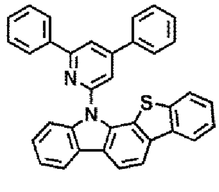
H44

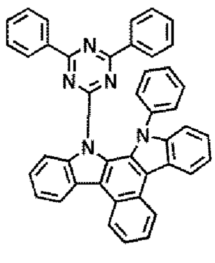
H45

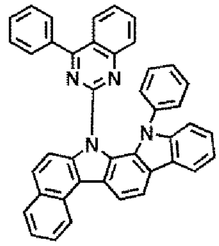
H46

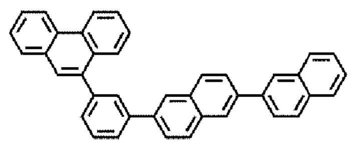
H47

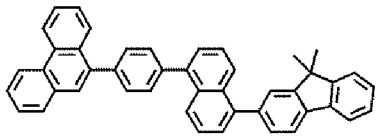
H48

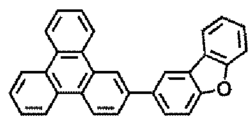
H49

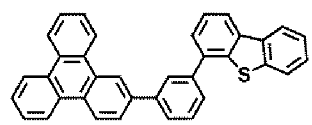
H50

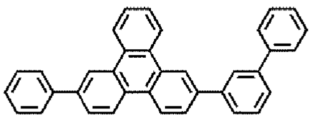

H51

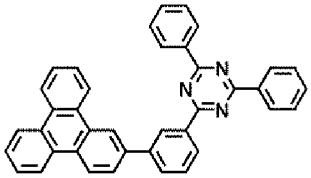

H52

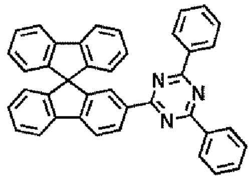

H53

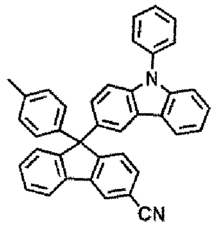

H54

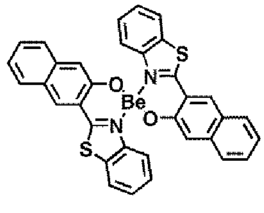

H55

In one or more embodiments, the host may include at least one selected from a silicon-containing compound (for example, BCPDS or the like), and a phosphine oxide-containing compound (for example, POPCPA or the like).

In one or more embodiments, the host may include a compound of a single type only, or two or more compounds that are different from each other (for example, the host may consist of BCPDS and POPCPA), but embodiments of the present disclosure are not limited thereto.

[Phosphorescent dopant included in emission layer in organic layer 150]

The phosphorescent dopant may include the organometallic compound represented by Formula 1.

In addition, the phosphorescent dopant may include an organometallic complex represented by Formula 401:

<Formula 401>

$$M'(L_{401})_{xc1}(L_{402})_{xc2}$$

<Formula 402>

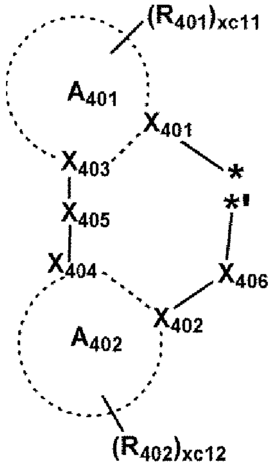

In Formulae 401 and 402,

M' may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),

$L_{401}$ may be a ligand represented by Formula 402, and xc1 may be 1, 2, or 3, wherein, when xc1 is 2 or more, two or more $L_{401}$(s) may be identical to or different from each other,

$L_{402}$ may be an organic ligand, and xc2 may be an integer from 0 to 4, wherein, when xc2 is 2 or more, two or more $L_{402}$(s) may be identical to or different from each other,

X401 to X404 may each independently be nitrogen or carbon,

X401 and X403 may be linked via a single bond or a double bond, and X402 and $X_{404}$ may be linked via a single bond or a double bond,

ring $A_{401}$ and ring $A_{402}$ may each independently be a $C_5$-$C_{60}$ (*e.g.* $C_5$-$C_{30}$) carbocyclic group or a $C_1$-$C_{60}$ (*e.g.* $C_1$-$C_{20}$) heterocyclic group,

$X_{405}$ may be a single bond, *-O-*', *-S-*', *-C(=O)-*', *-N($Q_{411}$)-*', *-C($Q_{411}$)($Q_{412}$)-*', *-C($Q_{411}$)-C($Q_{412}$)-*', *-C($Q_{411}$)=*', or *=C=*', wherein $Q_{411}$ and $Q_{412}$ may each independently be hydrogen, deuterium, a $C_1$-$C_{20}$ alkyl group, a $C_1$-$C_{20}$ alkoxy group, a phenyl group, a biphenyl group, a terphenyl group, or a naphthyl group,

$X_{406}$ may be a single bond, O, or S,

$R_{401}$ and $R_{402}$ may each independently be selected from hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{20}$ alkyl group, a substituted or unsubstituted $C_1$-$C_{20}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* $C_6$-$C_{30}$) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group, and a substituted or unsubstituted monovalent non-aromatic condensed heteropolycyclic group, - Si($Q_{401}$)($Q_{402}$)($Q_{403}$), -N($Q_{401}$)($Q_{402}$), -B($Q_{401}$)($Q_{402}$), -C(=O)($Q_{401}$), -S(=O)$_2$($Q_{401}$), and - P(=O)($Q_{401}$)($Q_{402}$), wherein $Q_{401}$ to $Q_{403}$ may each independently be selected from $C_1$-$C_{10}$ alkyl group, a $C_1$-$C_{10}$ alkoxy group, a $C_6$-$C_{20}$ aryl group, and a $C_1$-$C_{20}$ heteroaryl group,

xc11 and xc12 may each independently be an integer from 0 to 10, and

**[0144]** * and *' in Formula 402 each indicate a binding site to M' in Formula 401.

In one embodiment, ring $A_{401}$ and ring $A_{402}$ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X401 may be nitrogen, and X402 may be carbon, or ii) X401 and X402 may each be nitrogen at the same time.

In one or more embodiments, R401 and R402 in Formula 402 may each independently be selected from:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;

a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;

a cyclopentyl group, a cyclohexyl group, an adamantanyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group,

a carbazolyl group, a dibenzofuranyl group, and a dibenzothiophenyl group; and

$-Si(Q_{401})(Q_{402})(Q_{403})$, $-N(Q_{401})(Q_{402})$, $-B(Q_{401})(Q_{402})$, $-C(=O)(Q_{401})$, $-S(=O)_2(Q_{401})$, and $-P(=O)(Q_{401})(Q_{402})$, and

$Q_{401}$ to $Q_{403}$ may each independently be selected from a $C_1$-$C_{10}$ alkyl group, a $C_1$-$C_{10}$ alkoxy group, a phenyl group, a biphenyl group, and a naphthyl group, but embodiments of the present disclosure are not limited thereto.

In one or more embodiments, in Formula 401, when xc1 is 2 or more, two $A_{401}$(s) in two or more $L_{401}$(s) may optionally be linked via X407, which is a linking group, or when xc1 is 2 or more, two A402(s) in two or more $L_{401}$(s) may optionally be linked via $X_{408}$, which is a linking group (see Compounds PD1 to PD4 and PD7). $X_{407}$ and $X_{408}$ may each independently be a single bond, *-O-*', *-S-*', *-C(=O)-*', *-N($Q_{413}$)-*', *-C($Q_{413}$)($Q_{414}$)-*', or *-C($Q_{413}$)=C($Q_{414}$)-*' (wherein $Q_{413}$ and $Q_{414}$ may each independently be hydrogen, deuterium, a $C_1$-$C_{20}$ alkyl group, a $C_1$-$C_{20}$ alkoxy group, a phenyl group, a biphenyl group, a terphenyl group, or a naphthyl group), but embodiments of the present disclosure are not limited thereto.

$L_{402}$ in Formula 401 may be a monovalent, divalent, or trivalent organic ligand. For example, $L_{402}$ may be halogen, diketone (for example, acetylacetonate), carboxylic acid (for example, picolinate), -C(=O), isonitrile, -CN, and a phosphorus-containing material (for example, phosphine or phosphite), but embodiments of the present disclosure are not limited thereto.

In one embodiment, the phosphorescent dopant may be, for example, selected from Compounds PD1 to PD25, but embodiments of the present disclosure are not limited thereto:

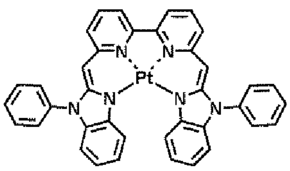
PD1

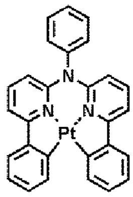
PD2

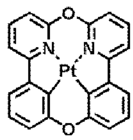
PD3

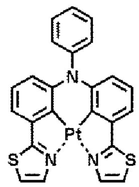
PD4

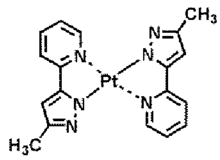
PD5

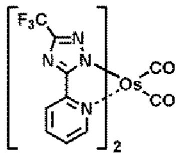
PD6

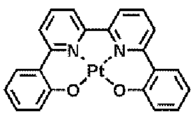
PD7

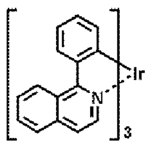
PD8

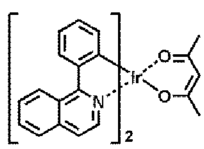
PD9

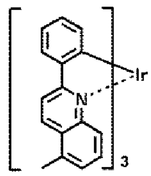
PD10

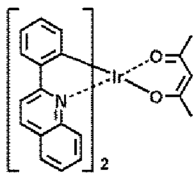
PD11

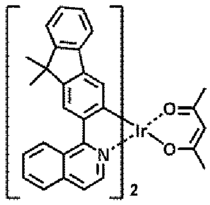
PD12

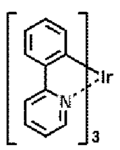
PD13

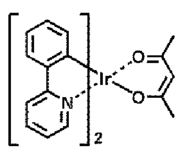
PD14

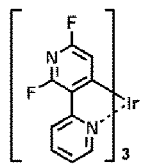
PD15

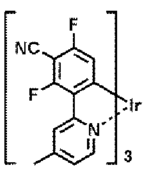
PD16

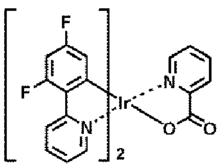
PD17

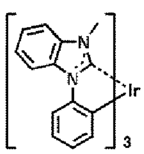
PD18

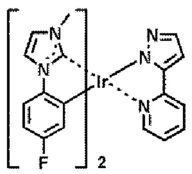
PD19

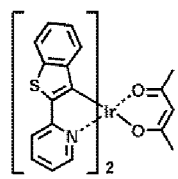
PD20

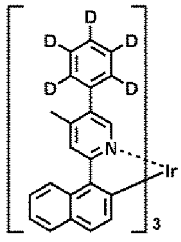

PD21

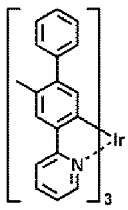

PD22

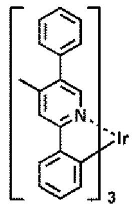

PD23

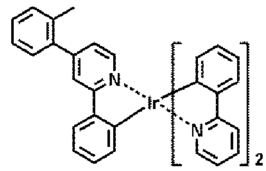

PD24

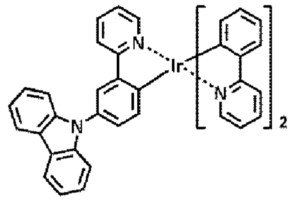

PD25

[Fluorescent dopant in emission layer]

The fluorescent dopant may include an arylamine compound or a styrylamine compound.

The fluorescent dopant may include a compound represented by Formula 501:

<Formula 501>

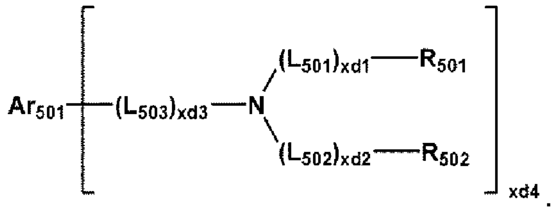

In Formula 501,

$Ar_{501}$ may be a substituted or unsubstituted $C_5$-$C_{60}$ carbocyclic group or a substituted or unsubstituted $C_1$-$C_{60}$ heterocyclic group,

$L_{501}$ to $L_{503}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ (*e.g.* $C_6$-$C_{30}$) arylene group, a substituted or unsubstituted $C_1$-$C_{60}$ (*e.g.* $C_1$-$C_{20}$) heteroarylene group, a substituted or unsubstituted divalent non-aromatic condensed polycyclic group, and a substituted or unsubstituted divalent non-aromatic condensed heteropolycyclic group

xd1 to xd3 may each independently be an integer from 0 to 3,

$R_{501}$ and $R_{502}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ *(e.g.* $C_6$-$C_{30}$) aryloxy group, a substituted or unsubstituted $C_6$-$C_{60}$ *(e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group, and a substituted or unsubstituted monovalent non-aromatic condensed heteropolycyclic group, and

xd4 may be an integer from 1 to 6.

For example, $Ar_{501}$ may be a substituted or unsubstituted $C_5$-$C_{30}$ carbocyclic group or a substituted or unsubstituted $C_1$-$C_{20}$ heterocyclic group, but embodiments are not limited thereto.

In one embodiment, $Ar_{501}$ in Formula 501 may be selected from:

a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and

a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, and a naphthyl group.

In one or more embodiments, $L_{501}$ to $L_{503}$ in Formula 501 may each independently be selected from:

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R501 and R502 in Formula 501 may each independently be selected from:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - $Si(Q_{31})(Q_{32})(Q_{33})$, and

$Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

In one or more embodiments, xd4 in Formula 501 may be 2 or more *(e.g* 2), but embodiments of the present disclosure are not limited thereto.

For example, the fluorescent dopant may be selected from Compounds FD1 to FD22:

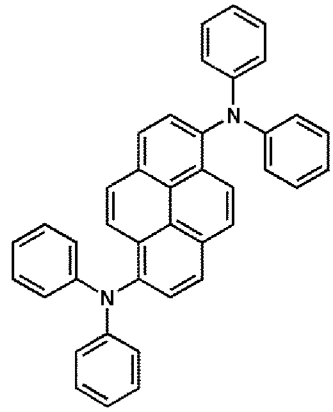

FD1

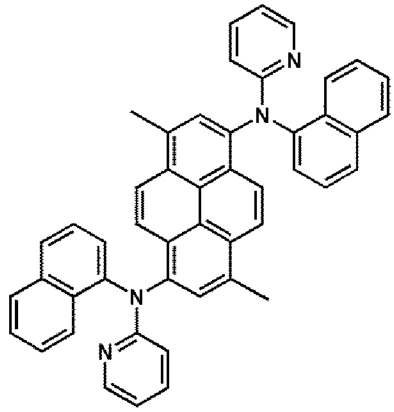

FD2

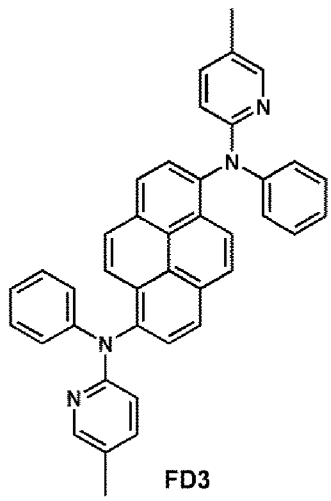

FD3

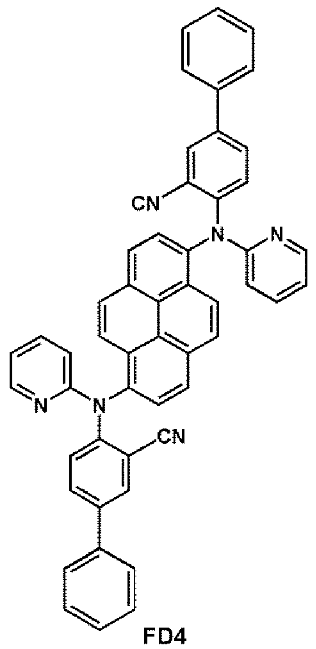

FD4

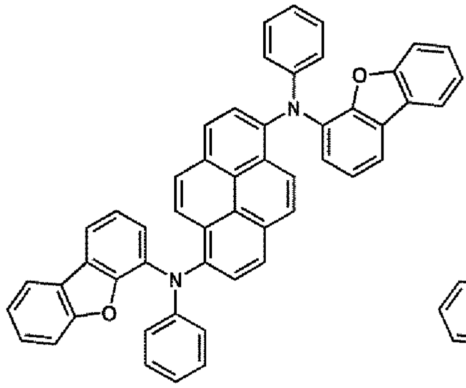

FD5

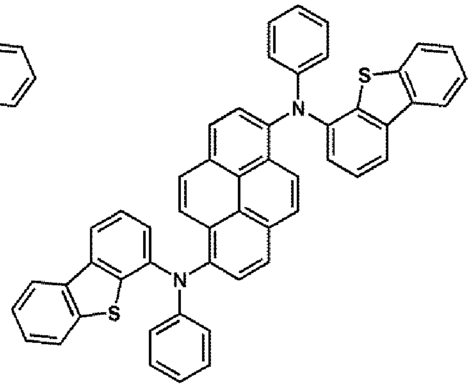

FD6

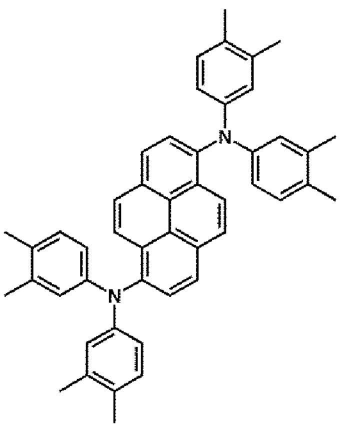

FD7

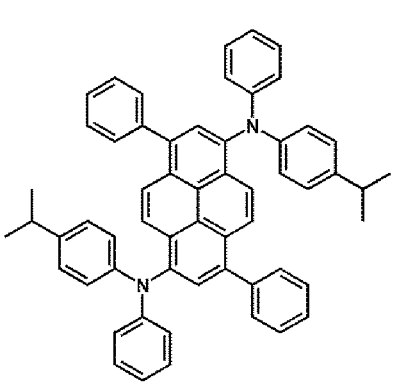

FD8

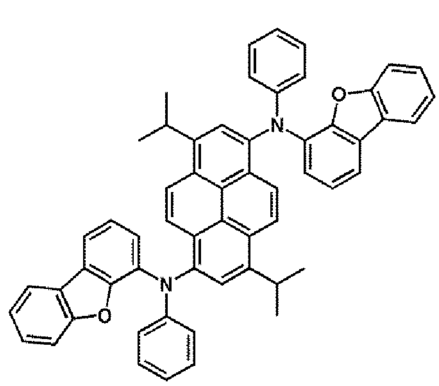

FD9

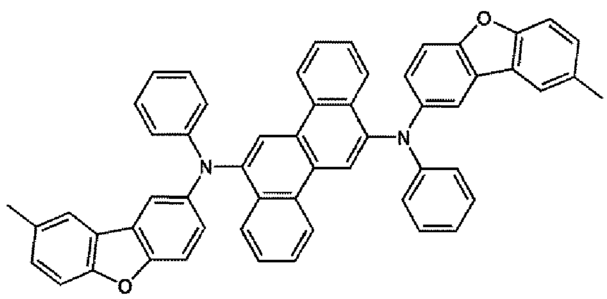

FD10

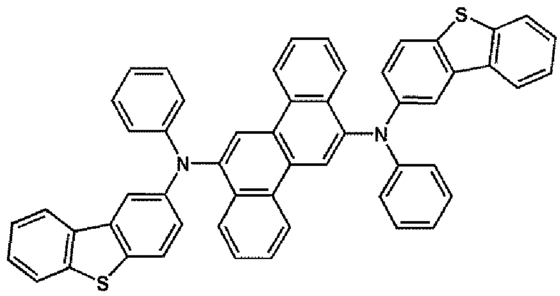

FD11

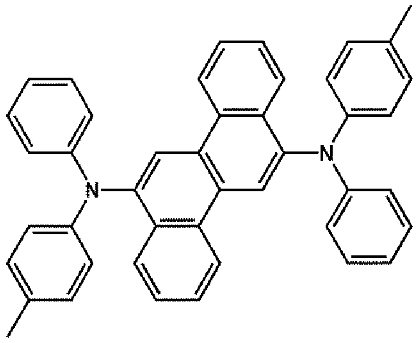

FD12

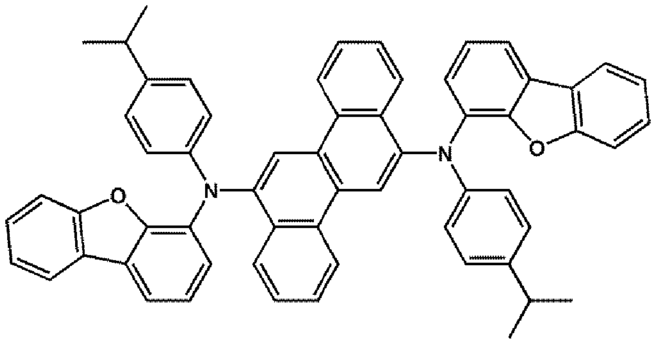

FD13

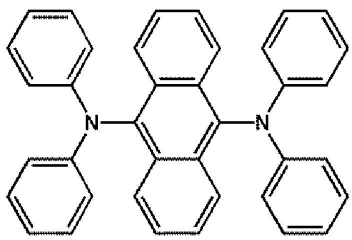

FD14

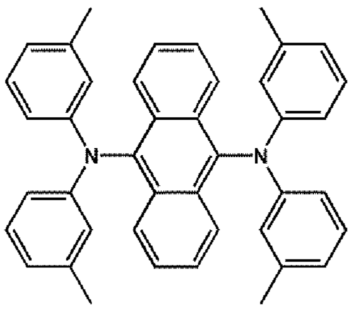

FD15

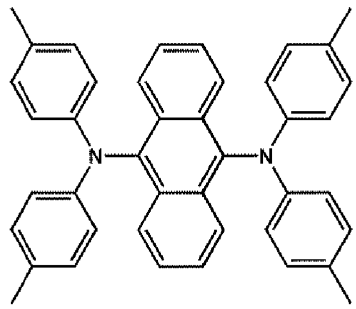

FD16

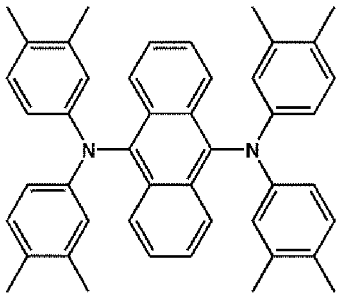

FD17

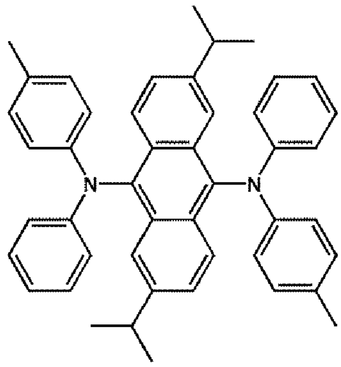

FD18

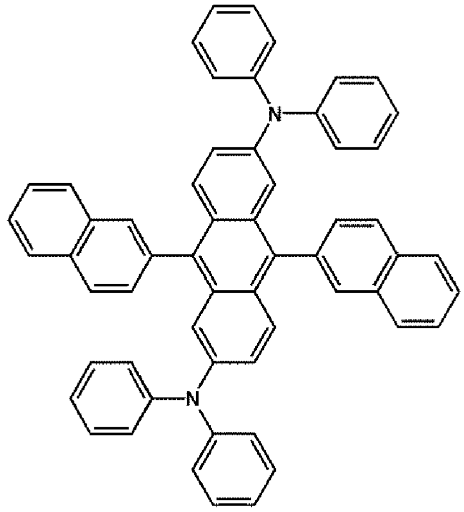

FD19

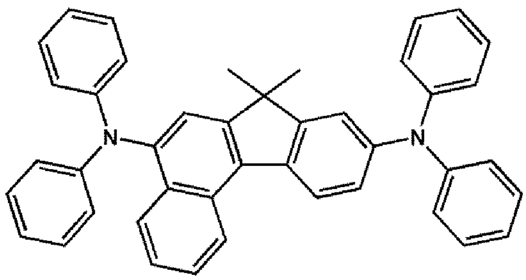

FD20

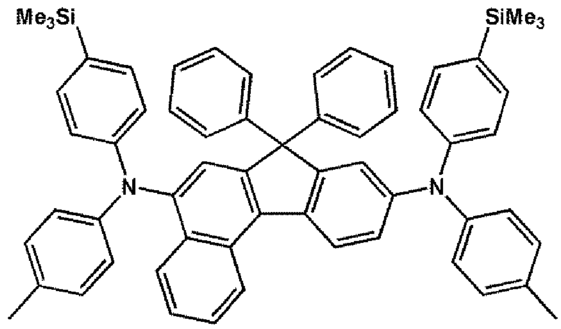

FD21

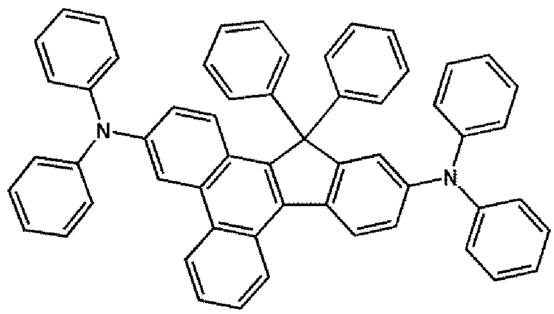

FD22

In one or more embodiments, the fluorescent dopant may be selected from the following compounds, but embodiments of the present disclosure are not limited thereto:

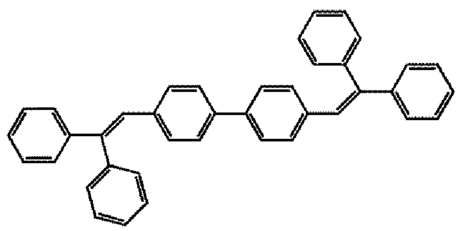

DPVBi

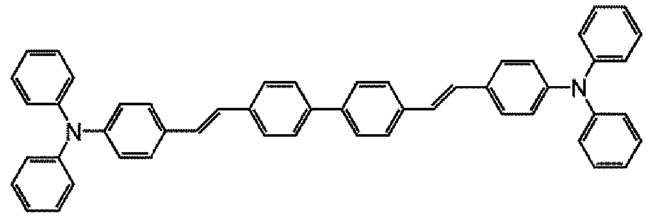

DPAVBi

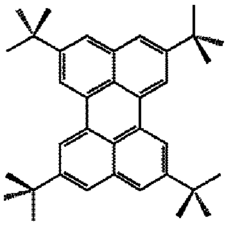

TBPe

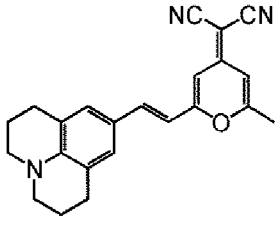

DCM

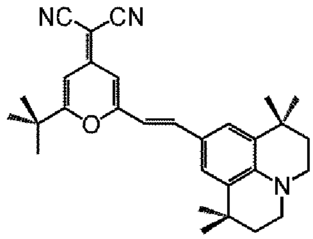

DCJTB

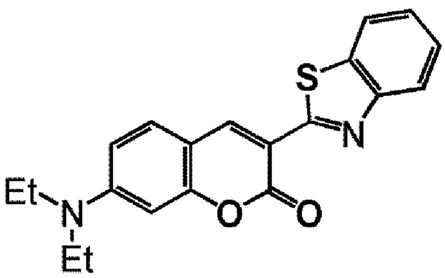

Coumarin 6

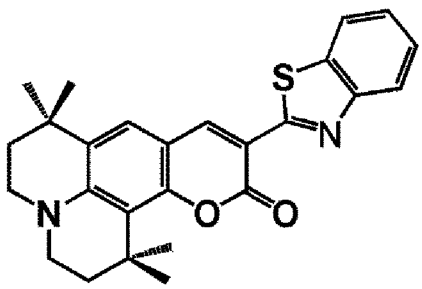

C545T

[Electron transport region in organic layer 150]

The electron transport region may have i) a single-layered structure including a single layer including a single material, ii) a single-layered structure including a single layer including a plurality of different materials, or iii) a multi-layered structure having a plurality of layers including a plurality of different materials.

The electron transport region may include at least one selected from a buffer layer, a hole blocking layer, an electron control layer, an electron transport layer, and an electron injection layer, but embodiments of the present disclosure are not limited thereto.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein for each structure, constituting layers are sequentially stacked from an emission layer. However, embodiments of the structure of the electron transport region are not limited thereto.

The electron transport region (for example, a buffer layer, a hole blocking layer, an electron control layer, or an electron transport layer in the electron transport region) may include a metal-free compound containing at least one $\pi$ electron-depleted nitrogen-containing ring.

The "$\pi$ electron-depleted nitrogen-containing ring" indicates a $C_1$-$C_{60}$ (*e.g.* a $C_1$-$C_{30}$) heterocyclic group having at least one *-N=*' moiety as a ring-forming moiety.

For example, the "$\pi$ electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed with each other, or iii) a heteropolycyclic group in which at least one of 5-membered to 7-membered heteromonocyclic groups, each having at least one *-N=*' moiety, is condensed with at least one $C_5$-$C_{60}$ (*e.g.* a $C_5$-$C_{30}$) carbocyclic group.

Examples of the $\pi$ electron-depleted nitrogen-containing ring include an imidazole, a pyrazole, a thiazole, an

isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an isobenzothiazole, a benzoxazole, an isobenzoxazole, a triazole, a tetrazole, an oxadiazole, a triazine, a thiadiazole, an imidazopyridine, an imidazopyrimidine, and an azacarbazole, but are not limited thereto.

For example, the electron transport region may include a compound represented by Formula 601:

<Formula 601 >

$[Ar_{601}]_{xe11}$-$[(L_{601})_{xe1}$-$R_{601}]_{xe21}$

In Formula 601,

$Ar_{601}$ may be a substituted or unsubstituted $C_5$-$C_{60}$ carbocyclic group or a substituted or unsubstituted $C_1$-$C_{60}$ heterocyclic group,

xe11 may be 1, 2, or 3,

$L_{601}$ may be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group,

xe1 may be an integer from 0 to 5,

$R_{601}$ may be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, - $Si(Q_{601})(Q_{602})(Q_{603})$, $-C(=O)(Q_{601})$, $-S(=O)_2(Q_{601})$, and $-P(=O)(Q_{601})(Q_{602})$,

$Q_{601}$ to $Q_{603}$ may each independently be a $C_1$-$C_{10}$ alkyl group, a $C_1$-$C_{10}$ alkoxy group, a phenyl group, a biphenyl group, a terphenyl group, or a naphthyl group, and

xe21 may be an integer from 1 to 5.

In one embodiment, at least one of $Ar_{601}$(s) in the number of xe11 and $R_{601}$(s) in the number of xe21 may include the $\pi$ electron-depleted nitrogen-containing ring.

For example, $Ar_{601}$ may be a substituted or unsubstituted $C_5$-$C_{30}$ carbocyclic group or a substituted or unsubstituted $C_1$-$C_{20}$ heterocyclic group, but embodiments are not limited thereto.

In one embodiment, $Ar_{601}$ in Formula 601 may be selected from:

a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and

a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl

group, a $C_1$-$C_{20}$ alkoxy group, a phenyl group, a biphenyl group, a terphenyl group, a naphthyl group, -Si($Q_{31}$)($Q_{32}$)($Q_{33}$), -S(=O)$_2$($Q_{31}$), and -P(=O)($Q_{31}$)($Q_{32}$), and

$Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

When xe11 in Formula 601 is 2 or more, two or more $Ar_{601}$(s) may be linked via a single bond.

In one or more embodiments, $Ar_{601}$ in Formula 601 may be an anthracene group.

In one or more embodiments, the compound represented by Formula 601 may be represented by Formula 601-1:

<Formula 601-1>

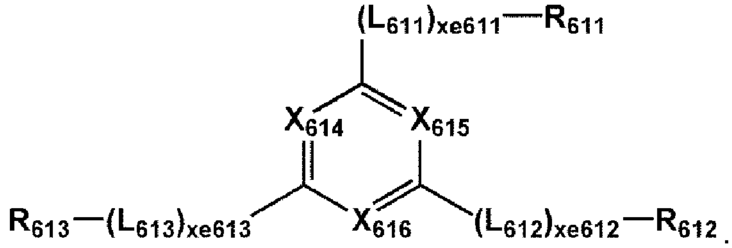

In Formula 601-1,

X614 may be N or C($R_{614}$), X615 may be N or C($R_{615}$), and X616 may be N or C($R_{616}$), wherein at least one selected from $X_{614}$ to $X_{616}$ may be N,

$L_{611}$ to $L_{613}$ may each independently be the same as defined in connection with $L_{601}$,

$xe_{611}$ to $xe_{613}$ may each independently be the same as defined in connection with xe1,

$R_{611}$ to $R_{613}$ may each independently be the same as defined in connection with $R_{601}$, and

$R_{614}$ to $R_{616}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, and a naphthyl group.

For example, $L_{601}$ and $L_{611}$ to $L_{613}$ in Formulae 601 and 601-1 may each independently be selected from: a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{30}$ arylene group, a substituted or unsubstituted $C_1$-$C_{20}$ heteroarylene group, a substituted or unsubstituted divalent non-aromatic condensed polycyclic group, and a substituted or unsubstituted divalent non-aromatic condensed heteropolycyclic group, but embodiments are not limited thereto.

In one embodiment, $L_{601}$ and $L_{611}$ to $L_{613}$ in Formulae 601 and 601-1 may each independently be selected from:

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a

pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,

but embodiments of the present disclosure are not limited thereto.

In one or more embodiments, xe1 and xe611 to xe613 in Formulae 601 and 601-1 may each independently be 0, 1, or 2.

For example, R601 and R611 to R613 in Formulae 601 and 601-1 may each independently be selected from: a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_1$-$C_{20}$ heteroaryl group, a substituted or unsubstituted monovalent non-aromatic condensed polycyclic group, a substituted or unsubstituted monovalent non-aromatic condensed heteropolycyclic group, - $Si(Q_{601})(Q_{602})(Q_{603})$, $-C(=O)(Q_{601})$, $-S(=O)_2(Q_{601})$, and $-P(=O)(Q_{601})(Q_{602})$.

In one or more embodiments, R601 and R611 to R613 in Formulae 601 and 601-1 may each independently be selected from:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a

terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and

$-S(=O)_2(Q_{601})$ and $-P(=O)(Q_{601})(Q_{602})$, and

$Q_{601}$ and $Q_{602}$ are the same as described above.

The electron transport region may include at least one compound selected from Compounds ET1 to ET36, but embodiments of the present disclosure are not limited thereto:

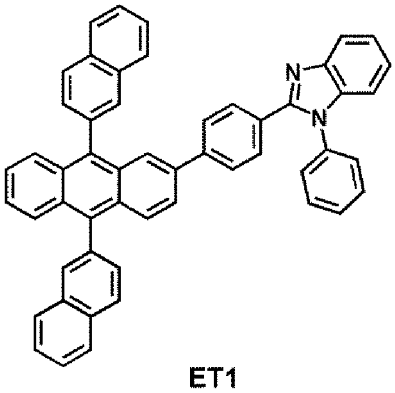

ET1

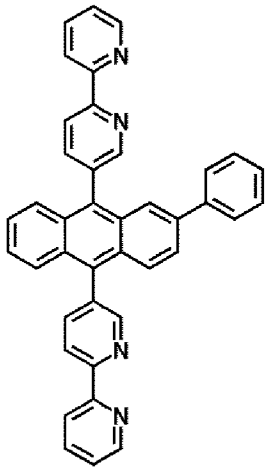

ET2

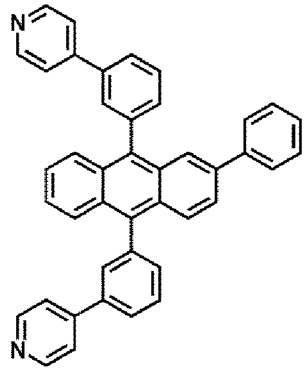

ET3

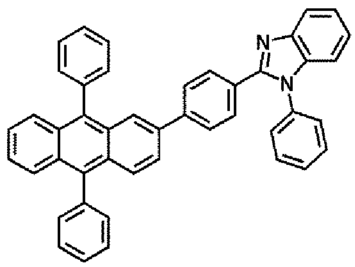

ET4

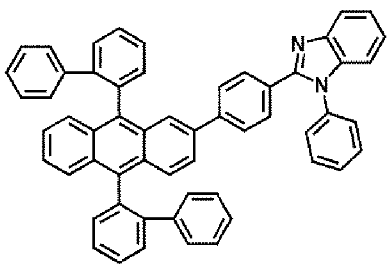

ET5

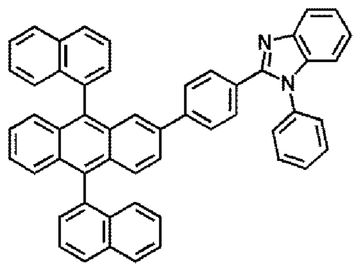

ET6

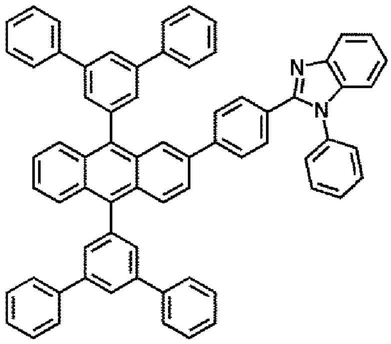

ET7

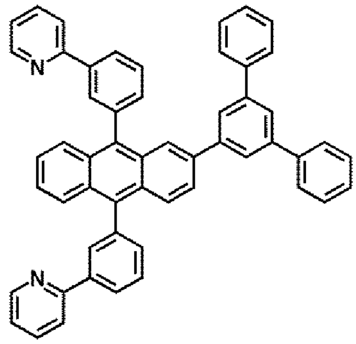

ET8

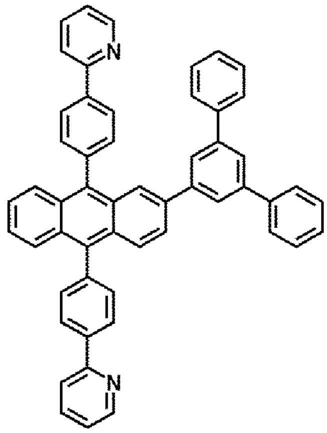

ET9

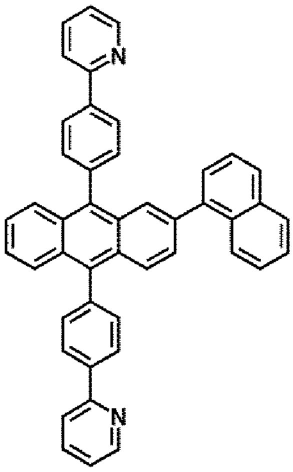

ET10

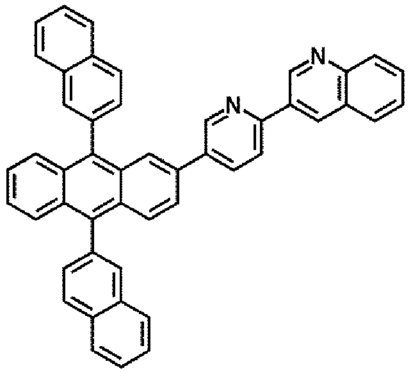

ET11

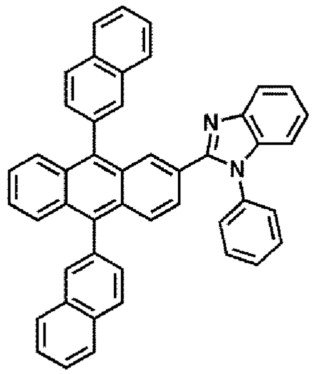

ET12

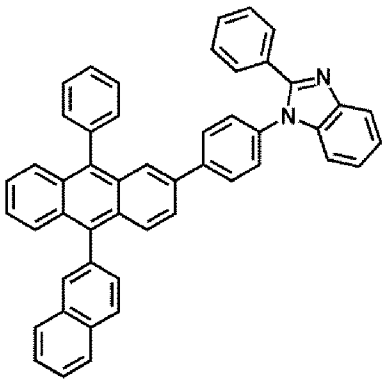

ET13

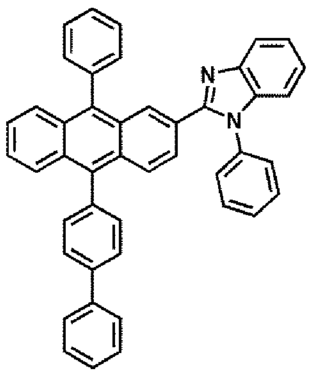

ET14

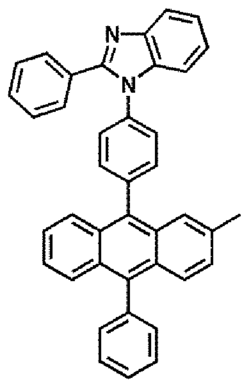

ET15

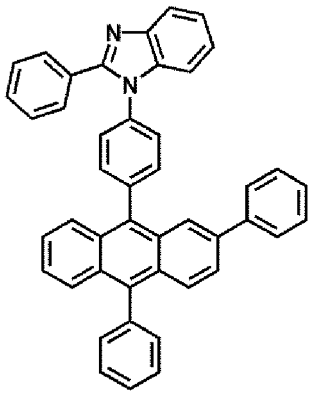

ET16

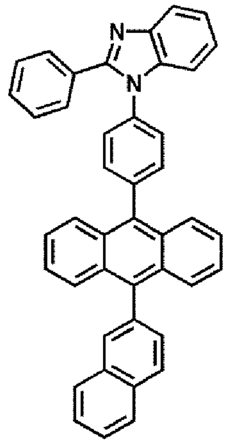

ET17

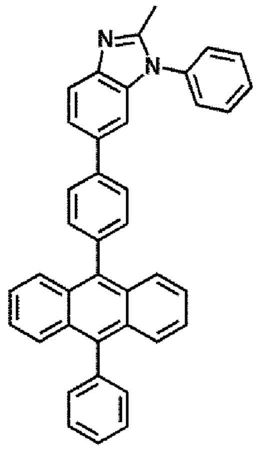

ET18

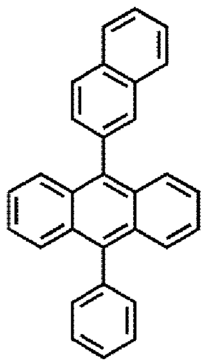

ET19

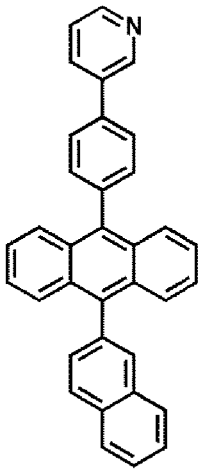

ET20

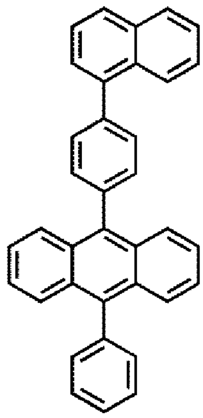

ET21

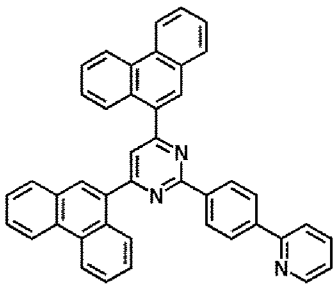

ET22

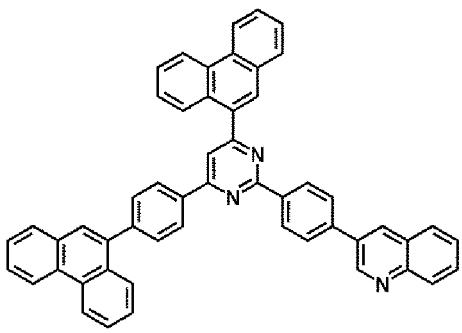

ET23

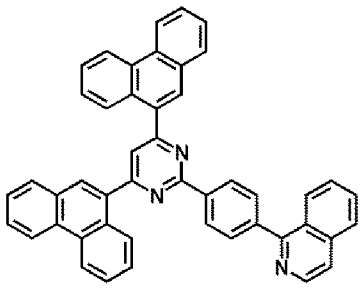

ET24

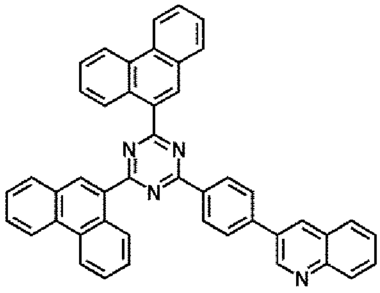

ET25

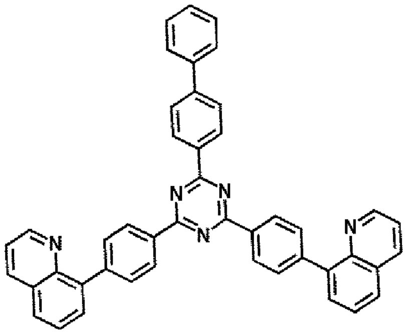

ET26

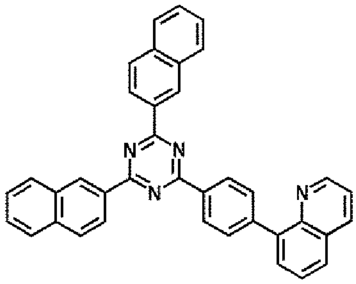

ET27

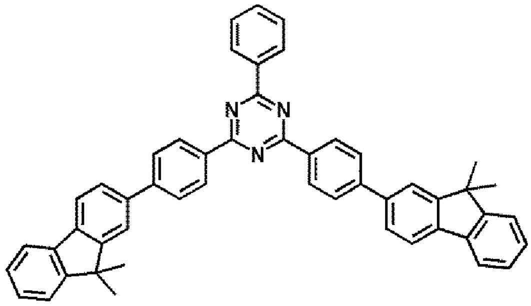

ET28

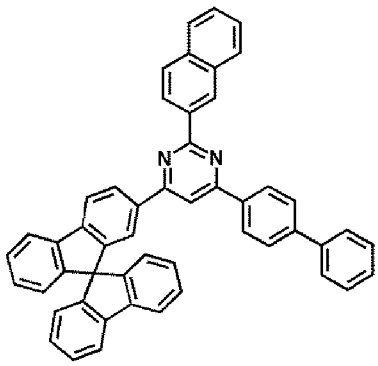

ET29

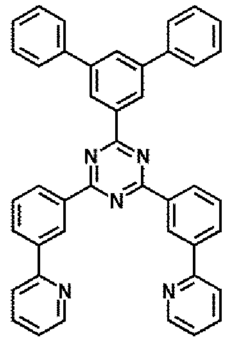

ET30

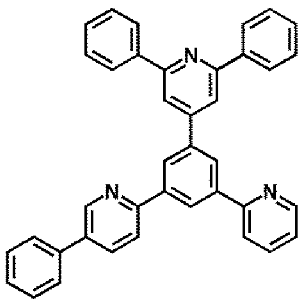

ET31

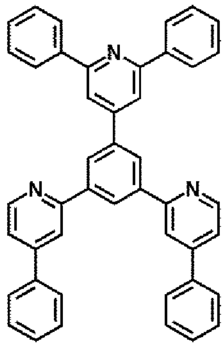

ET32

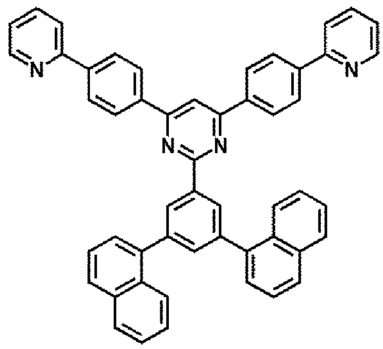

ET33

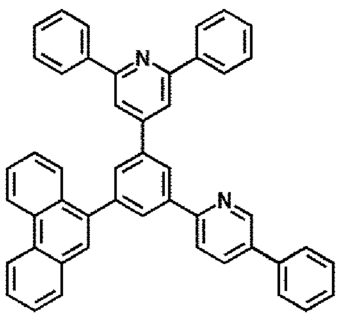

ET34

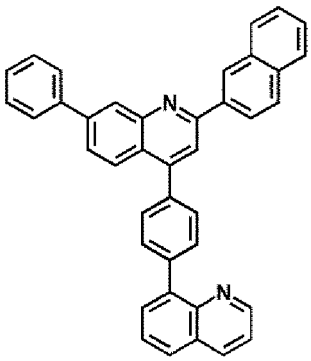

ET35

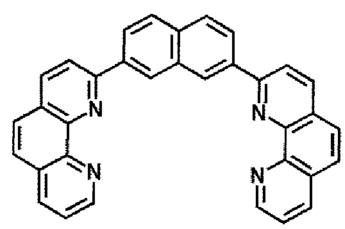

ET36

In one or more embodiments, the electron transport region may include at least one selected from 2,9-dimethyl-4,7-diphenyl-1,10-phenanthroline (BCP), 4,7-diphenyl-1,10-phenanthroline (Bphen), $Alq_3$, BAlq, 3-(biphenyl-4-yl)-5-(4-tert-butylphenyl)-4-phenyl-4H-1,2,4-triazole (TAZ), and NTAZ:

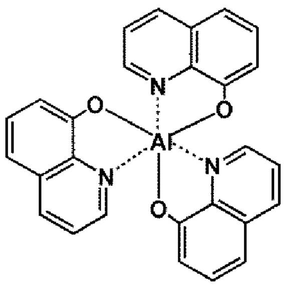

$Alq_3$

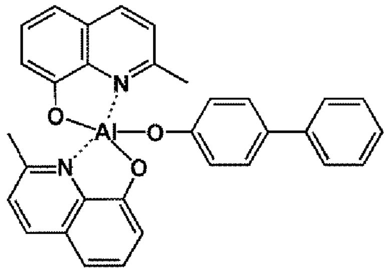

BAlq

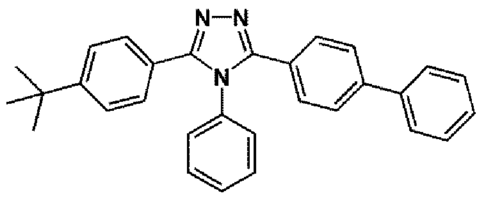

TAZ

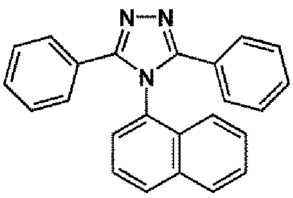

NTAZ

In one embodiment, the electron transport region may include a phosphine oxide-containing compound or the like, but embodiments of the present disclosure are not limited thereto. In one embodiment, the phosphine oxide-containing compound may be used in a hole blocking layer in the electron transport region, but embodiments of the present disclosure are not limited thereto.

A thickness of the buffer layer, the hole blocking layer, or the electron control layer may be in a range of about 20 Å to about 1,000 Å, for example, about 20 Å to about 700 Å, about 20 Å to about 500 Å, about 20 Å to about 400, about 30 Å to about 400 Å or about 30 Å to about 300 Å. When the thicknesses of the buffer layer, the hole blocking layer, and the electron control layer are within these ranges, the electron transport region may have excellent hole blocking characteristics or electron control characteristics without a substantial increase in driving voltage.

A thickness of the electron transport layer may be from about 100 Å to about 1,000 Å, for example, about 100 Å to about 700 Å, about 100 Å to about 600 Å, about 150 Å to about 600 Å, about 150 Å to about 500 Å or about 250 Å to about 350 Å.

When the thickness of the electron transport layer is within the range described above, satisfactory electron transport characteristics may be obtained without a substantial increase in driving voltage.

The electron transport region (for example, the electron transport layer in the electron transport region) may further include, in addition to the materials described above, a metal-containing material.

The metal-containing material may include at least one selected from alkali metal complex and alkaline earth-metal complex. The alkali metal complex may include a metal ion selected from a Li ion, a Na ion, a K ion, a Rb ion, and a Cs ion, and the alkaline earth-metal complex may include a metal ion selected from a Be ion, a Mg ion, a Ca ion, a Sr ion, and a Ba ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyl oxazole, a hydroxy phenylthiazole, a hydroxy diphenyl oxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may include a Li complex. The Li complex may include, for example, Compound ET-D1 (lithium quinolate, LiQ) or ET-D2:

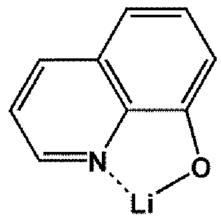

ET-D1

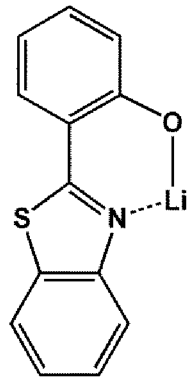

ET-D2 .

The electron transport region may include an electron injection layer that facilitates electron injection from the second electrode 190. The electron injection layer may directly contact the second electrode 190.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof.

The alkali metal may be selected from Li, Na, K, Rb, and Cs. In one embodiment, the alkali metal may be Li, Na, or Cs. In one or more embodiments, the alkali metal may be Li or Cs, but embodiments of the present disclosure are not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth-metal compound, and the rare earth metal compound may be selected from oxides and halides (for example, fluorides, chlorides, bromides, or iodides) of the alkali metal, the alkaline earth-metal, and the rare earth metal.

The alkali metal compound may be selected from alkali metal oxides, such as $Li_2O$, $CS_2O$, or $K_2O$, and alkali metal halides, such as LiF, NaF, CsF, KF, LiI, NaI, CsI, or KI. In one embodiment, the alkali metal compound may be selected from LiF, $Li_2O$, NaF, LiI, NaI, CsI, and KI, but embodiments of the present disclosure are not limited thereto.

The alkaline earth-metal compound may be selected from alkaline earth-metal oxides, such as BaO, SrO, CaO, $Ba_xSr_{1-x}O$ ($0<x<1$), or $Ba_xCa_{1-x}O$ ($0<x<1$). In one embodiment, the alkaline earth-metal compound may be selected from BaO, SrO, and CaO, but embodiments of the present disclosure are not limited thereto.

The rare earth metal compound may be selected from $YbF_3$, $ScF_3$, $SC_2O_3$, $Y_2O_3$, $Ce_2O_3$, $GdF_3$, and $TbF_3$. In one embodiment, the rare earth metal compound may be selected from $YbF_3$, $ScF_3$, $TbF_3$, $YbI_3$, $ScI_3$, and $TbI_3$, but embodiments of the present disclosure are not limited thereto.

The alkali metal complex, the alkaline earth-metal complex, and the rare earth metal complex may include an ion of alkali metal, alkaline earth-metal, and rare earth metal as described above, and a ligand coordinated with a metal ion of the alkali metal complex, the alkaline earth-metal complex, or the rare earth metal complex may be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but embodiments of the present disclosure are not limited thereto.

The electron injection layer may consist of an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof, as described above. In one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof may be homogeneously or non-homogeneously dispersed in a matrix including the organic material.

A thickness of the electron injection layer may be in a range of about 1 Å to about 100 Å, for example, about 3 Å to about 90 Å or about 3 Å to about 20 Å. When a thickness of the electron injection layer is within these ranges, satisfactory electron injection characteristics may be obtained without substantial increase in driving voltage.

[Second electrode 190]

The second electrode 190 may be disposed on the organic layer 150 having such a structure. The second electrode 190 may be a cathode which is an electron injection electrode, and in this regard, a material for forming the second electrode 190 may be selected from metal, an alloy, an electrically conductive compound, and a combination thereof, which have a relatively low work function.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The first electrode 190 may have a single-layered structure, or a multi-layered structure including two or more layers.

[Description of FIGS. 2 to 4]

FIG. 2 is a schematic view of an organic light-emitting device 20 according to an embodiment. The organic light-emitting device 20 includes a first capping layer 210, the first electrode 110, the organic layer 150, and the second electrode 190, which are sequentially stacked in this stated order. FIG. 3 is a schematic view of an organic light-emitting device 30 according to an embodiment. The organic light-emitting device 30 includes the first electrode 110, the organic layer 150, the second electrode 190, and a second capping layer 220, which are sequentially stacked in this stated order. FIG. 4 is a schematic view of an organic light-emitting device 40 according to an embodiment. The organic light-emitting device 40 includes the first capping layer 210, the first electrode 110, the organic layer 150, the second electrode 190, and the second capping layer 220, which are sequentially stacked in this stated order.

Regarding FIGS. 2 to 4, the first electrode 110, the organic layer 150, and the second electrode 190 may be understood by referring to the description presented in connection with FIG. 1.

In the organic layer 150 of each of the organic light-emitting devices 20 and 40, light generated in an emission layer may pass through the first electrode 110 and the first capping layer 210 toward the outside, wherein the first electrode 110 may be a semi-transmissive electrode or a transmissive electrode. In the organic layer 150 of each of the organic light-emitting devices 30 and 40, light generated in an emission layer may pass through the second electrode 190 and the second capping layer 220 toward the outside, wherein the second electrode 190 may be a semi-transmissive electrode or a transmissive electrode.

The first capping layer 210 and the second capping layer 220 may increase external luminescence efficiency according to the principle of constructive interference.

The first capping layer 210 and the second capping layer 220 may each independently be an organic capping layer including an organic material, an inorganic capping layer including an inorganic material, or a composite capping layer including an organic material and an inorganic material.

At least one selected from the first capping layer 210 and the second capping layer 220 may each independently include at least one material selected from carbocyclic compounds, heterocyclic compounds, amine-based compounds, porphyrine derivatives, phthalocyanine derivatives, naphthalocyanine derivatives, alkali metal complexes, and alkaline earth-based complexes. The carbocyclic compound, the heterocyclic compound, and the amine-based compound may be optionally substituted with a substituent containing at least one element selected from O, N, S, Se, Si, F, Cl, Br, and I. In one embodiment, at least one selected from the first capping layer 210 and the second capping layer 220 may each independently include an amine-based compound.

In one embodiment, at least one selected from the first capping layer 210 and the second capping layer 220 may each independently include the compound represented by Formula 201 or the compound represented by Formula 202.

In one or more embodiments, at least one selected from the first capping layer 210 and the second capping layer 220 may each independently include a compound selected from Compounds HT28 to HT33 and Compounds CP1 to CP5, but embodiments of the present disclosure are not limited thereto:

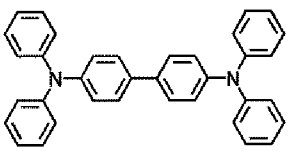

CP1

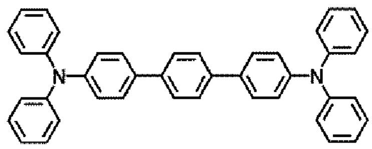

CP2

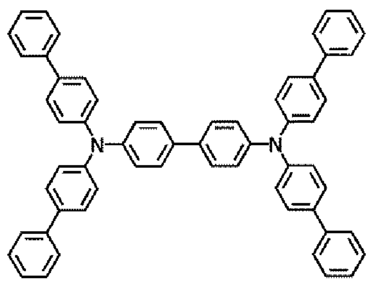

CP3

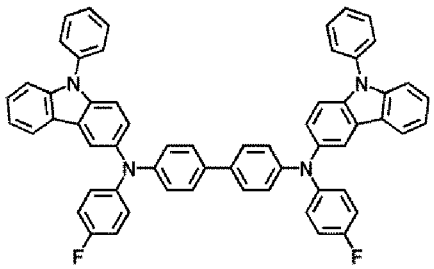
CP4

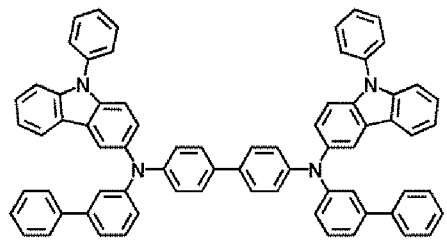
CP5

Hereinbefore, the organic light-emitting device according to an embodiment has been described in connection with FIGS. 1 to 4, but embodiments of the present disclosure are not limited thereto.

Layers constituting the hole transport region, an emission layer, and layers constituting the electron transport region may be formed in a certain region by using one or more suitable methods selected from vacuum deposition, spin coating, casting, Langmuir-Blodgett (LB) deposition, ink-jet printing, laser-printing, and laser-induced thermal imaging (LITI).

When layers constituting the hole transport region, an emission layer, and layers constituting the electron transport region are formed by vacuum deposition, the deposition may be performed at a deposition temperature of about 100 °C to about 500 °C, a vacuum degree of about $133\times10^{-8}$ to about $133\times10^{-3}$ Pa (about $10^{-8}$ torr to about $10^{-3}$ torr) and a deposition speed of about 0.01 Å/sec to about 100 Å/sec by taking into account a material to be included in a layer to be formed, and the structure of a layer to be formed.

When layers constituting the hole transport region, an emission layer, and layers constituting the electron transport region are formed by spin coating, the spin coating may be performed at a coating speed of about 2,000 rpm to about 5,000 rpm and at a heat treatment temperature of about 80 °C to 200 °C by taking into account a material to be included in a layer to be formed, and the structure of a layer to be formed.

[General definition of substituents]

The term "$C_1$-$C_{60}$ alkyl group" as used herein refers to a linear or branched aliphatic saturated hydrocarbon monovalent group having 1 to 60 carbon atoms, and examples thereof include a methyl group, an ethyl group, a propyl group, an isobutyl group, a sec-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group. Corresponding definitions apply to other ranges given for the number of carbon atoms in an alkyl/alkylene group.

The term "$C_2$-$C_{60}$ alkenyl group" as used herein refers to a hydrocarbon group having at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group. Corresponding definitions apply to other ranges given for the number of carbon atoms in an alkenyl/alkenylene group.

The term "$C_2$-$C_{60}$ alkynyl group" as used herein refers to a hydrocarbon group having at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group. Corresponding definitions apply to other ranges given for the number of carbon atoms in an alkynyl/alkynylene group.

The term "$C_1$-$C_{60}$ alkoxy group" as used herein refers to a monovalent group represented by $-OA_{101}$ (wherein A101 is the $C_1$-$C_{60}$ alkyl group), and examples thereof include a methoxy group, an ethoxy group, and an isopropyloxy group. Corresponding definitions apply to other ranges given for the number of carbon atoms in an alkoxy group.

The term "$C_3$-$C_{10}$ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent monocyclic group having at least one heteroatom selected from N, O, Si, P, and S as a ring-forming atom and 1 to 10 carbon atoms, and examples thereof include a 1,2,3,4-oxatriazolidinyl group, a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and examples

thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, Si, P, and S as a ring-forming atom, 1 to 10 carbon atoms, and at least one carbon-carbon double bond in its ring. Non-limiting examples of the $C_1$-$C_{10}$ heterocycloalkenyl group include a 4,5-dihydro-1,2,3,4-oxatriazolyl group, a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and a $C_6$-$C_{60}$ arylene group used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other. Corresponding definitions apply to other ranges given for the number of carbon atoms in an aryl/arylene group.

The term "$C_1$-$C_{60}$ heteroaryl group" as used herein refers to a monovalent group having a carbocyclic aromatic system that has at least one heteroatom selected from N, O, Si, P, and S as a ring-forming atom, in addition to 1 to 60 carbon atoms. The term "$C_1$-$C_{60}$ heteroarylene group" as used herein refers to a divalent group having a carbocyclic aromatic system that has at least one heteroatom selected from N, O, Si, P, and S as a ring-forming atom, in addition to 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be condensed with each other. Corresponding definitions apply to other ranges given for the number of carbon atoms in an heteroaryl/heteroarylene group.

The term "$C_6$-$C_{60}$ aryloxy group" as used herein refers to -OA102 (wherein A102 is the $C_6$-$C_{60}$ aryl group), and a $C_6$-$C_{60}$ arylthio group used herein indicates -SA103 (wherein A103 is the $C_6$-$C_{60}$ aryl group). Corresponding definitions apply to other ranges given for the number of carbon atoms in an aryloxy group and an arylthio group.

The term "monovalent non-aromatic condensed polycyclic group" as used herein refers to a monovalent group (for example, having 8 to 60 carbon atoms) having two or more rings condensed with each other, only carbon atoms as ring-forming atoms, and no aromaticity in its entire molecular structure. A detailed example of the monovalent non-aromatic condensed polycyclic group is a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one heteroatom selected from N, O, Si, P, and S, other than carbon atoms, as a ring-forming atom, and no aromaticity in its entire molecular structure. An example of the monovalent non-aromatic condensed heteropolycyclic group is a carbazolyl group. The term "divalent non-aromatic condensed heteropolycyclic group" as used herein refers to a divalent group having the same structure as the monovalent non-aromatic condensed heteropolycyclic group.

The term "$C_4$-$C_{60}$ carbocyclic group" as used herein refers to a monocyclic or polycyclic group having 4 to 60 carbon atoms in which a ring-forming atom is a carbon atom only. The term "$C_4$-$C_{60}$ carbocyclic group" as used herein refers to an aromatic carbocyclic group or a non-aromatic carbocyclic group. The $C_4$-$C_{60}$ carbocyclic group may be a ring, such as benzene, a monovalent group, such as a phenyl group, or a divalent group, such as a phenylene group. In one or more embodiments, depending on the number of substituents connected to the $C_4$-$C_{60}$ carbocyclic group, the $C_4$-$C_{60}$ carbocyclic group may be a trivalent group or a quadrivalent group. Corresponding definitions apply to other ranges given for the number of carbon atoms in a carbocyclic group.

The term "$C_2$-$C_{60}$ heterocyclic group" as used herein refers to a group having the same structure as the $C_4$-$C_{60}$ carbocyclic group, except that as a ring-forming atom, at least one heteroatom selected from N, O, Si, P, and S is used in addition to carbon (the number of carbon atoms may be in a range of 2 to 60). Corresponding definitions apply to other ranges given for the number of carbon atoms in a heterocyclic group.

In the present specification, at least one substituent of the substituted $C_4$-$C_{60}$ *(e.g.* $C_4$-$C_{30}$) carbocyclic group, the substituted $C_1$-$C_{60}$ *(e.g.* $C_1$-$C_{20}$) heterocyclic group, the substituted $C_2$-$C_{60}$ (*e.g.* $C_2$-$C_{20}$) heterocyclic group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ *(e.g.* $C_6$-$C_{30}$) arylene group, the substituted $C_1$-$C_{60}$ *(e.g.* $C_1$-$C_{20}$) heteroarylene group, the substituted divalent non-aromatic condensed polycyclic group, the substituted divalent non-aromatic condensed heteropolycyclic group, the substituted $C_1$-$C_{60}$ *(e.g.* $C_1$-$C_{20}$) alkyl group, the substituted $C_2$-$C_{60}$ *(e.g.* $C_2$-$C_{20}$) alkenyl group, the substituted $C_2$-$C_{60}$ *(e.g.* $C_2$-$C_{20}$) alkynyl group, the substituted $C_1$-$C_{60}$ *(e.g.* $C_1$-$C_{20}$) alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the

substituted $C_6$-$C_{60}$ (*e.g.* $C_6$-$C_{30}$) aryl group, the substituted $C_6$-$C_{60}$ *(e.g.* $C_6$-$C_{30}$) aryloxy group, the substituted $C_6$-$C_{60}$ *(e.g.* $C_6$-$C_{30}$) arylthio group, the substituted $C_1$-$C_{60}$ (*e.g.* $C_1$-$C_{20}$) heteroaryl group, the substituted monovalent non-aromatic condensed polycyclic group, and the substituted monovalent non-aromatic condensed heteropolycyclic group may be selected from:

deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ *(e.g.* $C_2$-$C_{20}$) alkenyl group, a $C_2$-$C_{60}$ *(e.g.* $C_2$-$C_{20}$) alkynyl group, and a C1-C60 (*e.g.* $C_1$-$C_{20}$) alkoxy group;

a $C_1$-$C_{60}$ *(e.g.* $C_1$-$C_{20}$) alkyl group, a $C_2$-$C_{60}$ *(e.g.* $C_2$-$C_{20}$) alkenyl group, a $C_2$-$C_{60}$ *(e.g.* $C_2$-$C_{20}$) alkynyl group, and a $C_1$-$C_{60}$ *(e.g.* $C_1$-$C_{20}$) alkoxy group, each substituted with at least one selected from deuterium, -F, -Cl, -Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ *(e.g.* $C_6$-$C_{30}$) aryl group, a $C_6$-$C_{60}$ *(e.g.* $C_6$-C30) aryloxy group, a $C_6$-$C_{60}$ *(e.g.* $C_6$-$C_{30}$) arylthio group, a $C_1$-$C_{60}$ *(e.g.* $C_1$-$C_{20}$) heteroaryl group, a monovalent non-aromatic condensed polycyclic group, a monovalent non-aromatic condensed heteropolycyclic group, -Si($Q_{11}$)($Q_{12}$)($Q_{13}$), - N($Q_{11}$)($Q_{12}$), -B($Q_{11}$)($Q_{12}$), -C(=O)($Q_{11}$), -S(=O)$_2$($Q_{11}$), and -P(=O)($Q_{11}$)($Q_{12}$);

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ *(e.g.* $C_6$-$C_{30}$) aryloxy group, a $C_6$-$C_{60}$ *(e.g.* $C_6$-$C_{30}$) arylthio group, a $C_1$-$C_{60}$ (e.g. $C_1$-$C_{20}$) heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ *(e.g.* $C_6$-$C_{30}$) aryloxy group, a $C_6$-$C_{60}$ *(e.g.* $C_6$-$C_{30}$) arylthio group, a $C_1$-$C_{60}$ (*e.g.* $C_1$-$C_{20}$) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a $C_1$-$C_{60}$ *(e.g.* $C_1$-$C_{20}$) alkyl group, a $C_2$-$C_{60}$ *(e.g.* $C_2$-$C_{20}$) alkenyl group, a $C_2$-$C_{60}$ *(e.g.* C2-C20) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ *(e.g.* $C_6$-$C_{30}$) aryl group, a $C_6$-$C_{60}$ *(e.g.* $C_6$-$C_{30}$) aryloxy group, a $C_6$-$C_{60}$ *(e.g.* $C_6$-$C_{30}$) arylthio group, a $C_1$-$C_{60}$ *(e.g.* $C_1$-$C_{20}$) heteroaryl group, a monovalent non-aromatic condensed polycyclic group, a monovalent non-aromatic condensed heteropolycyclic group, -Si($Q_{21}$)($Q_{22}$)($Q_{23}$), -N($Q_{21}$)($Q_{22}$), - B($Q_{21}$)($Q_{22}$), -C(=O)($Q_{21}$), -S(=O)$_2$($Q_{21}$), and -P(=O)($Q_{21}$)($Q_{22}$); and

-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), and - P(=O)($Q_{31}$)($Q_{32}$), and

$Q_{11}$ to $Q_{13}$, $Q_{21}$ to $Q_{23}$, and $Q_{31}$ to $Q_{33}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ *(e.g.* $C_2$-$C_{20}$) alkenyl group, a $C_2$-$C_{60}$ *(e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ *(e.g.* $C_6$-$C_{30}$) aryl group, a $C_1$-$C_{60}$ *(e.g.* $C_1$-$C_{20}$) heteroaryl group, a monovalent non-aromatic condensed polycyclic group, a monovalent non-aromatic condensed heteropolycyclic group, a $C_1$-$C_{60}$ (*e.g.* $C_1$-$C_{20}$) alkyl group substituted with at least one selected from deuterium, -F, and a cyano group, a $C_6$-$C_{60}$ (*e.g.* $C_6$-$C_{30}$) aryl group substituted with at least one selected from deuterium, -F, and a cyano group, a biphenyl group, and a terphenyl group.

The term "Ph" as used herein refers to a phenyl group, the term "Me" as used herein refers to a methyl group, the term "Et" as used herein refers to an ethyl group, the term "ter-Bu" or "$Bu^t$" as used herein refers to a tert-butyl group, and the term "OMe" as used herein refers to a methoxy group.

The term "biphenyl group" as used herein refers to "a phenyl group substituted with a phenyl group". In other words, the "biphenyl group" is a substituted phenyl group having a $C_6$-$C_{60}$ aryl group as a substituent.

The term "terphenyl group" as used herein refers to "a phenyl group substituted with a biphenyl group". In other words, the "terphenyl group" is a phenyl group having, as a substituent, a $C_6$-$C_{60}$ aryl group substituted with a $C_6$-$C_{60}$ aryl group.

*, *', and *" as used herein, unless defined otherwise, each refer to a binding site to a neighboring atom in a corresponding formula

Hereinafter, a compound according to embodiments and an organic light-emitting device according to embodiments will be described in detail with reference to Synthesis Examples and Examples. The wording "B was used instead of A" used in describing Synthesis Examples refers to that an identical molar equivalent of B was used in place of A.

## [Synthesis Examples]

### Synthesis Example 1: Synthesis of Compound BD1

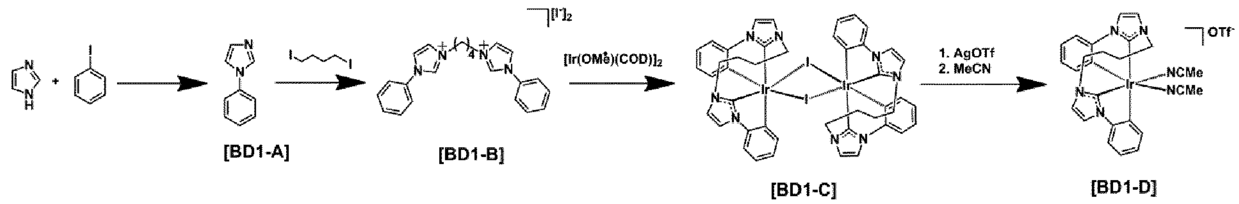


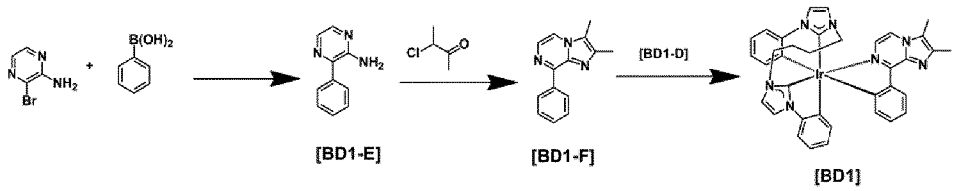


Synthesis of Intermediate [BD1-A]

Iodobenzene (1.0 eq), imidazole (1.2 eq), CuI (0.01 eq), $K_2CO_3$ (2.0 eq), and L-Proline (0.02 eq) were dissolved in dimethylsulfonate (0.1 M) and stirred at a temperature of 160 °C for 48 hours. The reaction mixture was cooled to room temperature, and an organic layer was extracted therefrom three times by using dichloromethane and water. Then, the extracted organic layer was dried by using magnesium sulfate and concentrated, and column chromatography was used to synthesize Intermediate [BD1-A] (yield: 65 %).

Synthesis of Intermediate [BD1-B]

Intermediate [BD1-A] (2.0 eq) and 1,4-diiodobutane (1.0 eq) were dissolved in toluene (1.0 eq) and stirred at a temperature of 120 °C for 12 hours. The reaction mixture was cooled to room temperature, washed with toluene, and then filtered to obtain a solid. The obtained solid was dried to synthesize Intermediate [BD1-B] (yield: 59 %).

Synthesis of Intermediate [BD1-C]

Intermediate [BD1-B] (1.0 eq), $[Ir(COD)OMe]_2$ (1.1 eq), $Ag_2O$ (0.5 eq), and sodium tert-butoxide (3.0 eq) were dissolved in 2-ethoxyethanol (0.5 M) and stirred at a temperature of 120 °C for 10 hours. The reaction mixture was cooled to room temperature, and an organic layer was extracted therefrom three times by using dichloromethane and water. Then, the extracted organic layer was dried by using magnesium sulfate and concentrated, and column chromatography was used to synthesize Intermediate [BD1-C] (yield: 21 %).

Synthesis of Intermediate [BD1-D]

Intermediate [BD1-C] (1.0 eq) and silver triflate (1.2 eq) were dissolved in acetone (1.0 M) and stirred at room temperature for 4 hours. Most of a solvent was removed from the reaction mixture under reduced pressure, and acetonitrile (20 eq) was added thereto. The mixture obtained therefrom was stirred for 0.5 hours. A solvent was removed therefrom under reduced pressure, and the result was concentrated to synthesize Intermediate [BD1-D] (yield: 81 %).

Synthesis of Intermediate [BD1-E]

3-bromopyrazin-2-amine (1.0 eq), phenylboronic acid (1.2 eq), $K_2CO_3$ (2.0 eq), and $Pd(PPh_3)_4$ (0.02 eq) were dissolved in toluene (0.1 M) and stirred at a temperature of 120 °C for 12 hours. The reaction mixture was cooled to room temperature, and an organic layer was extracted therefrom three times by using dichloromethane and water. Then, the extracted organic layer was dried by using magnesium sulfate and concentrated, and column chromatography was used to synthesize Intermediate [BD1-E] (yield: 84 %).

Synthesis of Intermediate [BD1-F]

Intermediate [BD1-E] (1.0 eq) was dissolved in ethanol (0.1 M), and 3-chlorobutan-2-one (1.1 eq) was slowly added dropwise thereto. Then, the reaction mixture was stirred at a temperature of 80 °C for 24 hours. The reaction mixture was cooled to room temperature, and an organic layer was extracted therefrom three times by using dichloromethane and water. Then, the extracted organic layer was dried by using magnesium sulfate and concentrated, and column chromatography was used to synthesize Intermediate [[BD1-F] (yield: 58 %).

Synthesis of Compound BD1

Intermediate [BD1-D], Intermediate [BD1-F], and $K_2CO_3$ (10.0 eq) were dissolved in 2-ethoxyethanol (0.05 M) and stirred at a temperature of 120 °C for 10 hours. The reaction mixture was cooled to room temperature, and an organic layer was extracted therefrom three times by using dichloromethane and water. Then, the extracted organic layer was dried by using magnesium sulfate and concentrated, and column chromatography was used to synthesize Compound [BD1] (yield: 61 %).

1H NMR (400 MHz, DMSO-d6): $\delta$= 8.82 (d, 1H), 8.61 (d, 1H), 8.33 (d, 1H), 7.54 (m, 3H), 7.23 (m, 4H), 6.77 (m, 2H), 6.67 (m, 2H), 5.21 (d, 2H), 5.06 (d, 2H), 3.17 (m, 2H), 3.01 (m, 2H), 2.55 (s, 3H), 2.23 (s, 3H), 1.53 (m, 2H), 1.50 (m, 2H),

LCMS. Calcd for $C_{36}H_{34}IrN_7$ ([M]+): m/z 756.93. Found: m/z 757.25.

**Synthesis Example 2: Synthesis of Compound BD2**

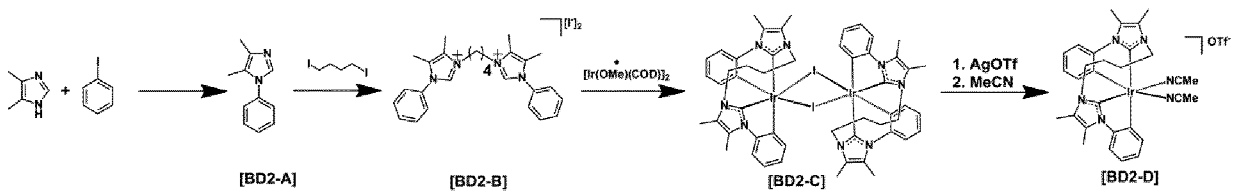


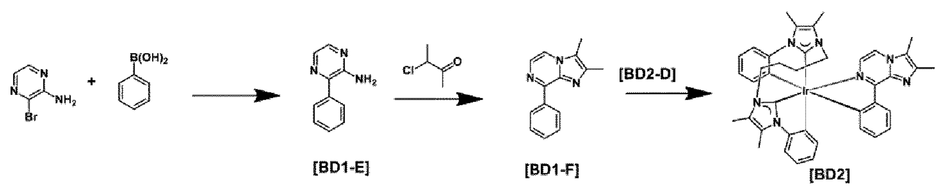


Synthesis of Intermediate fBD2-A]

Intermediate [BD2-A] (yield: 58 %) was synthesized in the same manner as in Synthesis of Intermediate [BD1-A], except that dimethylimidazole was used instead of imidazole.

Synthesis of Intermediate [BD2-B]

Intermediate [BD2-B] (yield: 51 %) was synthesized in the same manner as in Synthesis of Intermediate [BD1-B], except that Intermediate [BD2-A] was used instead of Intermediate [BD1-A].

Synthesis of Intermediate [BD2-C]

Intermediate [BD2-C] (yield: 81 %) was synthesized in the same manner as in Synthesis of Intermediate [BD1-C], except that Intermediate [BD2-B] was used instead of Intermediate [BD1-B].

Synthesis of Intermediate [BD2-D]

Intermediate [BD2-D] (yield: 37 %) was synthesized in the same manner as in Synthesis of Intermediate [BD1-D], except that Intermediate [BD2-C] was used instead of Intermediate [BD1-C].

Synthesis of Compound BD2

Compound BD2 (yield: 64 %) was synthesized in the same manner as in Synthesis of Compound BD1, except that Intermediate [BD2-D] was used instead of Intermediate [BD1-D].

1H NMR (400 MHz, DMSO-d6): δ= 8.82 (d, 1H), 8.61 (d, 1H), 8.33 (d, 1H), 7.54 (m, 3H), 7.23 (m, 4H), 6.77 (m, 2H), 6.67 (m, 2H), 3.17 (m, 2H), 3.01 (m, 2H), 2.55 (s, 3H), 2.36 (s, 12H), 2.23 (s, 3H), 1.53 (m, 2H), 1.50 (m, 2H),

LCMS. Calcd for $C_{40}H_{42}IrN_7$ ([M]+): m/z 813.04. Found: m/z 813.31.

**Synthesis Example 3: Synthesis of Compound BD3**

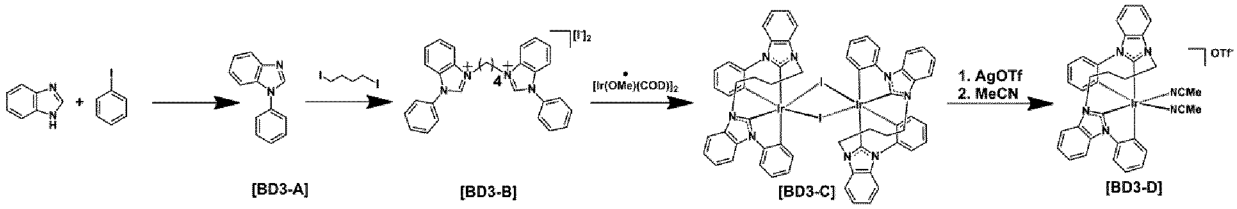


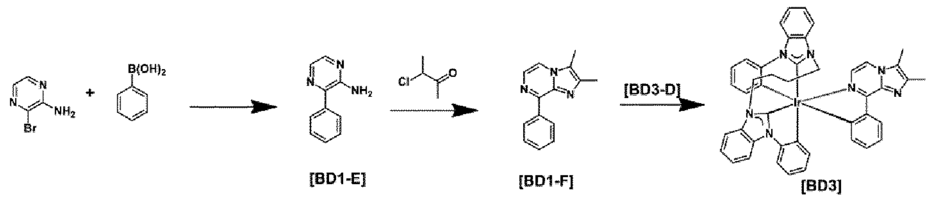


Synthesis of Intermediate [BD3-A]

Intermediate [BD3-A] (yield: 55 %) was synthesized in the same manner as in Synthesis of Intermediate [BD1-A], except that benzimidazole was used instead of imidazole.

Synthesis of Intermediate [BD3-B]

Intermediate [BD3-B] (yield: 54 %) was synthesized in the same manner as in Synthesis of Intermediate [BD1-B], except that Intermediate [BD3-A] was used instead of Intermediate [BD1-A].

Synthesis of Intermediate [BD3-C]

Intermediate [BD3-C] (yield: 74 %) was synthesized in the same manner as in Synthesis of Intermediate [BD1-C], except that Intermediate [BD3-B] was used instead of Intermediate [BD1-B].

Synthesis of Intermediate [BD3-D]

Intermediate [BD3-D] (yield: 41 %) was synthesized in the same manner as in Synthesis of Intermediate [BD1-D], except that Intermediate [BD3-C] was used instead of Intermediate [BD1-C].

Synthesis of Compound BD3

Compound BD3 (yield: 61 %) was synthesized in the same manner as in Synthesis of Compound [BD1], except that Intermediate [BD3-D] was used instead of Intermediate [BD1-D].

1H NMR (400 MHz, DMSO-d6): δ= 8.82 (d, 1H), 8.61 (d, 1H), 8.33 (d, 1H), 7.54 (m, 3H), 7.23 (m, 4H), 7.00 (d, 1H), 6.90 (m, 1H), 6.77 (m, 2H), 6.67 (m, 2H), 6.53 (m, 2H), 3.17 (m, 2H), 3.01 (m, 2H), 2.55 (s, 3H), 2.23 (s, 3H), 1.53 (m, 2H), 1.50 (m, 2H),

LCMS. Calcd for $C_{44}H_{33}IrN_7$ ([M]+): m/z 857.05. Found: m/z 857.28.

**[Examples]**

**Example 1**

As a substrate and an anode, a Corning 15 Ω/$cm^2$ (1,200 A) ITO glass substrate was cut to a size of 50 mm x 50 mm x 0.7 mm, sonicated with isopropyl alcohol and pure water each for 5 minutes, and then cleaned by exposure to ultraviolet rays and ozone for 30 minutes. Then, the ITO glass substrate was provided to a vacuum deposition apparatus.

2-TNATA was vacuum-deposited on the anode provided on the ITO glass substrate to form a hole injection layer having a thickness of 600 Å, and NPB was vacuum-deposited on the hole injection layer to form a hole transport layer having a thickness of 300 Å.

Compounds ETH1 and HTH1 (co-host) (a weight ratio of Compound ETH1 to Compound HTH1 was 1:1) and Compound BD1 (dopant) were co-deposited on the hole transport layer at a co-host to dopant weight ratio of 90:10 to form an emission layer having a thickness of 300 Å.

Diphenyl(4-(triphenylsilyl)phenyl)-phosphine oxide (TSPO1) was deposited on the emission layer to form a hole blocking layer having a thickness of 50 Å, $Alq_3$ was deposited on the hole blocking layer to form an electron transport layer having a thickness of 300 Å, LiF was deposited on the electron transport layer to form an electron injection layer having a thickness of 10 Å, and Al was vacuum-deposited on the electron injection layer to form a cathode having a thickness of 3,000 Å, thereby completing the manufacture of an organic light-emitting device.

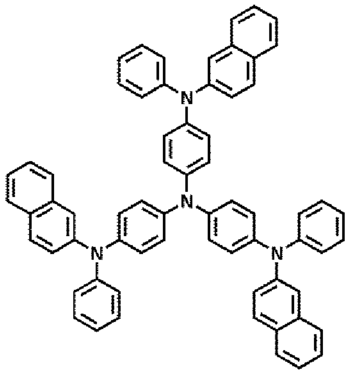

2-TNATA

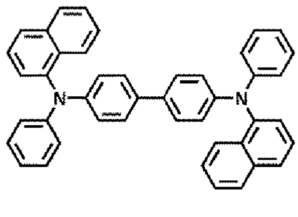

NPB

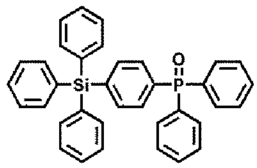

TSPO1

**Examples 2 to 5 and Comparative Examples 1 to 4**

Organic light-emitting devices were manufactured in the same manner as in Example 1, except that Compounds shown in Table 1 were each used instead of Compound BD1 as a dopant in forming an emission layer.

**Evaluation Example 1**

The driving voltage, current density, luminance, luminescence efficiency, emission color, and a wavelength of maximum emission of the organic light-emitting devices manufactured according to Examples 1 to 5 and Comparative Examples 1 to 4 were measured by using Keithley SMU 236 and a luminance meter PR650, and results thereof are shown in Table 1.

[Table1]

| | Dopant in emission layer | Driving voltage (V) | Current density (mA/$cm^2$) | Luminance (cd/$m^2$) | Efficiency (cd/A) | Emission color | Emission wavelength (nm) |
|---|---|---|---|---|---|---|---|
| Example 1 | BD1 | 4.3 | 5.3 | 1000 | 18.8 | blue | 469 |
| Example 2 | BD2 | 3.3 | 6.5 | 1000 | 16.5 | blue | 472 |
| Example 3 | BD3 | 3.3 | 4.8 | 1000 | 17.2 | blue | 480 |
| Example 4 | BD4 | 3.2 | 4.2 | 1000 | 23.7 | blue | 484 |
| Example 5 | BD5 | 3.1 | 4.8 | 1000 | 21.4 | blue | 472 |

(continued)

| | Dopant in emission layer | Driving voltage (V) | Current density (mA/cm$^2$) | Luminance (cd/m$^2$) | Efficiency (cd/A) | Emission color | Emission wavelength (nm) |
|---|---|---|---|---|---|---|---|
| Comparative Example 1 | A | 4.8 | 7.2 | 1000 | 9.2 | blue | 510 |
| Comparative Example 2 | B | 5.4 | 8.4 | 1000 | 12.1 | blue | 474 |
| Comparative Example 3 | C | 6.4 | 8.4 | 1000 | 10.2 | blue | 505 |
| Comparative Example 4 | D | 6.3 | 9.4 | 1000 | 14.5 | blue | 495 |

<Compound A>

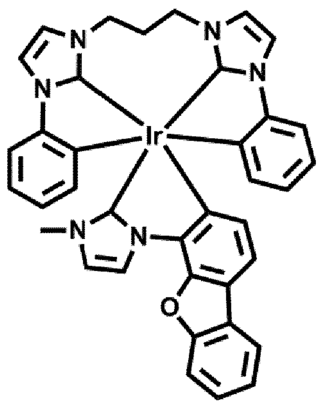

<Compound B>

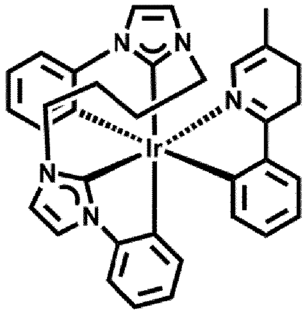

<Compound C>

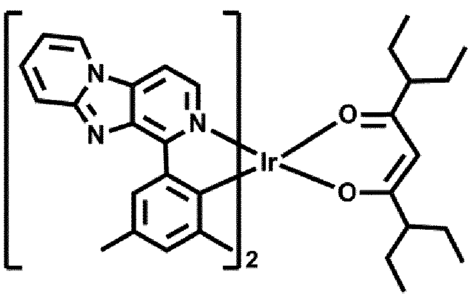

<Compound D>

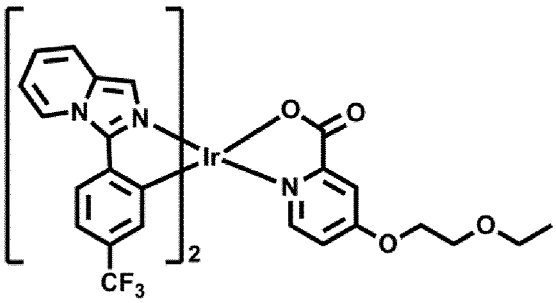

Referring to Table 1, it is confirmed that the organic light-emitting devices of Examples 1 to 5 have a low driving voltage, high luminance, high luminescence efficiency, and a long lifespan, as compared with those of the organic light-emitting devices of Comparative Examples 1 to 4.

The organic light-emitting device including the organometallic compound may have high efficiency and a long lifespan.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. An organometallic compound represented by Formula 1:

<Formula 1> $M(L_1)_{n1}(L_2)_{n2}$

<Formula 2-1>

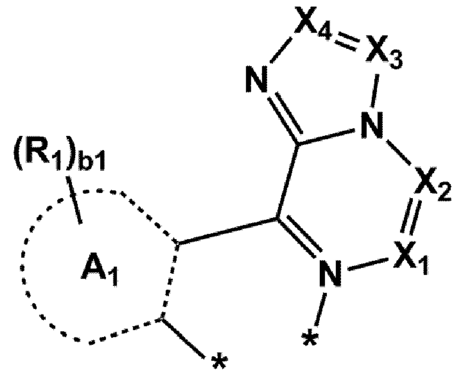

,

wherein, in Formula 1, M is selected from iridium (Ir), rhodium (Rh), cobalt (Co), and meitnerium (Mt),
$L_1$ is a ligand represented by Formula 2-1, and n1 is 1, 2, or 3, wherein, when n1 is 2 or more, two or more $L_1$(s) are identical to or different from each other,
$L_2$ is an organic ligand, and n2 is 0, 1, or 2, wherein, when n2 is 2, two $L_2$(s) are identical to or different from each other,
the sum of n1 and n2 is 2 or 3,
in Formula 2-1, ring $A_1$ is selected from a $C_5$-$C_{60}$ carbocyclic group and a $C_1$-$C_{60}$ heterocyclic group,
$X_1$ to $X_4$ are each independently $C(R_2)$ or N,
$R_1$ and $R_2$ are each independently selected from hydrogen, deuterium, -F, -Cl, - Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-N(Q_1)(Q_2)$, $-B(Q_1)(Q_2)$, $-P(Q_1)(Q_2)$, $-C(=O)(Q_1)$, $-S(=O)_2(Q_1)$, and $-P(=O)(Q_1)(Q_2)$,
b1 is an integer from 1 to 10,
at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group is selected from:

deuterium (-D), -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-Si(Q_{11})(Q_{12})(Q_{13})$, $-N(Q_{11})(Q_{12})$, $-B(Q_{11})(Q_{12})$, $-P(Q_{11})(Q_{12})$, - $C(=O)(Q_{11})$, $-S(=O)_2(Q_{11})$, and $-P(=O)(Q_{11})(Q_{12})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a C6-C60 arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a C6-C60 arylthio group, a $C_1$-$C_{60}$ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-Si(Q_{21})(Q_{22})(Q_{23})$, $-N(Q_{21})(Q_{22})$, $-B(Q_{21})(Q_{22})$, $-P(Q_{21})(Q_{22})$, - $C(=O)(Q_{21})$, $-S(=O)_2(Q_{21})$, and $-P(=O)(Q_{21})(Q_{22})$; and

$-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, - $S(=O)_2(Q_{31})$, and $-P(=O)(Q_{31})(Q_{32})$,

Q1 to $Q_3$, $Q_{11}$ to $Q_{13}$, $Q_{21}$ to $Q_{23}$, and $Q_{31}$ to $Q_{33}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, a $C_1$-$C_{60}$ alkyl group substituted with at least one selected from deuterium, -F, and a cyano group, a $C_6$-$C_{60}$ aryl group substituted with at least one selected from deuterium, -F, and a cyano group, a biphenyl group, and a terphenyl group, and

* indicates a binding site to M.

**2.** An organometallic compound according to claim 1, wherein, in Formula 1, n1 is 1, n2 is 1, and $L_2$ is a tetradentate ligand.

**3.** An organometallic compound according to claim 1 or claim 2, wherein ring $A_1$ in Formula 2-1 is selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a pyrrole group, an indole group, an indene group, a benzosilole group, a benzothiophene group, a benzofuran group, a carbazole group, a fluorene group, a dibenzosilole group, a dibenzothiophene group, a dibenzofuran group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, and a benzoquinazoline group; and/or
$X_1$ to $X_4$ in Formula 2-1 are each independently $C(R_2)$.

**4.** An organometallic compound according to any one of claims 1 to 3, wherein
$R_1$ and $R_2$ in Formula 2-1 are each independently selected from:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a C2-C20 alkenyl group, a $C_2$-$C_{20}$ alkynyl group, and a $C_1$-$C_{20}$ alkoxy group;

a $C_1$-$C_{20}$ alkyl group, a $C_2$-$C_{20}$ alkenyl group, a $C_2$-$C_{20}$ alkynyl group, and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazino group, a hydrazono group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a

naphthyl group, a pyridinyl group, a pyrimidinyl group, -Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), and - P(=O)($Q_{31}$)($Q_{32}$);

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazino group, a hydrazono group, a $C_1$-$C_{20}$ alkyl group, a $C_2$-$C_{20}$ alkenyl group, a $C_2$-$C_{20}$ alkynyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -Si($Q_{31}$)($Q_{32}$)($Q_{33}$), -N($Q_{31}$)($Q_{32}$), -B($Q_{31}$)($Q_{32}$), -C(=O)($Q_{31}$), - S(=O)$_2$($Q_{31}$), and -P(=O)($Q_{31}$)($Q_{32}$); and

-Si($Q_1$)($Q_2$)($Q_3$), -N($Q_1$)($Q_2$), -B($Q_1$)($Q_2$), -C(=O)($Q_1$), -S(=O)$_2$($Q_1$), -P($Q_1$)($Q_2$), and -P(=O)($Q_1$)($Q_2$), and

$Q_1$ to $Q_3$ and $Q_{31}$ to $Q_{33}$ are each independently selected from:

hydrogen, deuterium, -F, -Cl, -Br, -I, a cyano group, a $C_1$-$C_{20}$ alkyl group, a $C_2$-$C_{20}$ alkenyl group, a $C_2$-$C_{20}$ alkynyl group, a $C_1$-$C_{20}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{20}$ aryl group, a $C_1$-$C_{20}$ heteroaryl group, a monovalent non-aromatic condensed polycyclic group, and a monovalent non-aromatic condensed heteropolycyclic group;

a $C_1$-$C_{20}$ alkyl group substituted with at least one selected from deuterium, -F, and a cyano group;

a $C_6$-$C_{20}$ aryl group substituted with at least one selected from deuterium, -F, and a cyano group; and

a biphenyl group and a terphenyl group.

**5.** An organometallic compound according to any one of claims 1 to 4, wherein,

i) in Formula 2-1, $X_1$ and $X_2$ are each independently C($R_2$), and $R_2$ is hydrogen; or

ii) in Formula 2-1, $X_3$ and $X_4$ are each independently C($R_2$), and $R_2$ is a methyl group, a t-butyl group, or an isopropyl group.

**6.** An organometallic compound according to any one of claims 1 to 5, wherein

L1 is a ligand selected from groups represented by Formulae 2-1(1) and 2-1(2):

<Formula 2-1(1)>

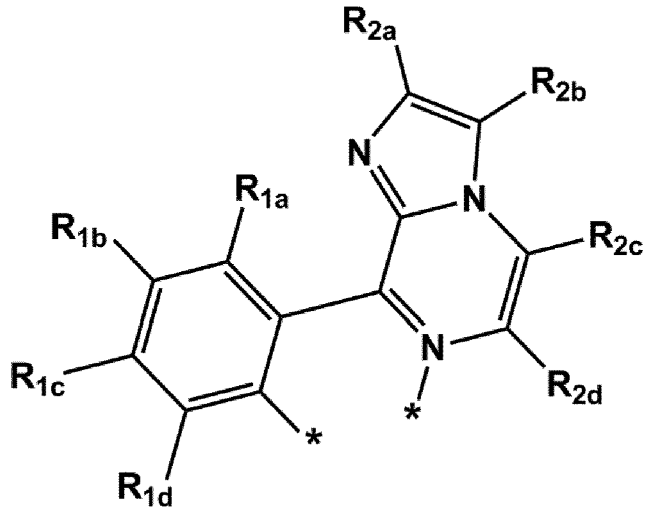

<Formula 2-1(2)>

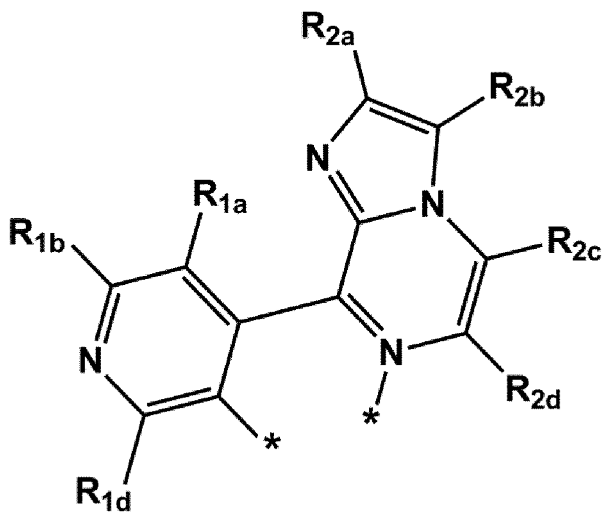

,

wherein, in Formulae 2-1 (1) and 2-1(2),
$R_{1a}$ to $R_{1d}$ and $R_{2a}$ to $R_{2d}$ are each independently the same as defined in connection with $R_1$ and $R_2$ in claim 1, and
* indicates a binding site to M.

**7.** An organometallic compound according to any one of claims 1 to 6, wherein

$L_2$ is a ligand represented by Formula 2-2 or 2-3:

<Formula 2-2>

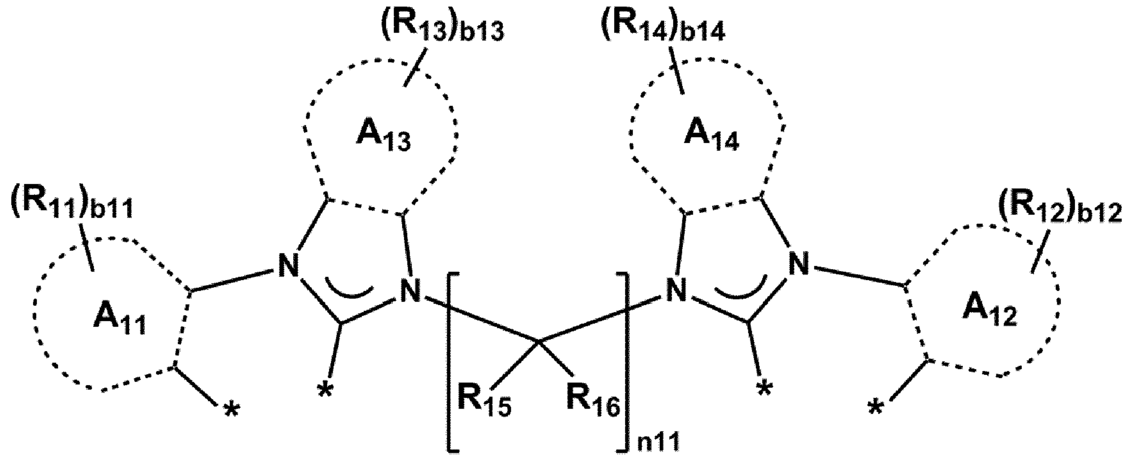

<Formula 2-3>

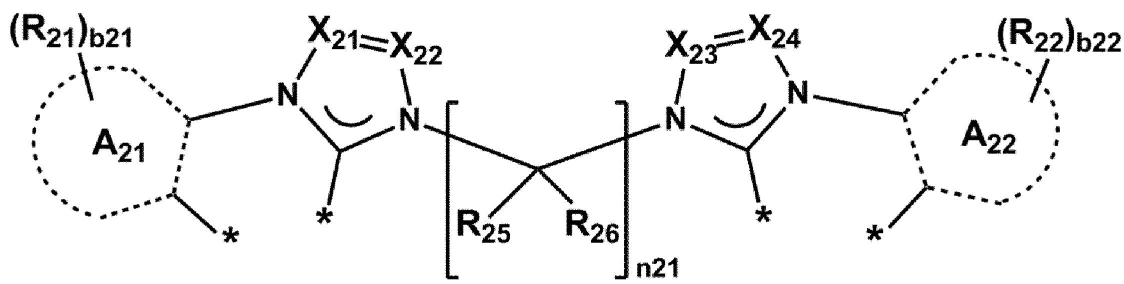

,wherein, in Formulae 2-2 and 2-3,
$X_{21}$ and $X_{22}$ are each independently $C(R_{23})$ or N,
$X_{23}$ and $X_{24}$ are each independently $C(R_{24})$ or N,
ring $A_{11}$ to ring $A_{14}$, ring $A_{21}$, ring $A_{22}$, $R_{11}$ to $R_{16}$, $R_{21}$ to $R_{26}$, b11 to b14, b21, b22, and * are each independently the same as defined in connection with $A_1$, $R_1$, b1, and * in claim 1, and
n11 and n21 are each independently an integer from 2 to 6.

**8.** An organometallic compound according to claim 7, wherein

ring $A_{11}$ to ring $A_{14}$, ring $A_{21}$, and ring $A_{22}$ in Formulae 2-2 and 2-3 are each independently selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a pyrrole group, an indole group, an indene group, a benzosilole group, a benzothiophene group, a benzofuran group, a carbazole group, a fluorene group, a dibenzosilole group, a dibenzothiophene group, a dibenzofuran group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, and a benzoquinazoline group; and/or
$X_{21}$ and $X_{22}$ in Formula 2-3 are each independently $C(R_{23})$, and $X_{23}$ and $X_{24}$ in Formula 2-3 are each independently $C(R_{24})$.

**9.** An organometallic compound according to claim 7 or claim 8, wherein $R_{11}$ to $R_{16}$ and $R_{21}$ to $R_{26}$ in Formulae 2-2 and 2-3 are each independently selected from:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a C2-C20 alkenyl group, a $C_2$-$C_{20}$ alkynyl group, and a $C_1$-$C_{20}$ alkoxy group;

a $C_1$-$C_{20}$ alkyl group, a $C_2$-$C_{20}$ alkenyl group, a $C_2$-$C_{20}$ alkynyl group, and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazino group, a hydrazono group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and - $P(=O)(Q_{31})(Q_{32})$;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazino group, a hydrazono group, a $C_1$-$C_{20}$ alkyl group, a $C_2$-$C_{20}$ alkenyl group, a $C_2$-$C_{20}$ alkynyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, an acridinyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, $-Si(Q_{31})(Q_{32})(Q_{33})$, $-N(Q_{31})(Q_{32})$, $-B(Q_{31})(Q_{32})$, $-C(=O)(Q_{31})$, - $S(=O)_2(Q_{31})$, and $-P(=O)(Q_{31})(Q_{32})$; and

$-Si(Q_1)(Q_2)(Q_3)$, $-N(Q_1)(Q_2)$, $-B(Q_1)(Q_2)$, $-C(=O)(Q_1)$, $-S(=O)_2(Q_1)$, $-P(Q_1)(Q_2)$, and $-P(=O)(Q_1)(Q_2)$,and

$Q_1$ to $Q_3$ and $Q_{31}$ to $Q_{33}$ are each independently selected from:

hydrogen, deuterium, -F, -Cl, -Br, -I, a cyano group, a $C_1$-$C_{20}$ alkyl group, a $C_2$-$C_{20}$ alkenyl group, a $C_2$-$C_{20}$ alkynyl group, a $C_1$-$C_{20}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{20}$ aryl group, a $C_1$-$C_{20}$ heteroaryl group, a monovalent non-aromatic condensed polycyclic group, and a monovalent non-aromatic condensed heteropolycyclic group;

a $C_1$-$C_{20}$ alkyl group substituted with at least one selected from deuterium, -F, and a cyano group;

a $C_6$-$C_{20}$ aryl group substituted with at least one selected from deuterium, -F, and a cyano group; and a biphenyl group and a terphenyl group.

**10.** An organometallic compound according to any one of claims 7 to 9, wherein

$L_2$ is a ligand selected from groups represented by Formulae 2-2(1) to 2-2(3) and 2-3(1):

<Formula 2-2(1)>

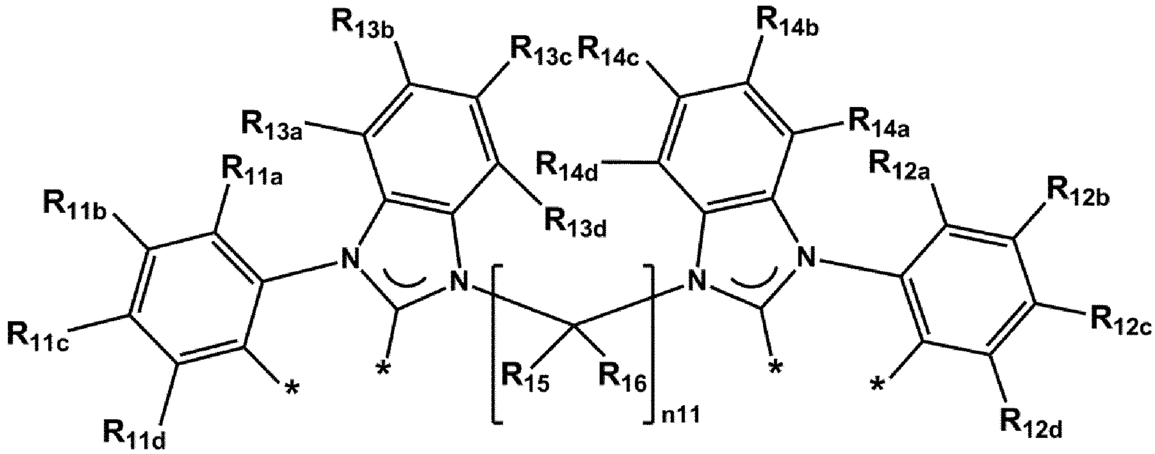

<Formula 2-2(2)>

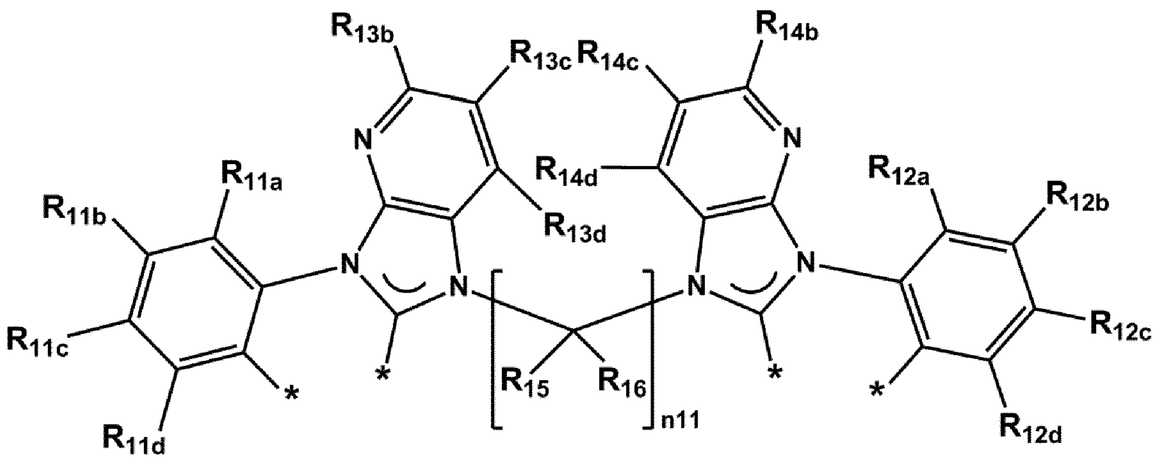

<Formula 2-2(3)>

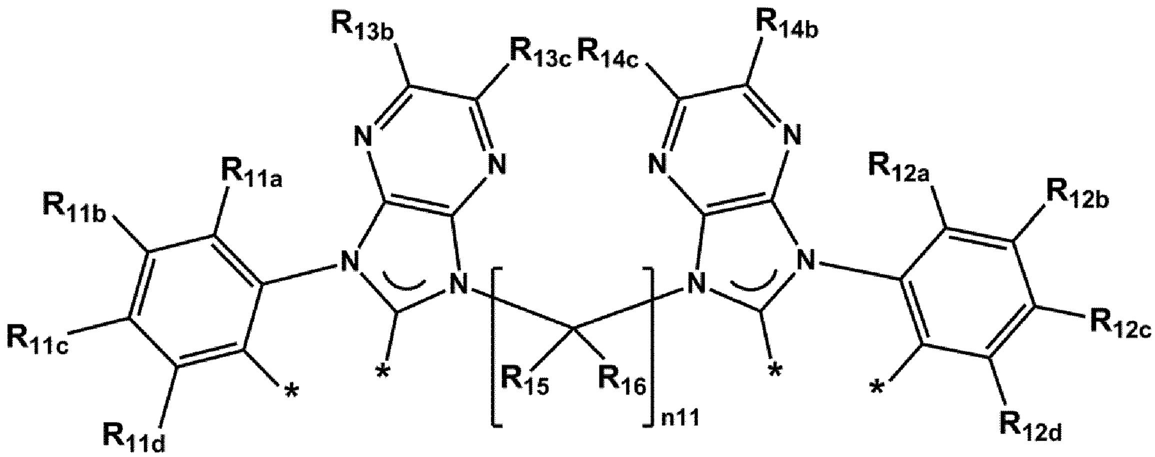

<Formula 2-3(1)>

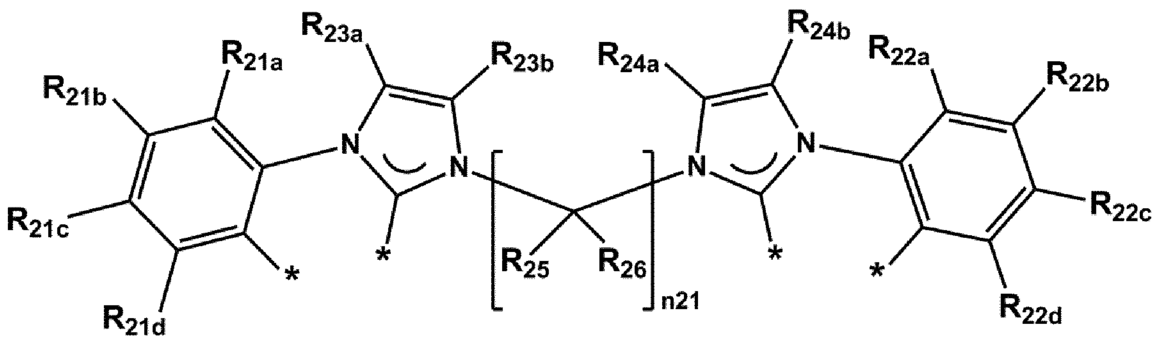

, wherein, in Formulae 2-2(1) to 2-2(3) and 2-3(1),

$R_{11a}$ to $R_{11d}$, $R_{12a}$ to $R_{12d}$, $R_{13a}$ to $R_{13d}$, $R_{14a}$ to $R_{14d}$, $R_{21a}$ to $R_{21d}$, $R_{22a}$ to $R_{22d}$, $R_{23a}$, $R_{23b}$, $R_{24a}$, R24b, n11, and n21 are each independently the same as defined in connection with $R_{11}$ to $R_{16}$, $R_{21}$ to $R_{26}$, n11, and n21 in claim 8, and

* indicates a binding site to M.

**11.** An organometallic compound according to claim 1, wherein the organometallic compound is selected from Compounds BD1 to BD59:

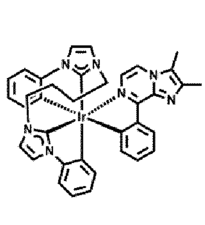
BD1

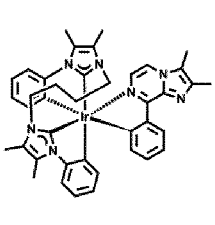
BD2

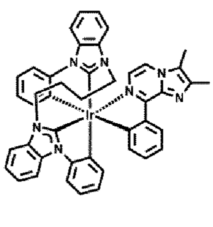
BD3

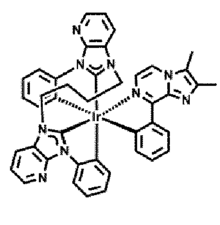
BD4

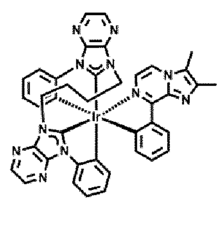
BD5

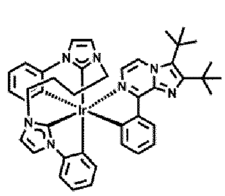
BD6
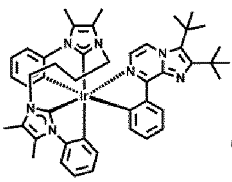
BD7
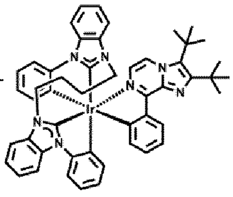
BD8
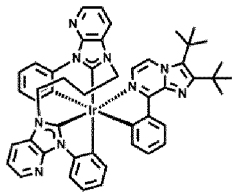
BD9
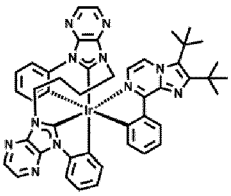
BD10

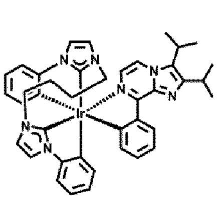
BD11
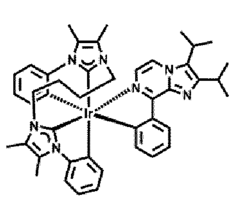
BD12
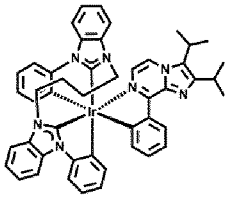
BD13
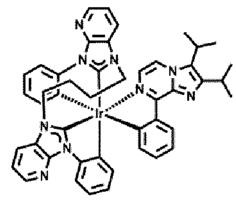
BD14
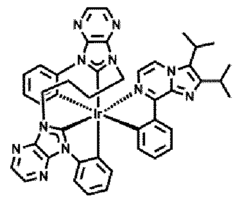
BD15

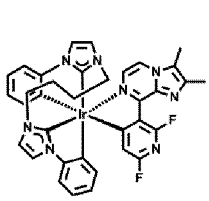
BD16
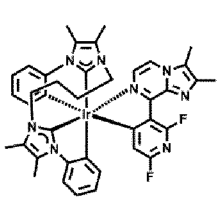
BD17
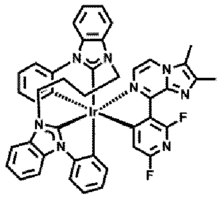
BD18
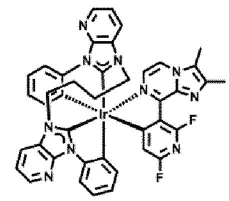
BD19
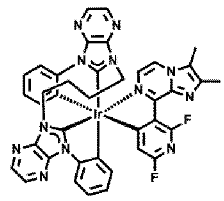
BD20

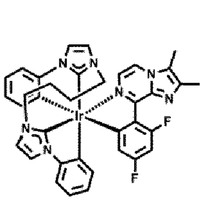
BD21
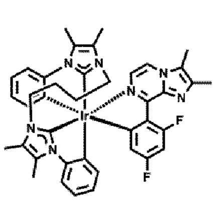
BD22
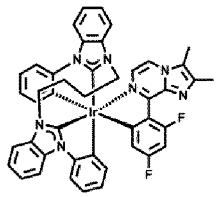
BD23
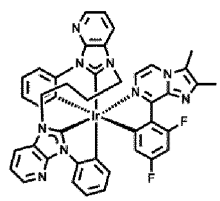
BD24
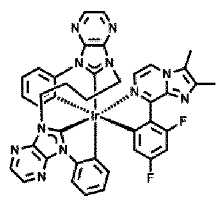
BD25

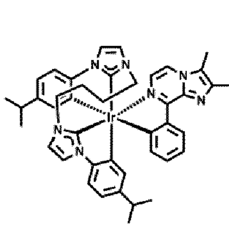
BD26
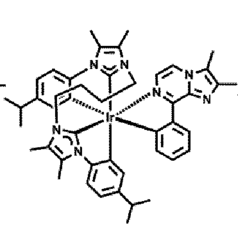
BD27
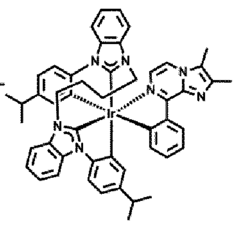
BD28
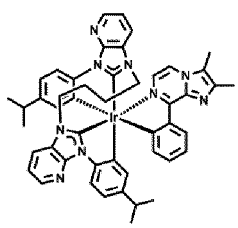
BD29
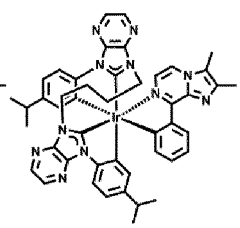
BD30

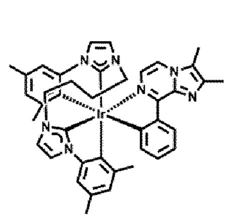
BD31

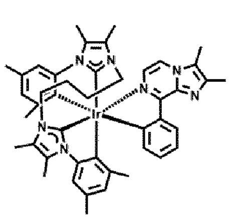
BD32

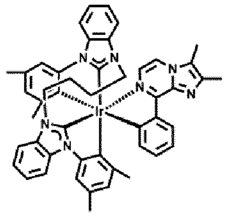
BD33

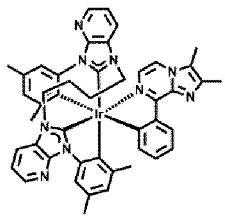
BD34

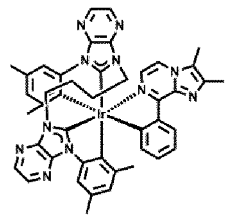
BD35

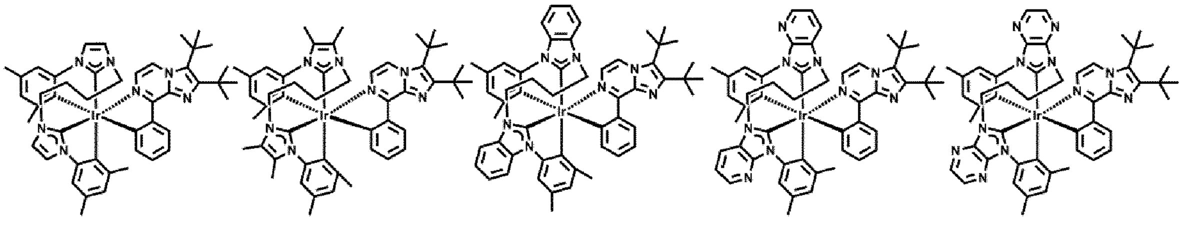
BD36 BD37 BD38 BD39 BD40

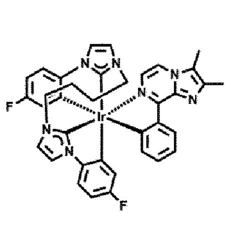
BD41

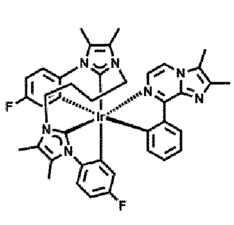
BD42

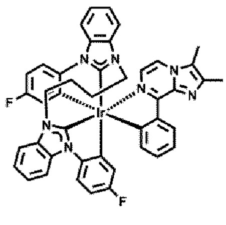
BD43

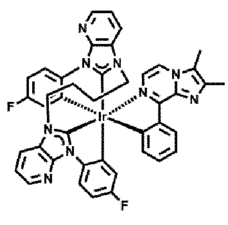
BD44

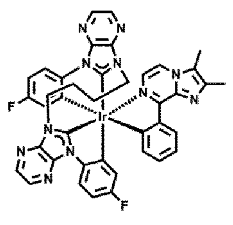
BD45

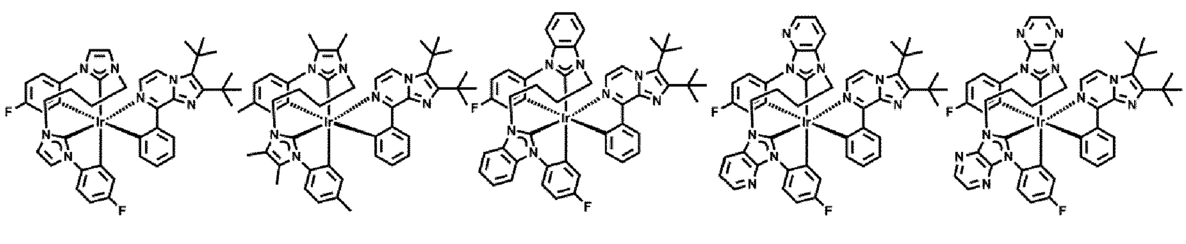
BD46 BD47 BD48 BD49 BD50

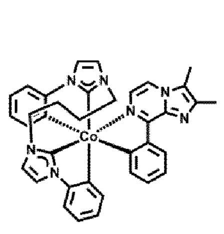
BD51

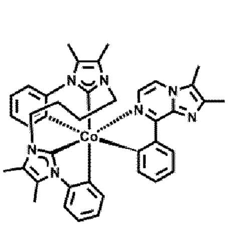
BD52

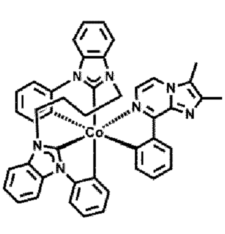
BD53

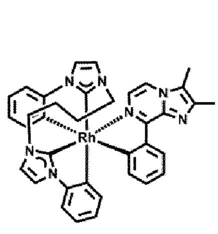
BD54

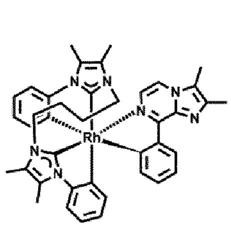
BD55

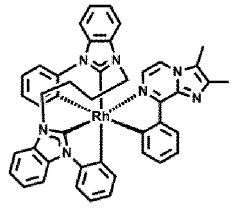
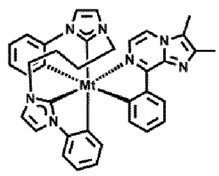
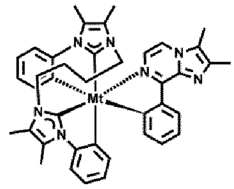
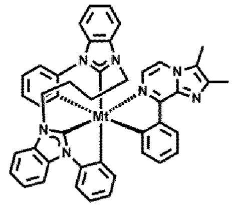

BD56 BD57 BD58 BD59

**12.** An organic light-emitting device comprising:

a first electrode;
a second electrode facing the first electrode; and
an organic layer between the first electrode and the second electrode and comprising an emission layer,
wherein the emission layer comprises at least one of the organometallic compound according to any one of claims 1 to 11,
the emission layer further comprises at least one selected from a second compound and a third compound,
the organometallic compound, the second compound, and the third compound are different from each other,
when the emission layer comprises both the second compound and the third compound, the second compound and the third compound form an exciplex, and
the organometallic compound and the second compound and/or the third compound do not form an exciplex, optionally wherein
the second compound and the third compound form an exciplex, and a wavelength ($\lambda_{max}$) of maximum emission in a photoluminescence (PL) spectrum of the exciplex is about 390 nm or more and about 500 nm or less, optionally wherein
a difference in absolute value between a lowest unoccupied molecular orbital (LUMO) energy level of the organometallic compound and a LUMO energy level of the second compound or the third compound is in a range of about 0.1 eV to about 10 eV, optionally wherein
a difference in absolute value between a highest occupied molecular orbital (HOMO) energy level of the organometallic compound and a HOMO energy level of the second compound or the third compound is about 1.25 eV or less.

**13.** An organic light-emitting device according to claim 12, wherein

the second compound is represented by Formula 3, and
the third compound is represented by Formula 4:

<Formula 3>

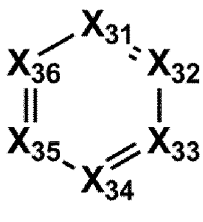

<Formula 4>

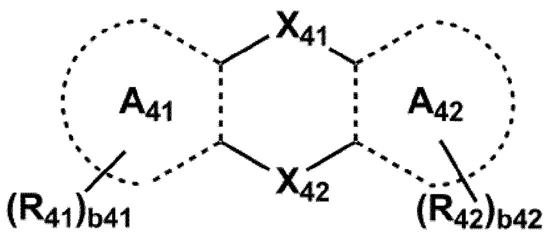
,

wherein, in Formulae 3 and 4,

$X_{31}$ is selected from $C(R_{31})$ and N, $X_{32}$ is selected from $C(R_{32})$ and N, $X_{33}$ is selected from $C(R_{33})$ and N, $X_{34}$ is selected from $C(R_{34})$ and N, $X_{35}$ is selected from $C(R_{35})$ and N, and $X_{36}$ is selected from $C(R_{36})$ and N, wherein at least one selected from $X_{31}$ to $X_{36}$ is N,

$R_{31}$ to $R_{36}$ are each independently selected from a group represented by $*-(L_{31})_{a31}-(R_{37})_{b37}$, hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$,and $-P(=S)(Q_1)(Q_2)$, wherein at least one selected from $R_{31}$ to $R_{36}$ is a group represented by $*-(L_{31})_{a31}-(R_{37})_{b37}$,

$L_{31}$ is selected from a substituted or unsubstituted $C_5$-$C_{60}$ carbocyclic group and a substituted or unsubstituted $C_1$-$C_{60}$ heterocyclic group,

a31 is an integer from 0 to 6,

$R_{37}$ is selected from a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, and $-P(=S)(Q_1)(Q_2)$,

b37 is an integer from 1 to 10,

$A_{41}$ and $A_{42}$ are each independently selected from a $C_5$-$C_{60}$ carbocyclic group and a $C_1$-$C_{60}$ heterocyclic group,

$X_{41}$ is selected from a single bond, O, S, $B(R_{43})$, $N(R_{43})$, $C(R_{43})(R_{44})$, and Si(R43)(R44), and $X_{42}$ is selected from a single bond, O, S, $B(R_{45})$, $N(R_{45})$, $C(R_{45})(R_{46})$, and Si(R45)(R46), wherein $X_{41}$ and $X_{42}$ are not a single bond at the same time,

$R_{41}$ to $R_{46}$ are each independently selected from a group represented by $*-(L_{41})_{a41}-(R_{47})_{b47}$, hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$,and $-P(=S)(Q_1)(Q_2)$, wherein at least one selected from $R_{41}$ to $R_{46}$ is a group represented by $*-(L_{41})_{a41}-(R_{47})_{b47}$,

$L_{41}$ is selected from a substituted or unsubstituted $C_5$-$C_{60}$ carbocyclic group and a substituted or unsubstituted $C_1$-$C_{60}$ heterocyclic group,

a41 is an integer from 0 to 6,

$R_{47}$ is selected from a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$

heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, and $-P(=S)(Q_1)(Q_2)$,
b47 is an integer from 1 to 10,
$Q_1$ to $Q_3$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a biphenyl group, and a terphenyl group, and
* indicates a binding site to a neighboring atom.

**14.** A organic light-emitting device according to claim 13, wherein
the second compound is selected from Compounds ETH1 to ETH80, and the third compound is selected from Compounds HTH1 to HTH28:

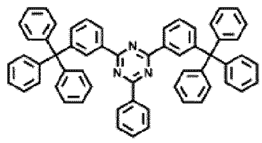
ETH1

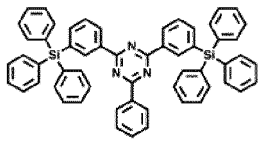
ETH2

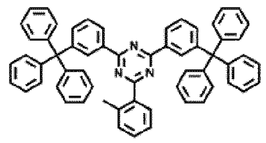
ETH3

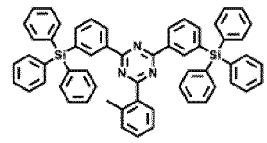
ETH4

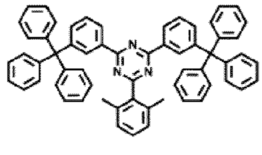
ETH5

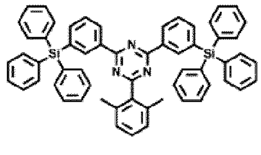
ETH6

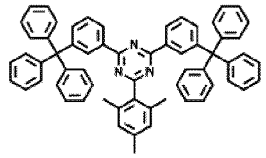
ETH7

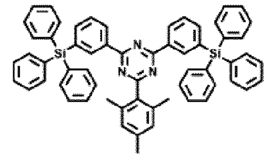
ETH8

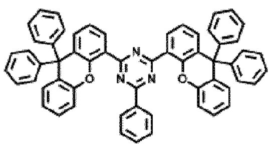
ETH9

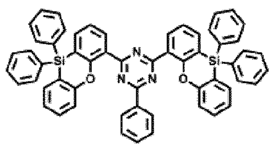
ETH10

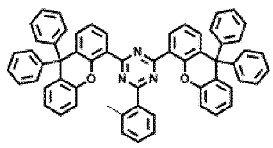
ETH11

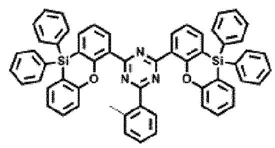
ETH12

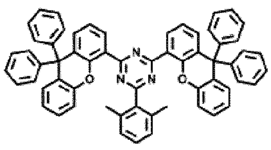
ETH13

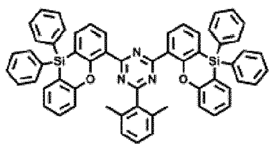
ETH14

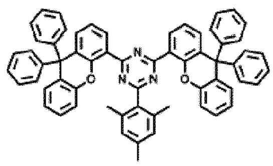
ETH15

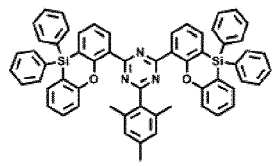
ETH16

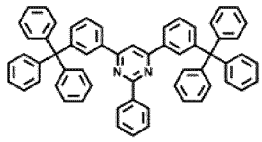
ETH17

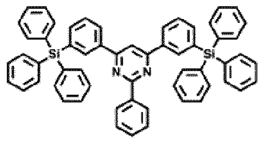
ETH18

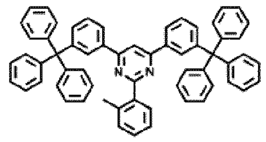
ETH19

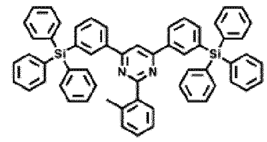
ETH20

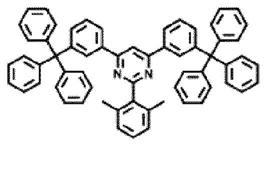
ETH21

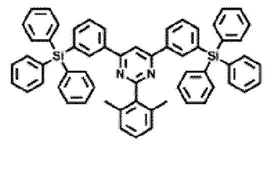
ETH22

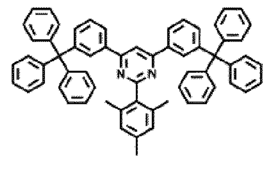
ETH23

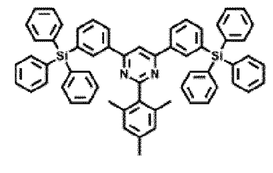
ETH24

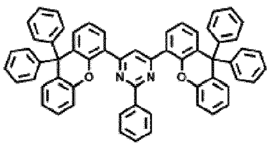
ETH25

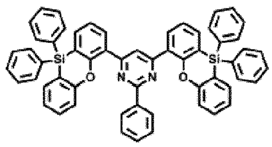
ETH26

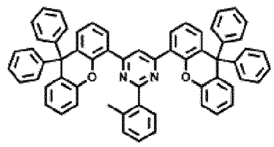
ETH27

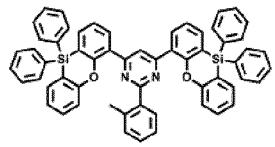
ETH28

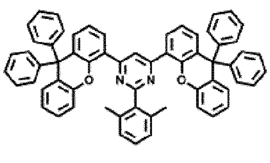
ETH29

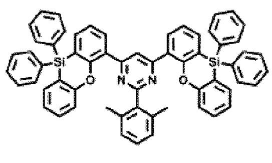
ETH30

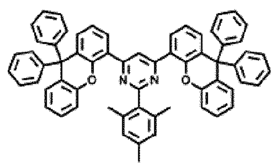
ETH31

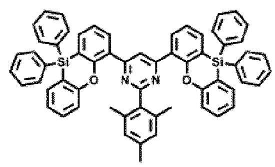
ETH32

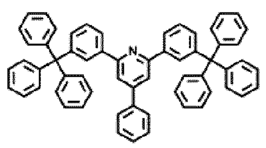
ETH33

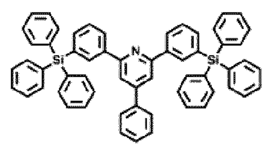
ETH34

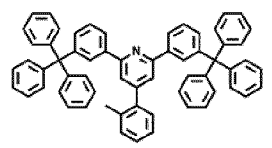
ETH35

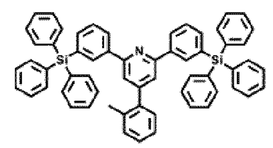
ETH36

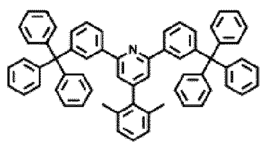
ETH37

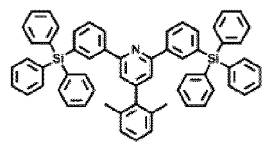
ETH38

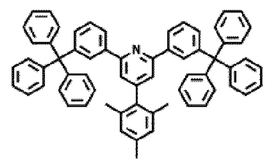
ETH39

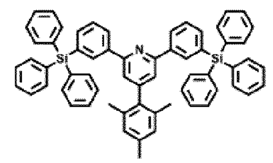
ETH40

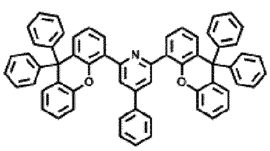
ETH41

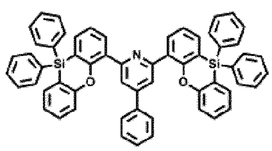
ETH42

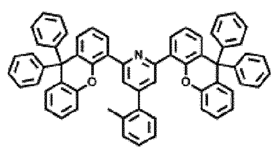
ETH43

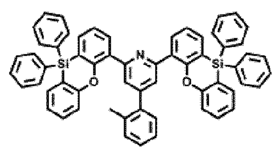
ETH44

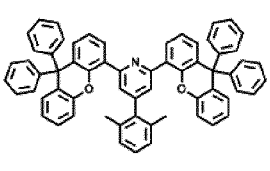
ETH45

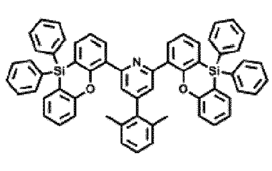
ETH46

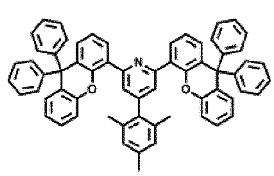
ETH47

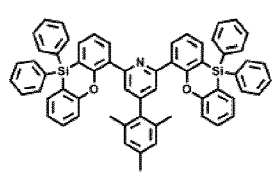
ETH48

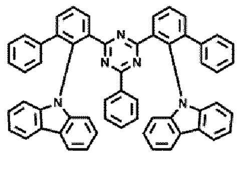
ETH49

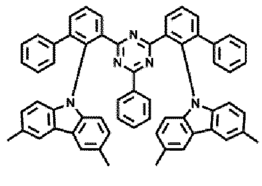
ETH50

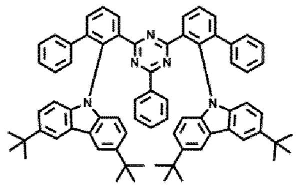
ETH51

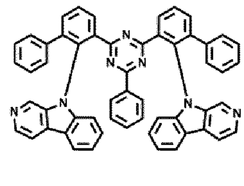
ETH52

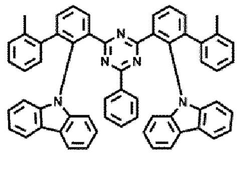
ETH53

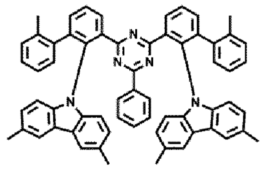
ETH54

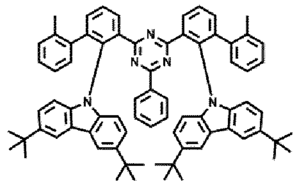
ETH55

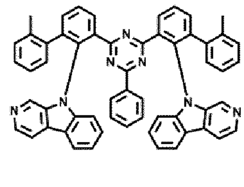
ETH56

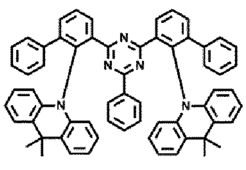
ETH57

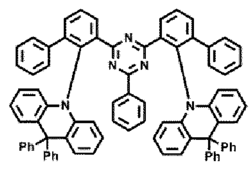
ETH58

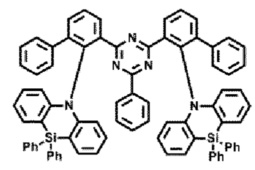
ETH59

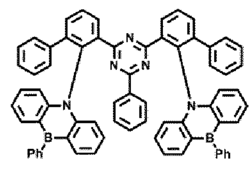
ETH60

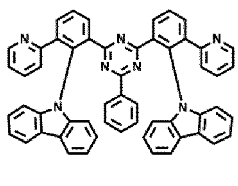
ETH61

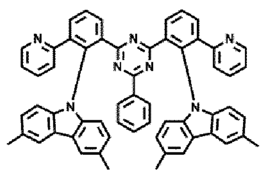
ETH62

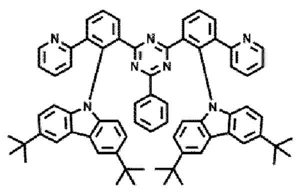
ETH63

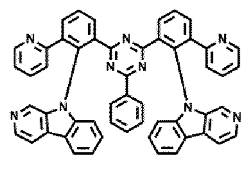
ETH64

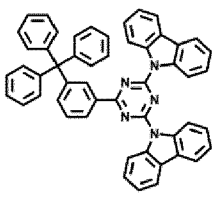
ETH65

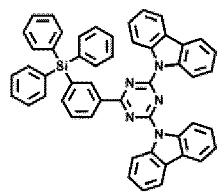
ETH66

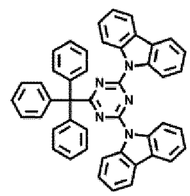
ETH67

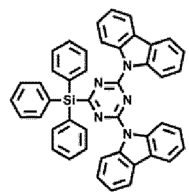
ETH68

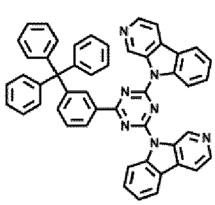
ETH69

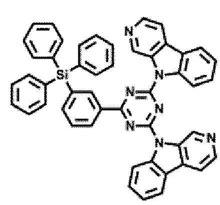
ETH70

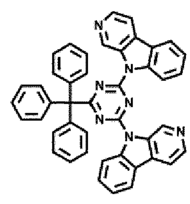
ETH71

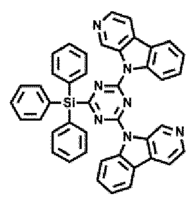
ETH72

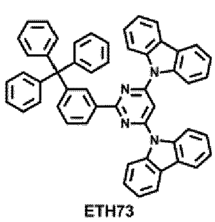
ETH73

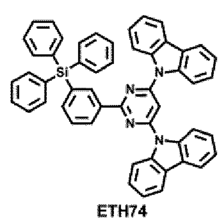
ETH74

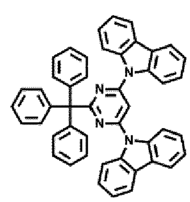
ETH75

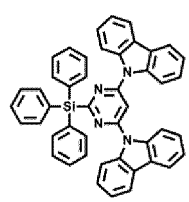
ETH76

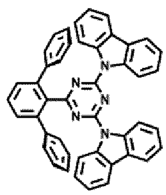
ETH77

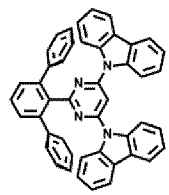
ETH78

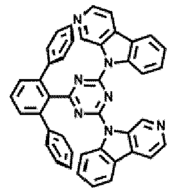
ETH79

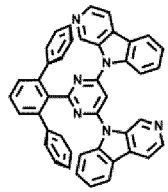
ETH80

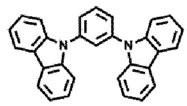
HTH1

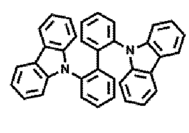
HTH2

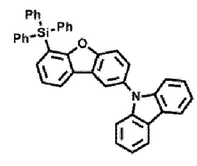
HTH3

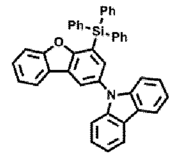
HTH4

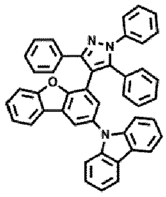
HTH5

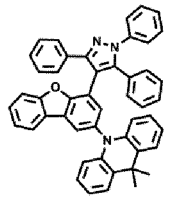
HTH6

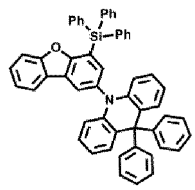
HTH7

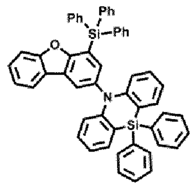
HTH8

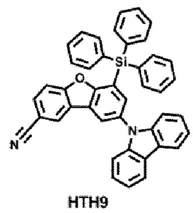
HTH9

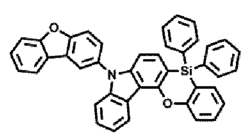
HTH10

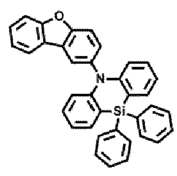
HTH11

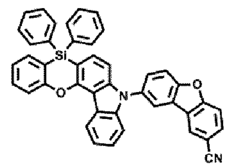
HTH12

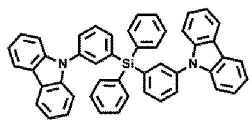
HTH13

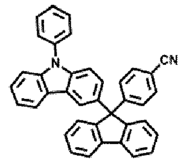
HTH14

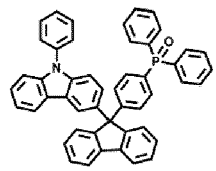
HTH15

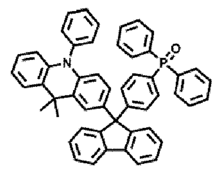
HTH16

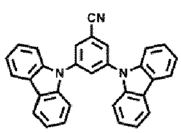
HTH17

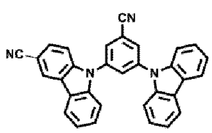
HTH18

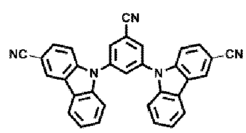
HTH19

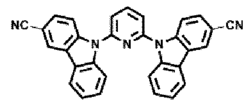
HTH20

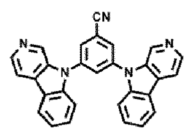
HTH21

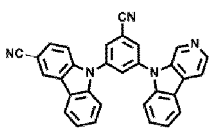
HTH22

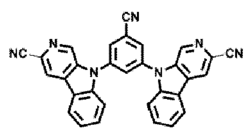
HTH23

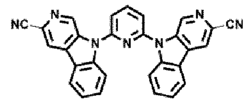
HTH24

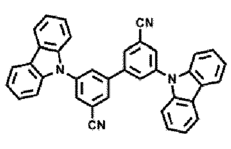

HTH25

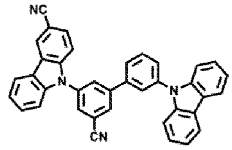

HTH26

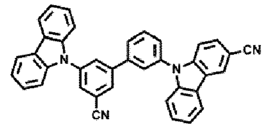

HTH27

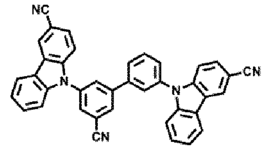

HTH28

**15.** An organic light-emitting device according to any one of claims 12 to 14, wherein a decay time of delayed fluorescence in a time-resolved electroluminescence (TREL) spectrum of the organic light-emitting device is about 50 ns or more.

**Patentansprüche**

**1.** Organometallische Verbindung, die durch Formel 1 dargestellt ist: < Formel 1>

$M(L_1)_{n1}(L_2)_{n2}$

<Formel 2-1>

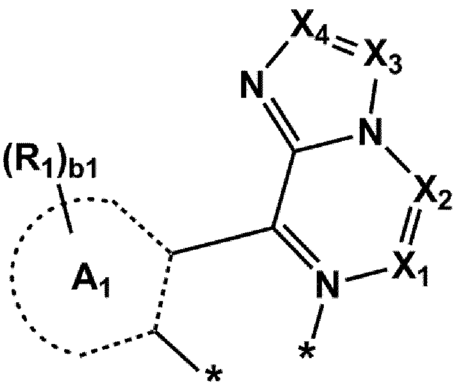

wobei in Formel 1 M aus Iridium (Ir), Rhodium (Rh), Kobalt (Co) und Meitnerium (Mt) ausgewählt ist,
$L_1$ ein Ligand ist, der durch Formel 2-1 dargestellt ist und n1 1, 2 oder 3 ist, wobei, wenn n1 2 oder mehr ist, zwei oder mehr $L_1$ identisch sind oder sich voneinander unterscheiden,
$L_2$ ein organischer Ligand ist und n2 0, 1 oder 2 ist, wobei, wenn n2 2 ist, zwei $L_2$ identisch sind oder sich voneinander unterscheiden,
die Summe von n1 und n2 2 oder 3 ist,
in Formel 2-1 Ring $A_1$ aus einer carbocyclischen $C_5$-$C_{60}$-Gruppe und einer heterocyclischen $C_1$-$C_{60}$-Gruppe ausgewählt ist,
$X_1$ bis $X_4$ jeweils unabhängig $C(R_2)$ oder N sind,
$R_1$ und $R_2$ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder nicht substituierten $C_1$-$C_{60}$-Alkylgruppe, einer substituierten oder nicht substituiertennicht substituierten $C_2$-$C_{60}$-Alkenylgtuppe, einer substituierten oder nicht substituiertennicht substituierten $C_2$-$C_{60}$-Alkynylgtuppe, einer substituierten oder nicht substituierten $C_1$-$C_{60}$-Alkoxygruppe, einer substituierten oder nicht substituierten $C_3$-$C_{10}$-Cycloalkylgruppe, einer substituierten oder nicht substituierten $C_1$-$C_{10}$-Heterocycloalkylgruppe, einer substituierten oder nicht substituierten $C_3$-$C_{10}$-Cycloalkenylgruppe, einer substituierten oder nicht substituierten $C_1$-$C_{10}$-Heterocycloalkenylgruppe, einer substituierten oder nicht substituierten $C_6$-$C_{60}$-Arylgruppe, einer substituierten oder nicht substituierten $C_6$-$C_{60}$-Aryloxygruppe, einer substituierten oder nicht substituierten $C_6$-$C_{60}$-Arylthiogruppe, einer substituierten oder nicht substituierten $C_1$-$C_{60}$-Heteroarylgruppe, einer substituierten oder nicht substituierten monovalenten nicht aromatischen kondensierten polycyclischen Gruppe, einer substituierten oder nicht substituierten monovalentenmonovalenten nicht aromatischen kondensierten heteropolycyclischen Gruppe, $-Si(Q_1)(Q_2)(Q_3)$, $-N(Q_1)(Q_2)$, $-B(Q_1)(Q_2)$, $-P(Q_1)(Q_2)$, $-C(=O)(Q_1)$, $-S(=O)_2(Q_1)$ und $-P(=O)(Q_1)(Q_2)$ ausgewählt sind,

b1 eine ganze Zahl von 1 bis 10 ist,
mindestens ein Substituent der substituierten $C_1$-$C_{60}$-Alkylgruppe, der substituierten $C_2$-$C_{60}$-Alkenygruppe, der substituierten $C_2$-$C_{60}$-Alkynylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten monovalenten nicht aromatischen kondensierten polycyclischen Gruppe und der substituierten monovalenten nicht aromatischen kondensierten heteropolycyclischen Gruppe ausgewählt ist aus:

Deuterium (-D), -F, -Cl, -Br, -I, einer Hydroxylgruppe, einer Cyanogruppe, einer Nitrogruppe, einer Amidinogruppe, einer Hydrazinogruppe, einer Hydrazonogruppe, einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe;
einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe, die jeweils mit mindestens einem substituiert ist, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycyclischen Gruppe, einer monovalenten nicht aromatischen kondensierten heteropolycyclischen Gruppe, $-Si(Q_{11})(Q_{12})(Q_{13})$, $-N(Q_{11})(Q_{12})$, $-B(Q_{11})(Q_{12})$, $-P(Q_{11})(Q_{12})$, $-C(=O)(Q_{11})$, $- S(=O)_2(Q_{11})$ und $-P(=O)(Q_{11})(Q_{12})$;
einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycyclischen Gruppe und einer monovalenten nicht aromatischen kondensierten heteropolycyclischen Gruppe;
einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycyclischen Gruppe und einer monovalenten nicht aromatischen kondensierten heteropolycyclischen Gruppe, die jeweils mit mindestens einem substituiert sind, ausgewählt aus Deuterium, - F, -Cl, -Br, -I, einer Hydroxylgruppe, einer Cyanogruppe, einer Nitrogruppe, einer Amidinogruppe, einer Hydrazinogruppe, einer Hydrazonogruppe, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer monovalenten nicht aromatischen kondensierten polycyclischen Gruppe, einer monovalenten nicht aromatischen kondensierten heteropolycyclischen Gruppe, $Si(Q_{21})(Q_{22})(Q_{23})$, $-N(Q_{21})(Q_{22})$, $-B(Q_{21})(Q_{22})$, $-P(Q_{21})(Q_{22})$, $-C(=O)(Q_{21})$, $- S(=O)_2(Q_{21})$ und $-P(=O)(Q_{21})(Q_{22})$; und
$-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $- S(=O)_2(Q_{31})$ und $-P(=O)(Q_{31})(Q_{32})$,
$Q_1$ bis $Q_3$, $Q_{11}$ bis $Q_{13}$, $Q_{21}$ bis $Q_{23}$ und $Q_{31}$ bis $Q_{33}$ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_1$-$C_{60}$-Heteroarylgruppe, einer monovalenten nicht aromatischen kondensierten polycyclischen Gruppe, einer monovalenten nicht aromatischen kondensierten heteropolycyclischen Gruppe, einer $C_1$-$C_{60}$-Alkylgtuppe, die mit mindestens einem substituiert ist, ausgewählt aus Deuterium, -F und einer Cyanogruppe, einer $C_6$-$C_{60}$-Arylgruppe, die mit mindestens einem substituiert ist, ausgewählt aus Deuterium, -F und einer Cyanogruppe, einer Biphenylgruppe und einer Terphenylgruppe, und
* eine Bindungsstelle an M angibt.

**2.** Organometallische Verbindung nach Anspruch 1, wobei
in Formel 1 n1 1 ist, n2 1 ist und $L_2$ ein vierzähniger Ligand ist.

**3.** Organometallische Verbindung nach Anspruch 1 oder Anspruch 2, wobei

Ring $A_1$ in Formel 2-1 aus einer Benzolgruppe, einer Naphthalengruppe, einer Anthracengruppe, einer Phenanthrengruppe, einer Triphenylengruppe, einer Pyrengruppe, einer Chrysengruppe, einer Cyclopentadiengruppe, einer 1,2,3,4-Tetrahydronaphthalengruppe, einer Thiophengruppe, einer Furangruppe, einer Pyrrolgruppe, einer Indolgruppe, einer Indengruppe, einer Benzosilolgruppe, einer Benzothiophengruppe, einer Benzofurangruppe, einer Carbazolgruppe, einer Fluorengruppe, einer Dibenzosilolgruppe, einer Dibenzothiophengruppe, einer Dibenzofurangruppe, einer Pyridingruppe, einer Pyrimidingruppe, einer Pyrazingruppe, einer Pyridazingruppe, einer Triazingruppe, einer Chinolingruppe, einer Isochinolingruppe, einer Chinoxalingruppe, einer Chinazolingruppe, einer Phenanthrolingruppe, einer Pyrazolgruppe, einer Imidazolgruppe, einer Triazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer Benzoxazolgruppe, einer Benzothioazolgruppe, einer Benzodiazolgruppe, einer Benzoxadiazolgruppe, einer Benzothiadiazolgruppe, einer 5,6,7,8-Tetrahydroisochinolingruppe, einer 5,6,7,8-Tetrahydrochinolingruppe und einer Benzochinazolingruppe ausgewählt ist; und/oder
$X_1$ bis $X_4$ in Formel 2-1 jeweils unabhängig $C(R_2)$ sind.

**4.** Organometallische Verbindung nach einem der Ansprüche 1 bis 3, wobei:
$R_1$ und $R_2$ in Formel 2-1 jeweils unabhängig ausgewählt sind aus:

Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer $C_1$-$C_{20}$-Alkylgruppe, einer $C_2$-$C_{20}$-Alkenylgruppe, einer $C_2$-$C_{20}$-Alkynylgruppe und einer $C_1$-$C_{20}$-Alkoxygruppe;
einer $C_1$-$C_{20}$-Alkylgruppe, einer $C_2$-$C_{20}$-Alkenylgruppe, einer $C_2$-$C_{20}$-Alkynylgruppe und einer $C_1$-$C_{20}$-Alkoxygruppe, die jeweils mit mindestens einem substituiert sind, ausgewählt aus -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazinogruppe, einer Hydrazonogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$ und $-P(=O)(Q_{31})(Q_{32})$;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzoquinolinylgruppe, einer Chinoxalinylgruppe, einer Chinazolinylgruppe, einer Cinnolinylgruppe, einer Carbazolylgruppe, einer Acridinylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzoquinolinylgruppe, einer Chinoxalinylgruppe, einer Chinazolinylgruppe, einer Cinnolinylgruppe, einer Carbazolylgruppe, einer Acridinylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe

und einer Imidazopyrimidinylgruppe; die jeweils mit mindestens einem substituiert sind, ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazinogruppe, einer Hydrazonogruppe, einer $C_1$-$C_{20}$-Alkylgruppe, einer $C_2$-$C_{20}$-Alkenylgruppe, einer $C_2$-$C_{20}$-Alkynylgruppe, einer $C_1$-$C_{20}$-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzoquinolinylgruppe, einer Chinoxalinylgruppe, einer Chinazolinylgruppe, einer Cinnolinylgruppe, einer Carbazolylgruppe, einer Acridinylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe, einer Imidazopyrimidinylgruppe, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$ und $-P(=O)(Q_{31})(Q_{32})$; und
$-Si(Q_1)(Q_2)(Q_3)$· $-N(Q_1)(Q_2)$· $-B(Q_1)(Q_2)$, $-C(=O)(Q_1)$, $-S(=O)_2(Q_1)$, $-P(Q_1)(Q_2)$ und $-P(=O)(Q_1)(Q_2)$, und
$Q_1$ bis $Q_3$ und $Q_{31}$ bis $Q_{33}$ jeweils unabhängig ausgewählt sind aus:

Wasserstoff, Deuterium, -F, -Cl, -Br, -I, einer Cyanogruppe, einer $C_1$-$C_{20}$-Alkylgruppe, einer $C_2$-$C_{20}$-Alkenylgruppe, einer $C_2$-$C_{20}$-Alkynylgruppe, einer $C_1$-$C_{20}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{20}$-Arylgruppe, einer $C_1$-$C_{20}$-Heteroarylgruppe, einer monovalenten nicht aromatischen kondensierten polycyclischen Gruppe und einer monovalenten nicht aromatischen kondensierten heteropolycyclischen Gruppe;
einer $C_1$-$C_{20}$-Alkylgruppe, die mit mindestens einem substituiert ist, ausgewählt aus Deuterium, -F und einer Cyanogruppe;
einer $C_6$-$C_{20}$-Arylgruppe, die mit mindestens einem substituiert ist, ausgewählt aus Deuterium, -F und einer Cyanogruppe; und
einer Biphenylgruppe und einer Terphenylgruppe.

**5.** Organometallische Verbindung nach einem der Ansprüche 1 bis 4, wobei:

i) in Formel 2-1 $X_1$ und $X_2$ jeweils unabhängig $C(R_2)$ sind und $R_2$ Wasserstoff ist; oder
ii) in Formel 2-1 $X_3$ und $X_4$ jeweils unabhängig $C(R_2)$ sind und $R_2$ eine Methylgruppe, eine t-Butylgruppe oder eine Isopropylgruppe ist.

**6.** Organometallische Verbindung nach einem der Ansprüche 1 bis 5, wobei:

$L_1$ ein Ligand ist, der aus Gruppen ausgewählt ist, die durch die Formeln 2-1(1) und 2-1(2) dargestellt sind:

<Formel 2-1(1)>

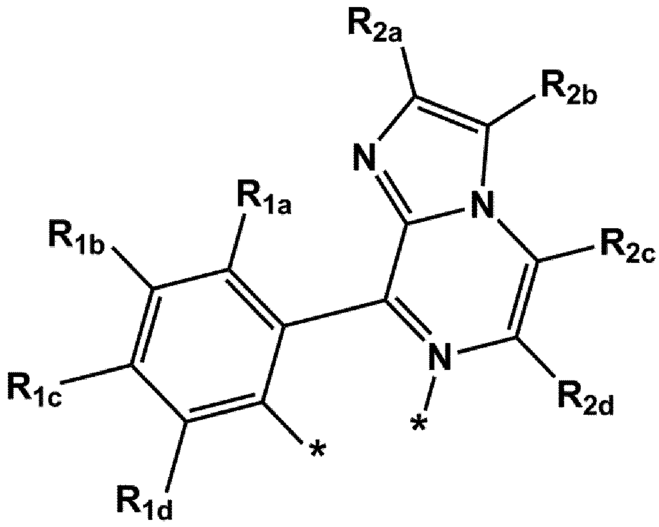

<Formel 2-1(2)>

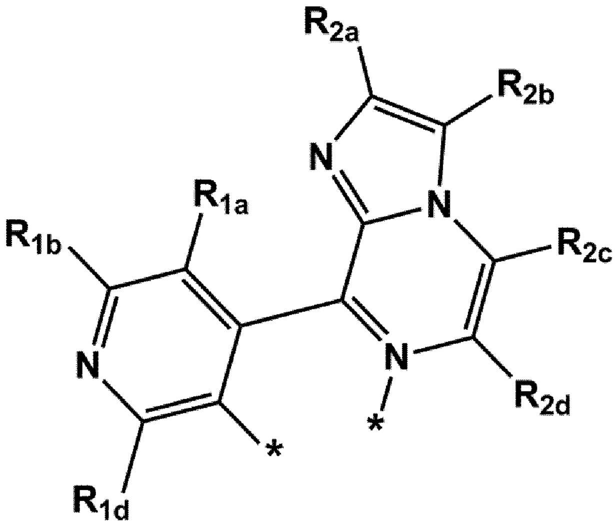

,

wobei in den Formeln 2-1(1) und 2-1(2):

$R_{1a}$ bis $R_{1d}$ und $R_{2a}$ bis $R_{2d}$ jeweils unabhängig gleich wie in Verbindung mit $R_1$ und $R_2$ unter Anspruch 1 definiert sind, und

* eine Bindungsstelle an M angibt.

**7.** Organometallische Verbindung nach einem der Ansprüche 1 bis 6, wobei:

$L_2$ ein Ligand ist, der durch Formel 2-2 oder 2-3 dargestellt ist:

<Formel 2-2>

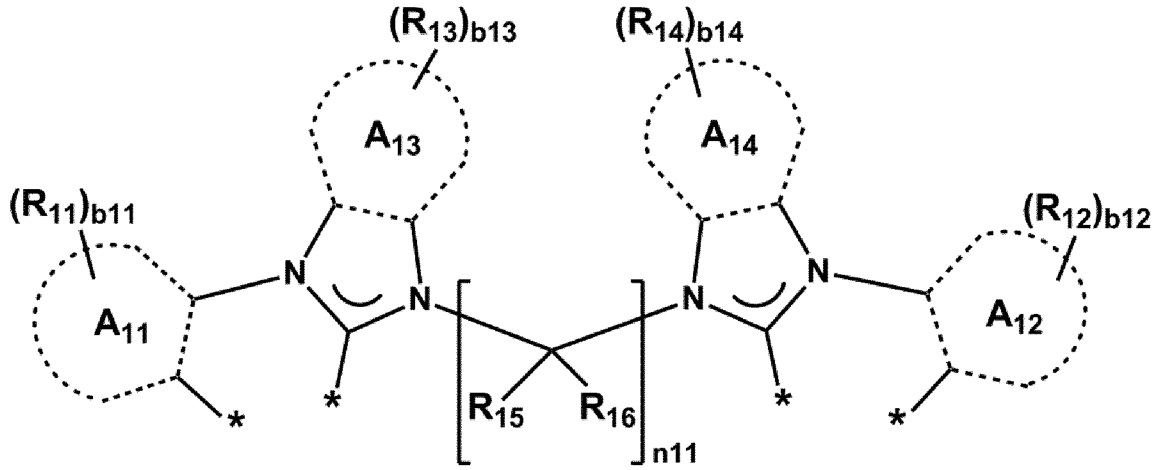

<Formel 2-3>

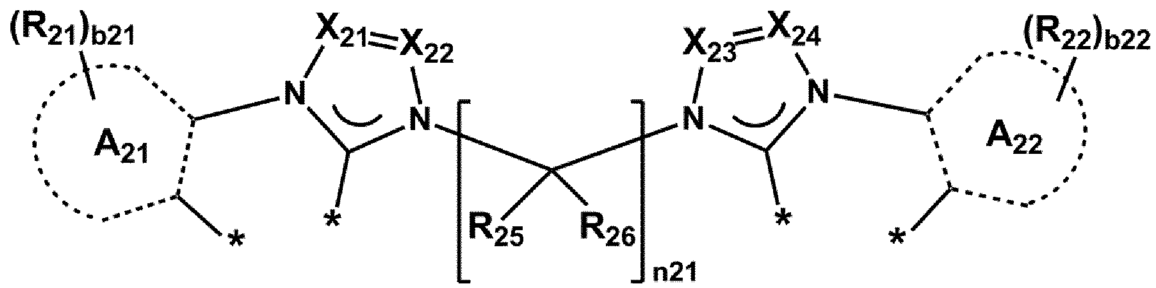

wobei in den Formeln 2-2 und 2-3:
$X_{21}$ und $X_{22}$ jeweils unabhängig $C(R_{23})$ oder N sind,
$X_{23}$ und $X_{24}$ jeweils unabhängig $C(R_{24})$ oder N sind,
Ring $A_{11}$ bis Ring $A_{14}$, Ring $A_{21}$, Ring $A_{22}$, $R_{11}$ bis $R_{16}$, $R_{21}$ bis $R_{26}$, b11 bis b14, b21, b22 und * jeweils unabhängig gleich wie in Verbindung mit $A_1$, $R_1$, b1 und * in Anspruch 1 definiert sind, und
n11 und n21 jeweils unabhängig eine ganze Zahl von 2 bis 6 sind.

**8.** Organometallische Verbindung nach Anspruch 7, wobei:

Ring $A_{11}$ bis Ring $A_{14}$, Ring $A_{21}$ und Ring $A_{22}$ in den Formeln 2-2 und 2-3 jeweils unabhängig aus einer Benzolgruppe, einer Naphthalengruppe, einer Anthracengruppe, einer Phenanthrengruppe, einer Triphenylengruppe, einer Pyrengruppe, einer Chrysengruppe, einer Cyclopentadiengruppe, einer 1,2,3,4-Tetrahydronaphthalengruppe, einer Thiophengruppe, einer Furangruppe, einer Pyrrolgruppe, einer Indolgruppe, einer Indengruppe, einer Benzosilolgruppe, einer Benzothiophengruppe, einer Benzofurangruppe, einer Carbazolgruppe, einer Fluorengruppe, einer Dibenzosilolgruppe, einer Dibenzothiophengruppe, einer Dibenzofurangruppe, einer Pyridingruppe, einer Pyrimidingruppe, einer Pyrazingruppe, einer Pyridazingruppe, einer Triazingruppe, einer Chinolingruppe, einer Isochinolingruppe, einer Chinoxalingruppe, einer Quinazolingruppe, einer Phenanthrolingruppe, einer Pyrazolgruppe, einer Imidazolgruppe, einer Triazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer Benzoxazolgruppe, einer Benzothiazolgruppe, einer Benzoxadiazolgruppe, einer Benzothiadiazolgruppe, einer 5,6,7,8-Tetrahydroisochinolingruppe, einer 5,6,7,8-Tetrahydrochinolingruppe und einer Benzochinazolingruppe ausgewählt sind; und/oder
$X_{21}$ und $X_{22}$ in Formel 2-3 jeweils unabhängig $C(R_{23})$ sind und $X_{23}$ und $X_{24}$ in Formel 2-3 jeweils unabhängig $C(R_{24})$ sind.

**9.** Organometallische Verbindung nach Anspruch 7 oder Anspruch 8, wobei
$R_{11}$ bis $R_{16}$ und $R_{21}$ bis $R_{26}$ in den Formeln 2-2 und 2-3 jeweils unabhängig ausgewählt sind aus:

Wasserstoff, Deuterium, -F, -Cl, -Br, -I, einer Hydroxylgruppe, einer Cyanogruppe, einer Nitrogruppe, einer

Amidinogruppe, einer Hydrazinogruppe, einer Hydrazonogruppe, einer $C_1$-$C_{20}$-Alkylgruppe, einer $C_2$-$C_{20}$-Alkenylgruppe, einer $C_2$-$C_{20}$-Alkynylgruppe und einer $C_1$-$C_{20}$-Alkoxygruppe;

einer $C_1$-$C_{20}$-Alkylgruppe, einer $C_2$-$C_{20}$-Alkenylgruppe, einer $C_2$-$C_{20}$-Alkynylgruppe und einer $C_1$-$C_{20}$-Alkoxygruppe, die jeweils mit mindestens einem substituiert sind, ausgewählt aus -F, -Cl, -Br, -I, $-CD_3$, $-CD_2H$, $-CDH_2$, $-CF_3$, $-CF_2H$, - $CFH_2$, einer Hydroxylgruppe, einer Cyanogruppe, einer Nitrogruppe, einer Amidinogruppe, einer Hydrazinogruppe, einer Hydrazonogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe, $-Si(Q_{31})(Q_{32})(Q_{33})$, $-N(Q_{31})(Q_{32})$, $-B(Q_{31})(Q_{32})$, $-C(=O)(Q_{31})$, - $S(=O)_2(Q_{31})$ und $-P(=O)(Q_{31})(Q_{32})$;

einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzoquinolinylgruppe, einer Chinoxalinylgruppe, einer Chinazolinylgruppe, einer Cinnolinylgruppe, einer Carbazolylgruppe, einer Acridinylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;

einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzoquinolinylgruppe, einer Chinoxalinylgruppe, einer Chinazolinylgruppe, einer Cinnolinylgruppe, einer Carbazolylgruppe, einer Acridinylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe; die jeweils mit mindestens einem substituiert sind, ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Amidinogruppe, einer Hydrazinogruppe, einer Hydrazonogruppe, einer $C_1$-$C_{20}$-Alkylgruppe, einer $C_2$-$C_{20}$-Alkenylgruppe, einer $C_2$-$C_{20}$-Alkynylgruppe, einer $C_1$-$C_{20}$-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzoquinolinylgruppe, einer Chinoxalinylgruppe, einer Chinazolinylgruppe, einer Cinnolinylgruppe, einer Carbazolylgruppe, einer Acridinylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe, einer Imidazopyrimidinylgruppe, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$ und

$-P(=O)(Q_{31})(Q_{32})$; und
$-Si(Q_1)(Q_2)(Q_3)$, $-N(Q_1)(Q_2)$, $-B(Q_1)(Q_2)$, $-C(=O)(Q_1)$, $-S(=O)_2(Q_1)$, $-P(Q_1)(Q_2)$ und $-P(=O)(Q_1)(Q_2)$, und $Q_1$ bis $Q_3$ und $Q_{31}$ bis $Q_{33}$ jeweils unabhängig ausgewählt sind aus:

Wasserstoff, Deuterium, -F, -Cl, -Br, -I, einer Cyanogruppe, einer $C_1$-$C_{20}$-Alkylgruppe, einer $C_2$-$C_{20}$-Alkenylgruppe, einer $C_2$-$C_{20}$-Alkynylgruppe, einer $C_1$-$C_{20}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{20}$-Arylgruppe, einer $C_1$-$C_{20}$-Heteroarylgruppe, einer monovalenten nicht aromatischen kondensierten polycyclischen Gruppe und einer monovalenten nicht aromatischen kondensierten heteropolycyclischen Gruppe;
einer $C_1$-$C_{20}$-Alkylgruppe, die mit mindestens einem substituiert ist, ausgewählt aus Deuterium, -F und einer Cyanogruppe;
einer $C_6$-$C_{20}$-Arylgruppe, die mit mindestens einem substituiert ist, ausgewählt aus Deuterium, -F und einer Cyanogruppe; und
einer Biphenylgruppe und einer Terphenylgruppe.

**10.** Organometallische Verbindung nach einem der Ansprüche 7 bis 9, wobei:

$L_2$ ein Ligand ist, der aus Gruppen ausgewählt ist, die durch die Formeln 2-2(1) bis 2-2(3) und 2-3(1) dargestellt sind:

<Formel 2-2(1)>

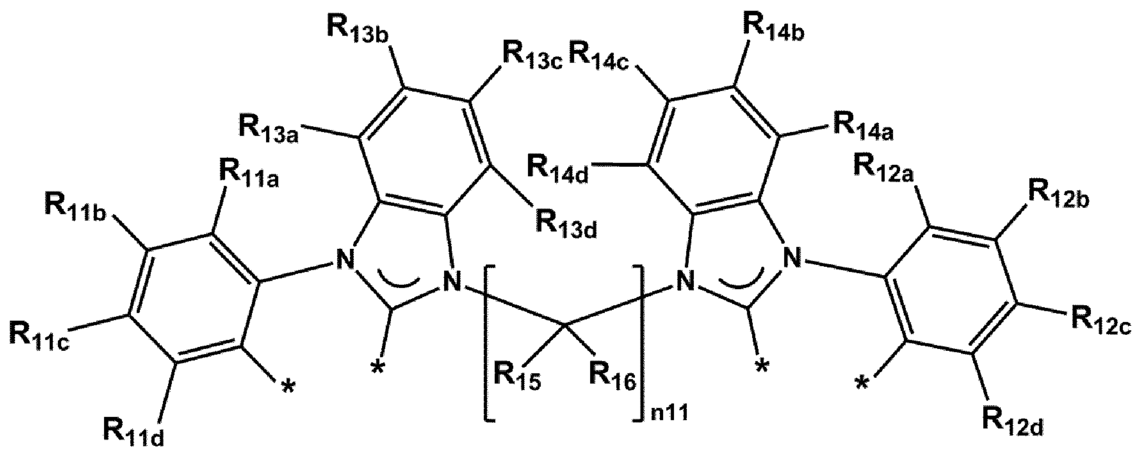

<Formel 2-2(2)>

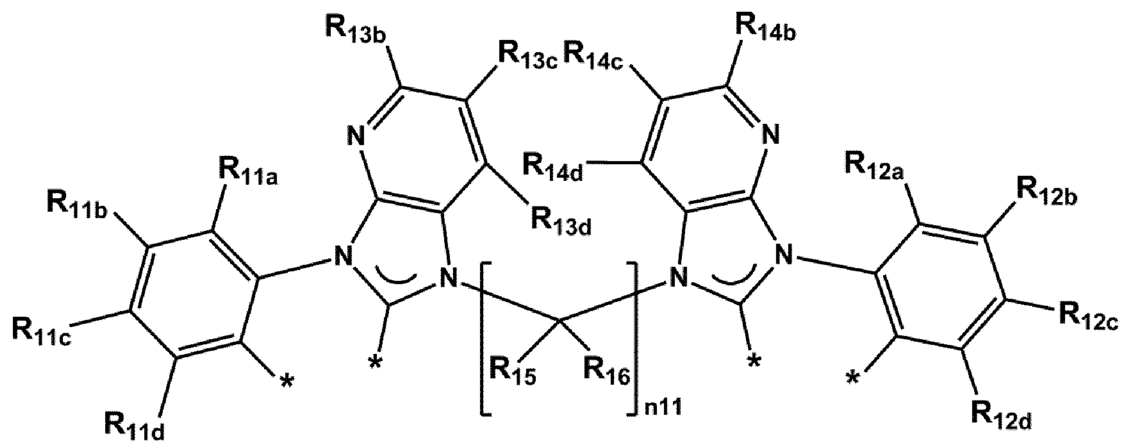

<Formel 2-2(3)>

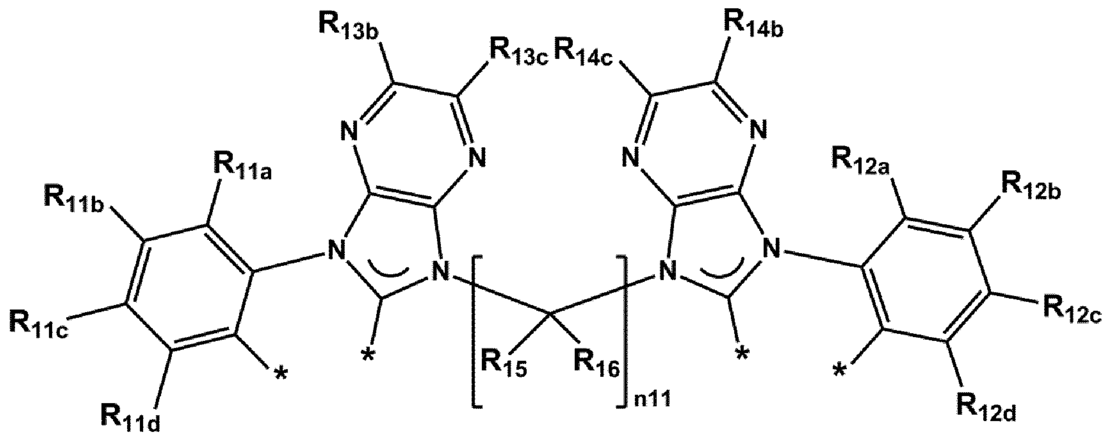

<Formel 2-3(1)>

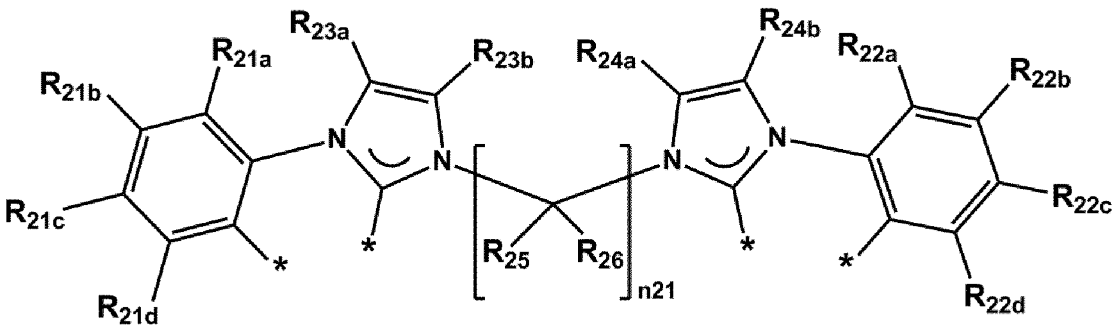

,

wobei in den Formeln 2-2(1) bis 2-2(3) und 2-3(1):
$R_{11a}$ bis $R_{11d}$, $R_{12a}$ bis $R_{12d}$, $R_{13a}$ bis $R_{13d}$, $R_{14a}$ bis $R_{14d}$, $R_{21a}$ bis $R_{21d}$, $R_{22a}$ bis $R_{22d}$, $R_{23a}$, $R_{23b}$, $R_{24a}$, $R_{24b}$, n11 und n21 jeweils unabhängig gleich wie in Verbindung mit $R_{11}$ bis $R_{16}$, $R_{21}$ bis $R_{26}$, n11 und n21 in Anspruch 8 definiert sind, und
* eine Bindungsstelle an M angibt.

**11.** Organometallische Verbindung nach Anspruch 1, wobei:

die organometallische Verbindung aus den Verbindungen BD1 bis BD59 ausgewählt ist:

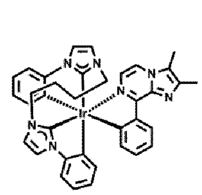

BD1

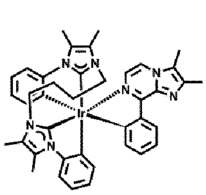

BD2

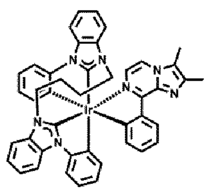

BD3

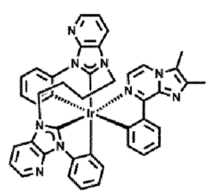

BD4

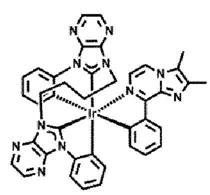

BD5

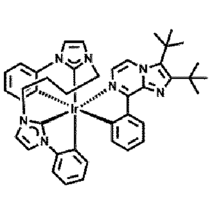
BD6

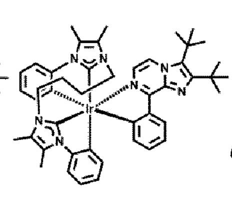
BD7

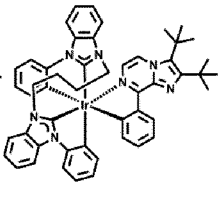
BD8

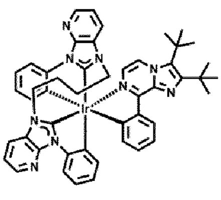
BD9

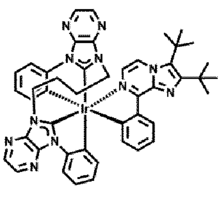
BD10

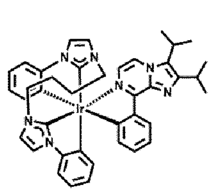
BD11

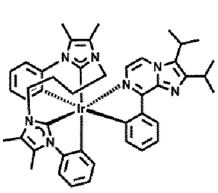
BD12

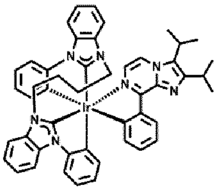
BD13

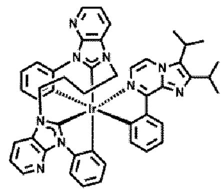
BD14

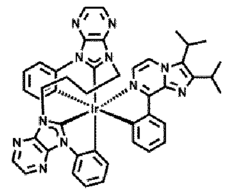
BD15

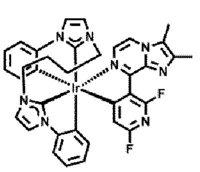
BD16

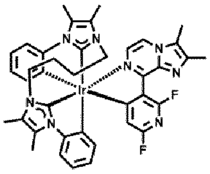
BD17

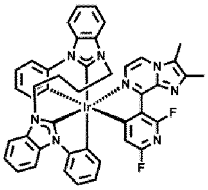
BD18

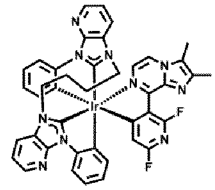
BD19

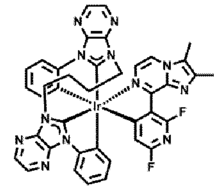
BD20

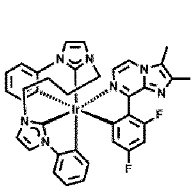
BD21

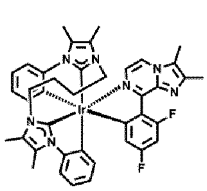
BD22

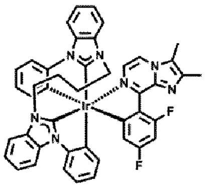
BD23

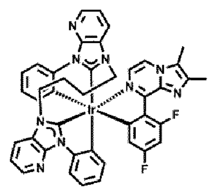
BD24

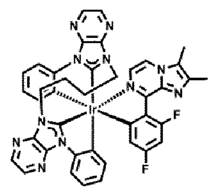
BD25

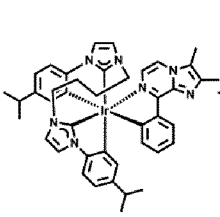
BD26

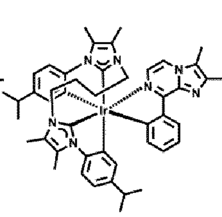
BD27

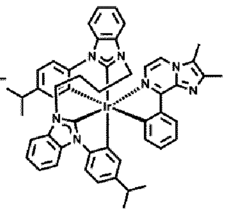
BD28

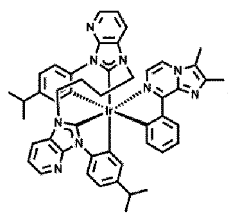
BD29

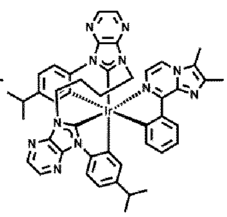
BD30

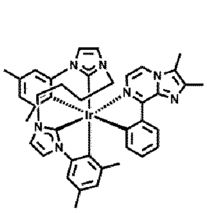
BD31

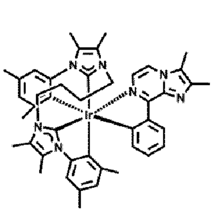
BD32

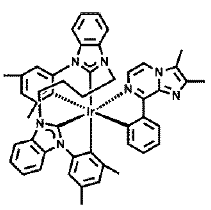
BD33

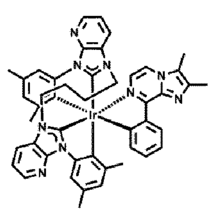
BD34

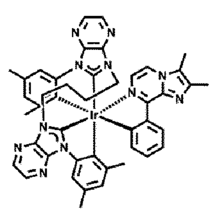
BD35

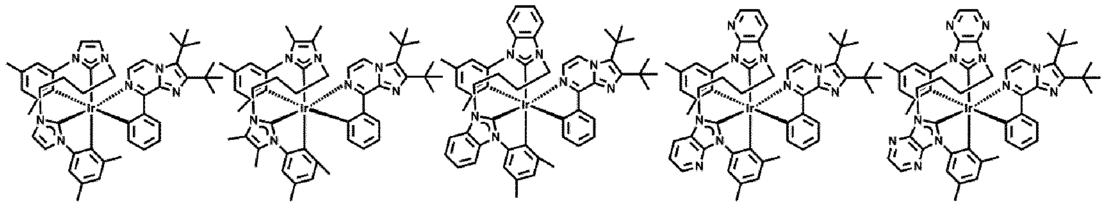

BD36 BD37 BD38 BD39 BD40

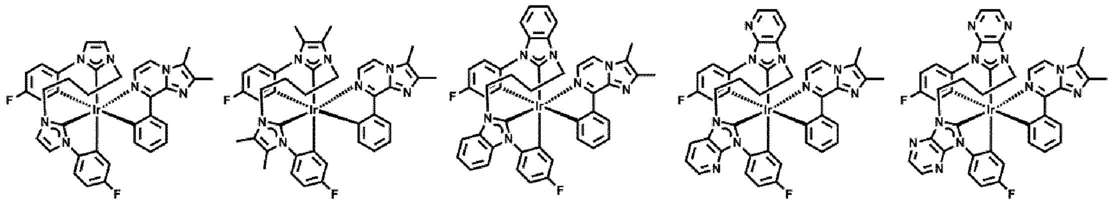

BD41 BD42 BD43 BD44 BD45

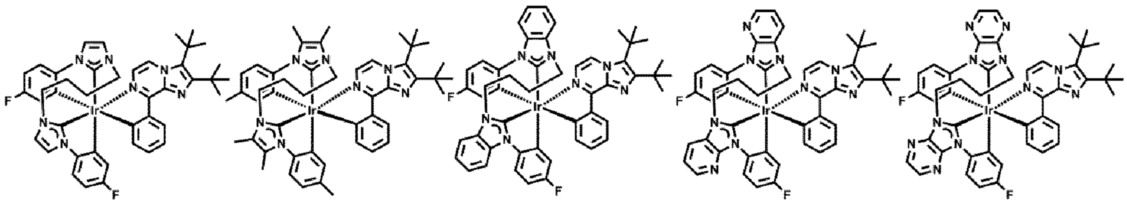

BD46 BD47 BD48 BD49 BD50

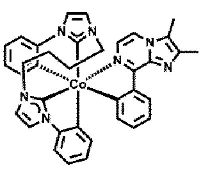

BD51

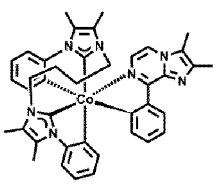

BD52

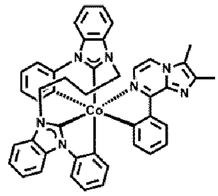

BD53

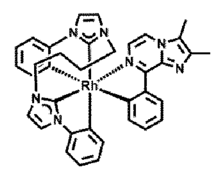

BD54

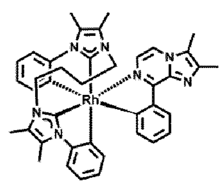

BD55

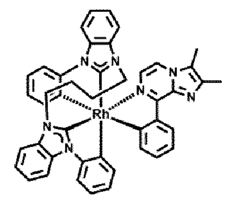

BD56

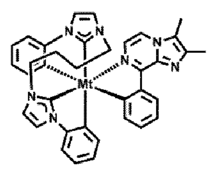

BD57

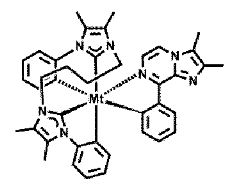

BD58

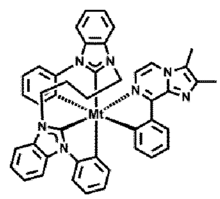

BD59

**12.** Organische lichtemittierende Vorrichtung, die umfasst:

eine erste Elektrode;
eine zweite Elektrode, die der ersten Elektrode zugewandt ist; und
eine organische Schicht zwischen der ersten Elektrode und der zweiten Elektrode und umfassend eine Emissionsschicht,
wobei die Emissionsschicht mindestens eine der organometallischen Verbindung nach einem der Ansprüche 1 bis 11 umfasst,

die Emissionsschicht ferner mindestens eine umfasst, die aus einer zweiten Verbindung und einer dritten Verbindung ausgewählt ist,
sich die organometallische Verbindung, die zweite Verbindung und die dritte Verbindung voneinander unterscheiden,
wenn die Emissionsschicht sowohl die zweite Verbindung als auch die dritte Verbindung umfasst, die zweite Verbindung und die dritte Verbindung einen Exciplex bilden, und
die organometallische Verbindung und die zweite Verbindung und/oder die dritte Verbindung keinen Exciplex bilden, optional wobei:

die zweite Verbindung und die dritte Verbindung einen Exciplex bilden und eine Wellenlänge ($\lambda_{max}$) der maximalen Emission in einem Photolumineszenzspektrum (PL-Spektrum) des Exciplexes ungefähr 390 nm oder mehr und ungefähr 500 nm oder weniger beträgt, optional wobei:

ein Unterschied eines absoluten Werts zwischen einem Energieniveau des niedrigsten unbesetzten molekularen Orbitals (LUMO) der organometallischen Verbindung und einem LUMO-Energieniveau der zweiten Verbindung oder der dritten Verbindung in einem Bereich von ungefähr 0,1 eV bis ungefähr 10 eV liegt, wobei:

ein Unterschied eines absoluten Werts zwischen einem Energieniveau des höchsten besetzten molekularen Orbitals (HOMO) der organometallischen Verbindung und einem HOMO-Energieniveau der zweiten Verbindung oder der dritten Verbindung ungefähr 1,25 eV oder weniger beträgt.

**13.** Organische lichtemittierende Vorrichtung nach Anspruch 12, wobei:

die zweite Verbindung durch Formel 3 dargestellt ist, und
die dritte Verbindung durch Formel 4 dargestellt ist:

<Formel 3>

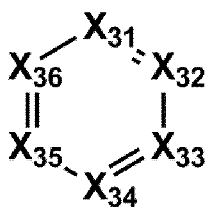

<Formel 4>

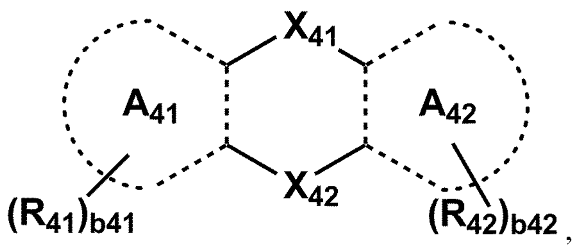

wobei in Formel 3 und 4:
$X_{31}$ aus $C(R_{31})$ und N ausgewählt ist, $X_{32}$ aus $C(R_{32})$ und N ausgewählt ist, $X_{33}$ aus $C(R_{33})$ und N ausgewählt ist, $X_{34}$ aus $C(R_{34})$ und N ausgewählt ist, $X_{35}$ aus $C(R_{35})$ und N ausgewählt ist und $X_{36}$ aus $C(R_{36})$ und N ausgewählt ist, wobei mindestens eines, das aus $X_{31}$ bis $X_{36}$ ausgewählt ist, N ist,
$R_{31}$ bis $R_{36}$ jeweils unabhängig aus einer Gruppe, dargestellt durch $*-(L_{31})_{a31}-(R_{37})_{b37}$, Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder nicht substituierten $C_1$-$C_{60}$-Alkylgruppe, einer substituierten oder nicht substituierten $C_2$-$C_{60}$-Alkenylgruppe, einer substituierten oder nicht substituierten $C_2$-$C_{60}$-Alkynylgruppe, einer substituierten oder nicht substituierten $C_1$-$C_{60}$-Alkoxygruppe, einer substituierten oder nicht substituierten $C_3$-$C_{10}$-Cycloalkylgruppe, einer substituierten oder nicht substituierten $C_1$-$C_{10}$-Heterocycloalkylgruppe, einer substituierten oder nicht substituierten $C_3$-$C_{10}$-Cycloalkenylgruppe, einer substituier-

ten oder nicht substituierten $C_1$-$C_{10}$-Heterocycloalkenylgruppe, einer substituierten oder nicht substituierten $C_6$-$C_{60}$-Arylgruppe, einer substituierten oder nicht substituierten $C_6$-$C_{60}$-Aryloxygruppe, einer substituierten oder nicht substituierten $C_6$-$C_{60}$-Arylthiogruppe, einer substituierten oder nicht substituierten $C_1$-$C_{60}$-Heteroarylgruppe, einer substituierten oder nicht substituierten $C_1$-$C_{60}$-Heteroaryloxygruppe, einer substituierten oder nicht substituierten $C_1$-$C_{60}$-Heteroarylthiogruppe, einer substituierten oder nicht substituierten monovalenten nicht aromatischen kondensierten polycyclischen Gruppe, einer substituierten oder nicht substituierten monovalenten nicht aromatischen kondensierten heteropolycyclischen Gruppe, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$ und $-P(=S)(Q_1)(Q_2)$ ausgewählt ist, wobei mindestens eines, das aus $R_{31}$ bis $R_{36}$ ausgewählt ist, eine Gruppe ist, die durch $*-(L_{31})_{a31}-(R_{37})_{b37}$ dargestellt ist,

$L_{31}$ aus einer substituierten oder nicht substituierten carbocyclischen $C_5$-$C_{60}$-Gruppe und einer substituierten oder nicht substituierten heterocyclischen $C_1$-$C_{60}$-Gruppe ausgewählt ist,

a31 eine ganze Zahl von 0 bis 6 ist,

$R_{37}$ unabhängig aus einer substituierten oder nicht substituierten $C_1$-$C_{60}$-Alkylgruppe, einer substituierten oder nicht substituierten $C_2$-$C_{60}$-Alkenylgruppe, einer substituierten oder nicht substituierten $C_2$-$C_{60}$-Alkynylgruppe, einer substituierten oder nicht substituierten $C_1$-$C_{60}$-Alkoxygruppe, einer substituierten oder nicht substituierten $C_3$-$C_{10}$-Cycloalkylgruppe, einer substituierten oder nicht substituierten $C_1$-$C_{10}$-Heterocycloalkylgruppe, einer substituierten oder nicht substituierten $C_3$-$C_{10}$-Cycloalkenylgruppe, einer substituierten oder nicht substituierten $C_1$-$C_{10}$-Heterocycloalkenylgruppe, einer substituierten oder nicht substituierten $C_6$-$C_{60}$-Arylgruppe, einer substituierten oder nicht substituierten $C_6$-$C_{60}$-Aryloxygruppe, einer substituierten oder nicht substituierten $C_6$-$C_{60}$-Arylthiogruppe, einer substituierten oder nicht substituierten $C_1$-$C_{60}$-Heteroarylgruppe, einer substituierten oder nicht substituierten $C_1$-$C_{60}$-Heteroaryloxygruppe, einer substituierten oder nicht substituierten $C_1$-$C_{60}$-Heteroarylthiogruppe, einer substituierten oder nicht substituierten monovalenten nicht aromatischen kondensierten polycyclischen Gruppe, einer substituierten oder nicht substituierten monovalenten nicht aromatischen kondensierten heteropolycyclischen Gruppe, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$ und $-P(=S)(Q_1)(Q_2)$ ausgewählt ist,

b37 eine ganze Zahl von 1 bis 10 ist,

$A_{41}$ und $A_{42}$ jeweils unabhängig aus einer carbocyclischen $C_5$-$C_{60}$-Gruppe und einer heterocyclischen $C_1$-$C_{60}$-Gruppe ausgewählt sind,

$X_{41}$ aus einer Einfachbindung, O, S, $B(R_{43})$, $N(R_{43})$, $C(R_{43})(R_{44})$ und $Si(R_{43})(R_{44})$ ausgewählt ist, und $X_{42}$ aus einer Einfachbindung, O, S, $B(R_{45})$, $N(R_{45})$, $C(R_{45})(R_{46})$ und $Si(R_{45})(R_{46})$ ausgewählt ist, wobei $X_{41}$ und $X_{42}$ nicht gleichzeitig eine Einfachbindung sind,

$R_{41}$ bis $R_{46}$ jeweils unabhängig aus einer Gruppe, dargestellt durch $*-(L_{41})_{a41}-(R_{47})_{b47}$, Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder nicht substituierten $C_1$-$C_{60}$-Alkylgruppe, einer substituierten oder nicht substituierten $C_2$-$C_{60}$-Alkenylgruppe, einer substituierten oder nicht substituierten $C_2$-$C_{60}$-Alkynylgruppe, einer substituierten oder nicht substituierten $C_1$-$C_{60}$-Alkoxygruppe, einer substituierten oder nicht substituierten $C_3$-$C_{10}$-Cycloalkylgruppe, einer substituierten oder nicht substituierten $C_1$-$C_{10}$-Heterocycloalkylgruppe, einer substituierten oder nicht substituierten $C_3$-$C_{10}$-Cycloalkenylgruppe, einer substituierten oder nicht substituierten $C_1$-$C_{10}$-Heterocycloalkenylgruppe, einer substituierten oder nicht substituierten $C_6$-$C_{60}$-Arylgruppe, einer substituierten oder nicht substituierten $C_6$-$C_{60}$-Aryloxygruppe, einer substituierten oder nicht substituierten $C_6$-$C_{60}$-Arylthiogruppe, einer substituierten oder nicht substituierten $C_1$-$C_{60}$-Heteroarylgruppe, einer substituierten oder nicht substituierten $C_1$-$C_{60}$-Heteroaryloxygruppe, einer substituierten oder nicht substituierten $C_1$-$C_{60}$-Heteroarylthiogruppe, einer substituierten oder nicht substituierten monovalenten nicht aromatischen kondensierten polycyclischen Gruppe, einer substituierten oder nicht substituierten monovalenten nicht aromatischen kondensierten heteropolycyclischen Gruppe, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$ und $-P(=S)(Q_1)(Q_2)$ ausgewählt ist, wobei mindestens eines, das aus $R_{41}$ bis $R_{46}$ ausgewählt ist, eine Gruppe ist, die durch $*-(L_{41})_{a41}-(R_{47})_{b47}$ dargestellt ist,

$L_{41}$ aus einer substituierten oder nicht substituierten carbocyclischen $C_5$-$C_{60}$-Gruppe und einer substituierten oder nicht substituierten heterocyclischen $C_1$-$C_{60}$-Gruppe ausgewählt ist,

a41 eine ganze Zahl von 0 bis 6 ist,

$R_{47}$ unabhängig aus einer substituierten oder nicht substituierten $C_1$-$C_{60}$-Alkylgruppe, einer substituierten oder nicht substituierten $C_2$-$C_{60}$-Alkenylgruppe, einer substituierten oder nicht substituierten $C_2$-$C_{60}$-Alkynylgruppe, einer substituierten oder nicht substituierten $C_1$-$C_{60}$-Alkoxygruppe, einer substituierten oder nicht substituierten $C_3$-$C_{10}$-Cycloalkylgruppe, einer substituierten oder nicht substituierten $C_1$-$C_{10}$-Heterocycloalkylgruppe, einer substituierten oder nicht substituierten $C_3$-$C_{10}$-Cycloalkenylgruppe, einer substituierten oder nicht substituierten $C_1$-$C_{10}$-Heterocycloalkenylgruppe, einer substituierten oder nicht substituierten $C_6$-$C_{60}$-Arylgruppe, einer sub-

stituierten oder nicht substituierten $C_6$-$C_{60}$-Aryloxygruppe, einer substituierten oder nicht substituierten $C_6$-$C_{60}$-Arylthiogruppe, einer substituierten oder nicht substituierten $C_1$-$C_{60}$-Heteroarylgruppe, einer substituierten oder nicht substituierten $C_1$-$C_{60}$-Heteroaryloxygruppe, einer substituierten oder nicht substituierten $C_1$-$C_{60}$-Heteroarylthiogruppe, einer substituierten oder nicht substituierten monovalenten nicht aromatischen kondensierten polycyclischen Gruppe, einer substituierten oder nicht substituierten monovalenten nicht aromatischen kondensierten heteropolycyclischen Gruppe, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $- S(=O)_2(Q_1)$, $-P(=O)(Q_1)(Q_2)$ und $-P(=S)(Q_1)(Q_2)$ ausgewählt ist,

b47 eine ganze Zahl von 1 bis 10 ist,

$Q_1$ bis $Q_3$ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe ausgewählt sind, und

* eine Bindungsstelle an ein benachbartes Atom angibt.

**14.** Organische lichtemittierende Vorrichtung nach Anspruch 13, wobei:
die zweite Verbindung aus den Verbindungen ETH1 bis ETH80 ausgewählt ist und die dritte Verbindung aus den Verbindungen HTH1 bis HTH28 ausgewählt ist:

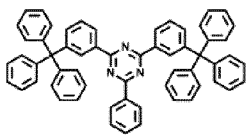
ETH1

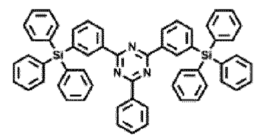
ETH2

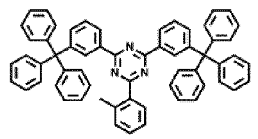
ETH3

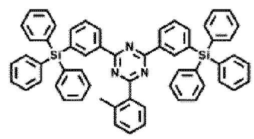
ETH4

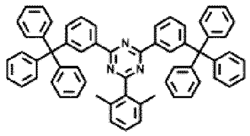
ETH5

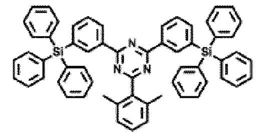
ETH6

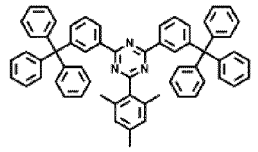
ETH7

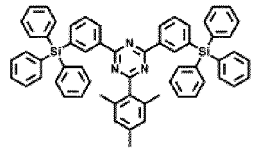
ETH8

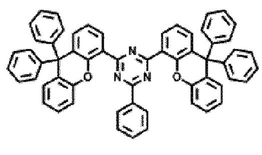
ETH9

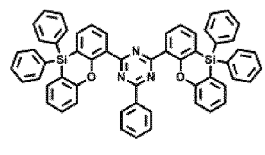
ETH10

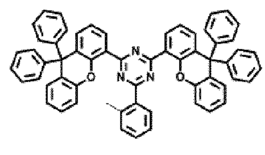
ETH11

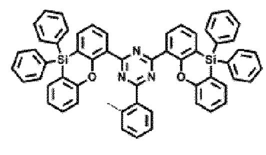
ETH12

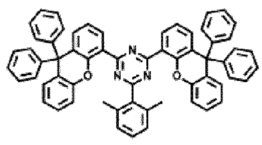
ETH13

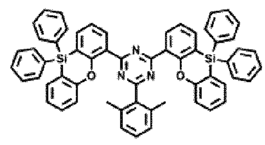
ETH14

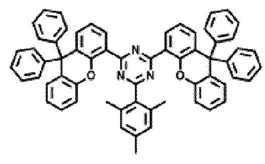
ETH15

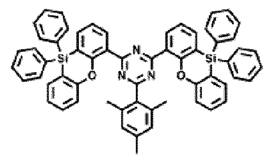
ETH16

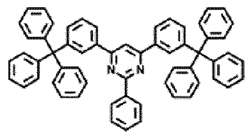
ETH17

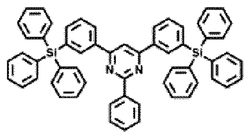
ETH18

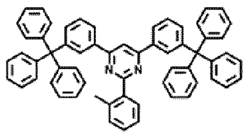
ETH19

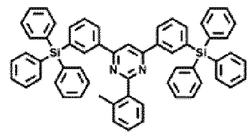
ETH20

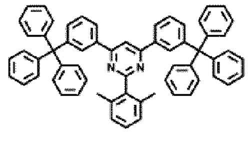
ETH21

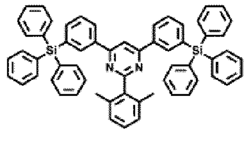
ETH22

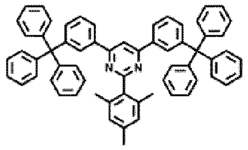
ETH23

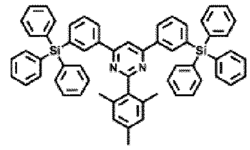
ETH24

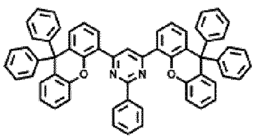
ETH25

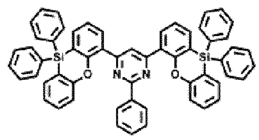
ETH26

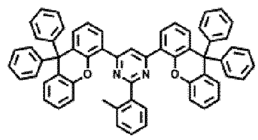
ETH27

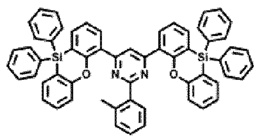
ETH28

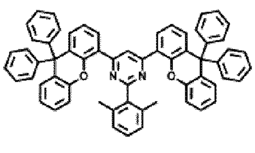
ETH29

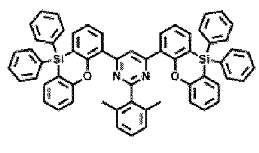
ETH30

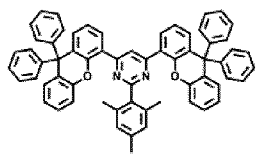
ETH31

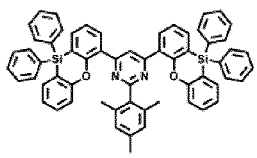
ETH32

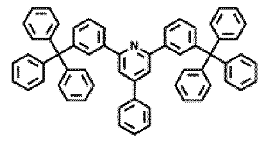
ETH33

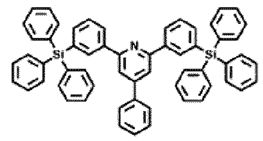
ETH34

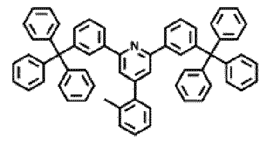
ETH35

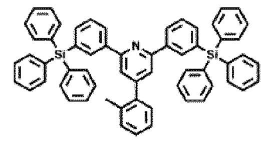
ETH36

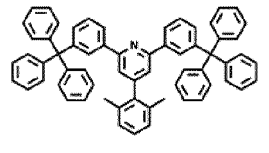
ETH37

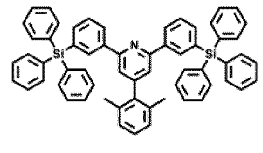
ETH38

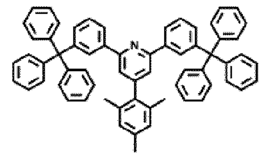
ETH39

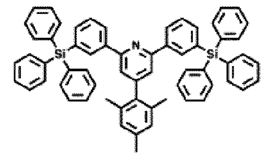
ETH40

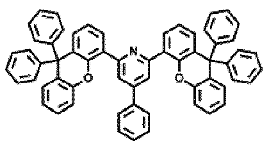
ETH41

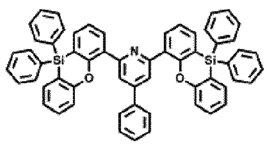
ETH42

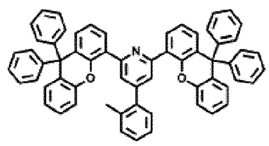
ETH43

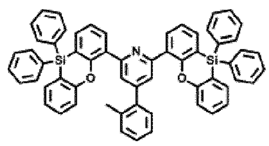
ETH44

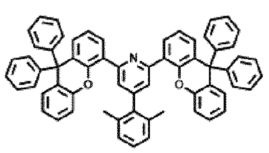
ETH45

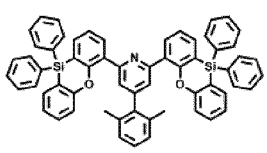
ETH46

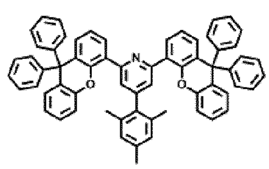
ETH47

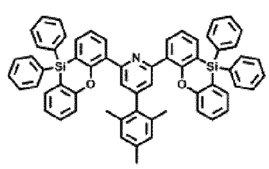
ETH48

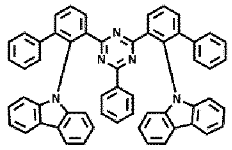
ETH49

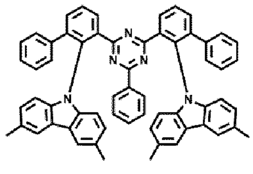
ETH50

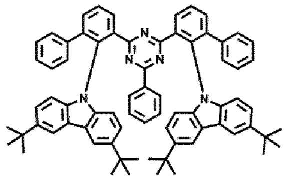
ETH51

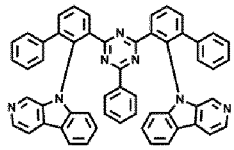
ETH52

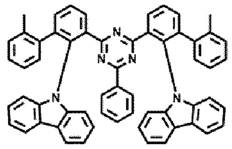
ETH53

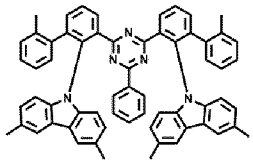
ETH54

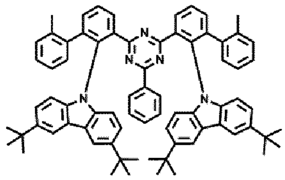
ETH55

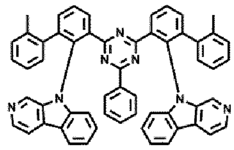
ETH56

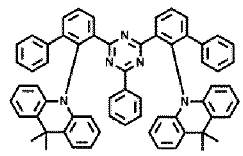
ETH57

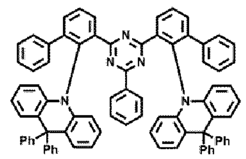
ETH58

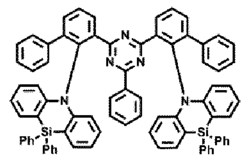
ETH59

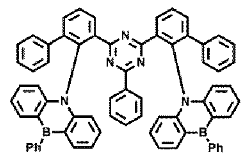
ETH60

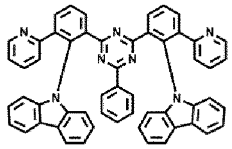
ETH61

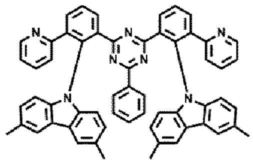
ETH62

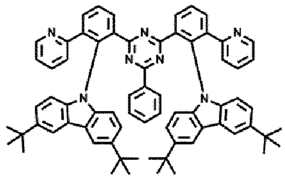
ETH63

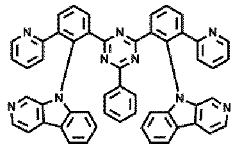
ETH64

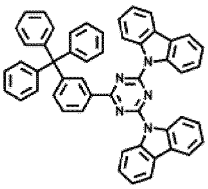
ETH65

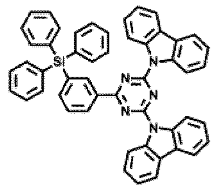
ETH66

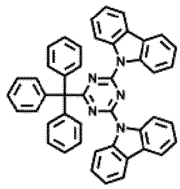
ETH67

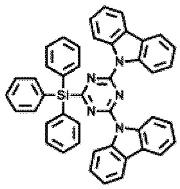
ETH68

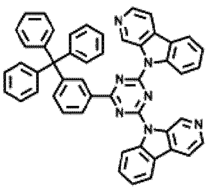
ETH69

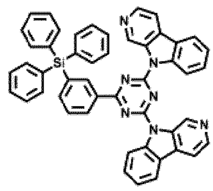
ETH70

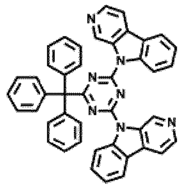
ETH71

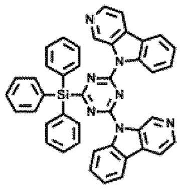
ETH72

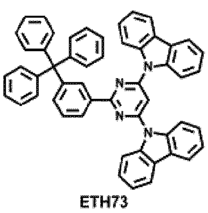
ETH73

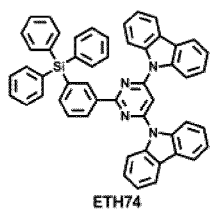
ETH74

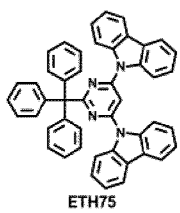
ETH75

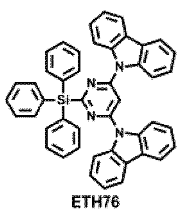
ETH76

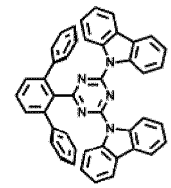
ETH77

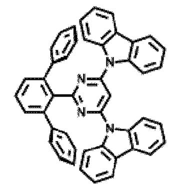
ETH78

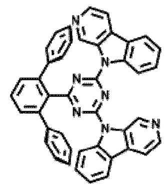
ETH79

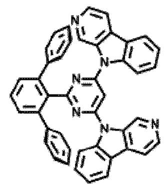
ETH80

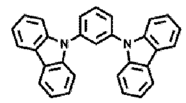
HTH1

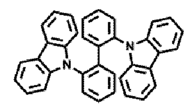
HTH2

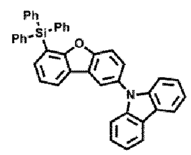
HTH3

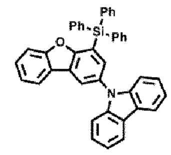
HTH4

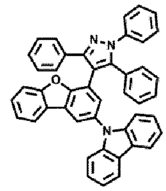
HTH5

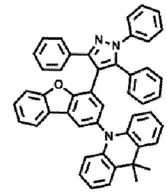
HTH6

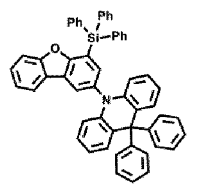
HTH7

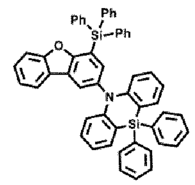
HTH8

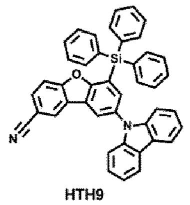
HTH9

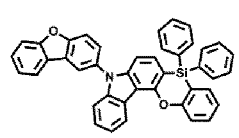
HTH10

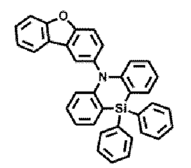
HTH11

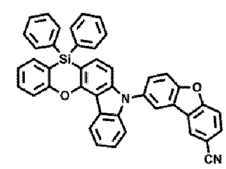
HTH12

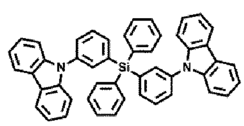
HTH13

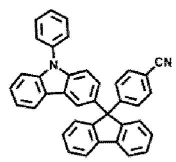
HTH14

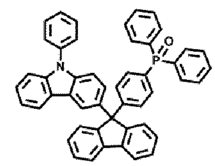
HTH15

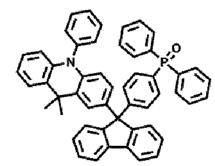
HTH16

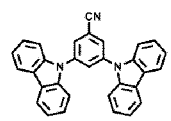
HTH17

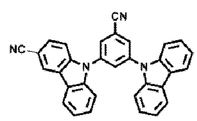
HTH18

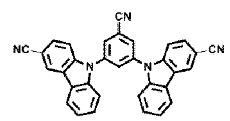
HTH19

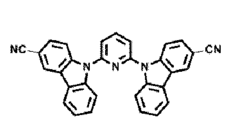
HTH20

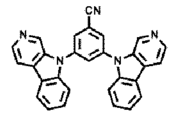
HTH21

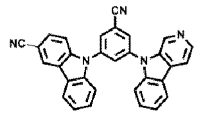
HTH22

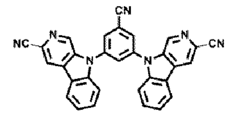
HTH23

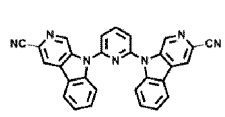
HTH24

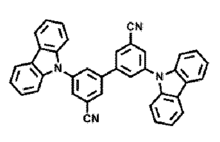
HTH25

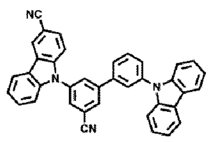
HTH26

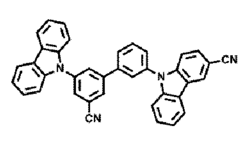
HTH27

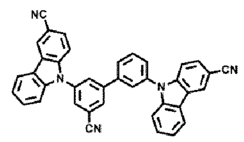
HTH28

**15.** Organische lichtemittierende Vorrichtung nach einem der Ansprüche 12 bis 14, wobei: eine Verfallszeit einer verzögerten Fluoreszenz in einem Spektrum der zeitaufgelösten Elektrolumineszenz (TREL) der organischen lichtemittierenden Vorrichtung ungefähr 50 ns oder mehr beträgt.

## Revendications

**1.** Composé organométallique représenté par la Formule 1: < Formule 1>

$M(L_1)_{n1}(L_2)_{n2}$

<Formule 2-1>

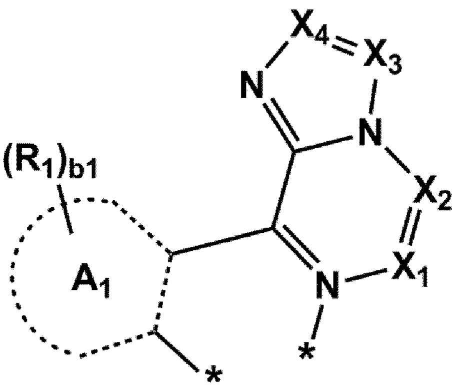

,

dans lequel, dans la Formule 1, M est choisi parmi l'iridium (Ir), le rhodium (Rh), le cobalt (Co) et le meitnérium (Mt),
$L_1$ est un ligand représenté par la Formule 2-1 et n1 est 1, 2 ou 3, où, lorsque n1 est 2 ou plus, deux $L_1$(s) ou plus sont identiques ou différents les uns des autres,
$L_2$ est un ligand organique et n2 est 0, 1 ou 2, où, lorsque n2 est 2, deux $L_2$(s) sont identiques ou différents l'un de l'autre,
la somme de n1 et n2 est 2 ou 3,
dans la Formule 2-1, le cycle $A_1$ est choisi parmi un groupe $C_5$-$C_{60}$ carbocyclique et un groupe $C_1$-$C_{60}$ hétérocyclique,
$X_1$ à $X_4$ sont chacun indépendamment $C(R_2)$ ou N,
$R_1$ et $R_2$ sont chacun indépendamment choisis parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe polycyclique condensé non aromatique monovalent substitué ou non substitué, un groupe hétéropolycyclique condensé non aromatique monovalent substitué ou non substitué, $-Si(Q_1)(Q_2)(Q_3)$, $-N(Q_1)(Q_2)$, $-B(Q_1)(Q_2)$, $-P(Q_1)(Q_2)$, $-C(=O)(Q_1)$, $-S(=O)_2(Q_1)$ et $-P(=O)(Q_1)(Q_2)$,
b1 est un nombre entier de 1 à 10,
au moins un substituant du groupe $C_1$-$C_{60}$ alkyle substitué, du groupe $C_2$-$C_{60}$ alcényle substitué, du groupe $C_2$-$C_{60}$ alcynyle substitué, du groupe $C_1$-$C_{60}$ alcoxy substitué, du groupe $C_3$-$C_{10}$ cycloalkyle substitué, du groupe $C_1$-$C_{10}$ hétérocycloalkyle substitué, du groupe $C_3$-$C_{10}$ cycloalcényle substitué, du groupe $C_1$-$C_{10}$ hétérocycloalcényle substitué, du groupe $C_6$-$C_{60}$ aryle substitué, du groupe $C_6$-$C_{60}$ aryloxy substitué, du groupe $C_6$-$C_{60}$ arylthio substitué, du groupe $C_1$-$C_{60}$ hétéroaryle substitué, du groupe polycyclique condensé non aromatique monovalent substitué et du groupe hétéropolycyclique condensé non aromatique monovalent substitué est choisi parmi:

un deutérium (-D), -F, -Cl, -Br, -I, un groupe hydroxyle, un groupe cyano, un groupe nitro, un groupe amidino,

un groupe hydrazino, un groupe hydrazono, un groupe $C_1$-$C_{60}$ alkyle, un groupe $C_2$-$C_{60}$ alcényle, un groupe $C_2$-$C_{60}$ alcynyle et un groupe $C_1$-$C_{60}$ alcoxy;

un groupe $C_1$-$C_{60}$ alkyle, un groupe $C_2$-$C_{60}$ alcényle, un groupe $C_2$-$C_{60}$ alcynyle et un groupe $C_1$-$C_{60}$ alcoxy, chacun étant substitué avec au moins un choisi parmi un deutérium, -F, -Cl, -Br, -I, un groupe hydroxyle, un groupe cyano, un groupe nitro, un groupe amidino, un groupe hydrazino, un groupe hydrazono, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, un groupe hétéropolycyclique condensé non aromatique monovalent, $-Si(Q_{11})(Q_{12})(Q_{13})$, $-N(Q_{11})(Q_{12})$, $-B(Q_{11})(Q_{12})$, $-P(Q_{11})(Q_{12})$, $-C(=O)(Q_{11})$, - $S(=O)_2(Q_{11})$ et $-P(=O)(Q_{11})(Q_{12})$;

un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent et un groupe hétéropolycyclique condensé non aromatique monovalent;

un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent et un groupe hétéropolycyclique condensé non aromatique monovalent, chacun étant substitué avec au moins un choisi parmi un deutérium, -F, -Cl, -Br, -I, un groupe hydroxyle, un groupe cyano, un groupe nitro, un groupe amidino, un groupe hydrazino, un groupe hydrazono, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe polycyclique condensé non aromatique monovalent, un groupe hétéropolycyclique condensé non aromatique monovalent, $-Si(Q_{21})(Q_{22})(Q_{23})$, - $N(Q_{21})(Q_{22})$, $-B(Q_{21})(Q_{22})$, $-P(Q_{21})(Q_{22})$, $-C(=O)(Q_{21})$, $-S(=O)_2(Q_{21})$ et $-P(=O)(Q_{21})(Q_{22})$; et

$-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, - $S(=O)_2(Q_{31})$ et $-P(=O)(Q_{31})(Q_{32})$,

$Q_1$ à $Q_3$, $Q_{11}$ à $Q_{13}$, $Q_{21}$ à $Q_{23}$ et $Q_{31}$ à $Q_{33}$ sont chacun indépendamment choisis parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_1$-$C_{60}$ hétéroaryle, un groupe polycyclique condensé non aromatique monovalent, un groupe hétéropolycyclique condensé non aromatique monovalent, un groupe $C_1$-$C_{60}$ alkyle substitué avec au moins un choisi parmi un deutérium, -F et un groupe cyano, un groupe $C_6$-$C_{60}$ aryle substitué avec au moins un choisi parmi un deutérium, -F et un groupe cyano, un groupe biphényle et un groupe terphényle, et

* indique un site de liaison à M.

**2.** Composé organométallique selon la revendication 1, dans lequel:
dans la Formule 1, n1 est 1, n2 est 1 et $L_2$ est un ligand tétradenté.

**3.** Composé organométallique selon la revendication 1 ou la revendication 2, dans lequel:

le cycle $A_1$ dans la Formule 2-1 est choisi parmi un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe thiophène, un groupe furane, un groupe pyrrole, un groupe indole, un groupe indène, un groupe benzosilole, un groupe benzothiophène, un groupe benzofurane, un groupe carbazole, un groupe fluorène, un groupe dibenzosilole, un groupe dibenzothiophène, un groupe dibenzofurane, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoléine, un groupe 5,6,7,8-tétrahydroquinoléine et un groupe benzoquinazoline; et/ou

$X_1$ à $X_4$ dans la Formule 2-1 sont chacun indépendamment $C(R_2)$.

**4.** Composé organométallique selon l'une quelconque des revendications 1 à 3, dans lequel: $R_1$ et $R_2$ dans la Formule 2-1 sont chacun indépendamment choisis parmi:

un hydrogène, un deutérium, -F, -Cl, -Br, -I, un groupe hydroxyle, un groupe cyano, un groupe nitro, un groupe amidino, un groupe hydrazino, un groupe hydrazono, un groupe $C_1$-$C_{20}$ alkyle, un groupe $C_2$-$C_{20}$ alcényle, un groupe $C_2$-$C_{20}$ alcynyle et un groupe $C_1$-$C_{20}$ alcoxy;
un groupe $C_1$-$C_{20}$ alkyle, un groupe $C_2$-$C_{20}$ alcényle, un groupe $C_2$-$C_{20}$ alcynyle et un groupe $C_1$-$C_{20}$ alcoxy, chacun étant substitué avec au moins un choisi parmi un deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazino, un groupe hydrazono, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, un groupe pyrimidinyle, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$ et $-P(=O)(Q_{31})(Q_{32})$;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe acridinyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe acridinyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle, chacun étant substitué avec au moins un choisi parmi un deutérium, -F, -Cl, -Br, -I, $-CD_3$, $-CD_2H$, $-CDH_2$, $-CF_3$, $- CF_2H$, $-CFH_2$, un groupe hydroxyle, un groupe cyano, un groupe nitro, un groupe amidino, un groupe hydrazino, un groupe hydrazono, un groupe $C_1$-$C_{20}$ alkyle, un groupe $C_2$-$C_{20}$ alcényle, un groupe $C_2$-$C_{20}$ alcynyle, un groupe $C_1$-$C_{20}$ alcoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe acridinyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle,

un groupe dibenzocarbazolyle, un groupe imidazopyridinyle, un groupe imidazopyrimidinyle, -Si($Q_{31}$)($Q_{32}$)($Q_{33}$), - N($Q_{31}$)($Q_{32}$), -B($Q_{31}$)($Q_{32}$), -C(=O)($Q_{31}$), -S(=O)$_2$($Q_{31}$) et -P(=O)($Q_{31}$)($Q_{32}$); et
-Si($Q_1$)($Q_2$)($Q_3$), -N($Q_1$)($Q_2$), -B($Q_1$)($Q_2$), -C(=O)($Q_1$), -S(=O)$_2$($Q_1$), -P($Q_1$)($Q_2$) et -P(=O)($Q_1$)($Q_2$), et
$Q_1$ à $Q_3$ et $Q_{31}$ à $Q_{33}$ sont chacun indépendamment choisis parmi:
un hydrogène, un deutérium, -F, -Cl, -Br, -I, un groupe cyano, un groupe $C_1$-$C_{20}$ alkyle, un groupe $C_2$-$C_{20}$ alcényle, un groupe $C_2$-$C_{20}$ alcynyle, un groupe $C_1$-$C_{20}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{20}$ aryle, un groupe $C_1$-$C_{20}$ hétéroaryle, un groupe polycyclique condensé non aromatique monovalent et un groupe hétéropolycyclique condensé non aromatique monovalent;
un groupe $C_1$-$C_{20}$ alkyle substitué avec au moins un choisi parmi un deutérium, -F et un groupe cyano;
un groupe $C_6$-$C_{20}$ aryle substitué avec au moins un choisi parmi un deutérium, -F et un groupe cyano; et
un groupe biphényle et un groupe terphényle.

**5.** Composé organométallique selon l'une quelconque des revendications 1 à 4, dans lequel:

i) dans la Formule 2-1, $X_1$ et $X_2$ sont chacun indépendamment C($R_2$) et $R_2$ est un hydrogène; ou
ii) dans la Formule 2-1, $X_3$ et $X_4$ sont chacun indépendamment C($R_2$) et $R_2$ est un groupe méthyle, un groupe t-butyle ou un groupe isopropyle.

**6.** Composé organométallique selon l'une quelconque des revendications 1 à 5, dans lequel:

$L_1$ est un ligand choisi dans des groupes représentés par les Formules 2-1(1) et 2-1(2):

<Formule 2-1(1)>

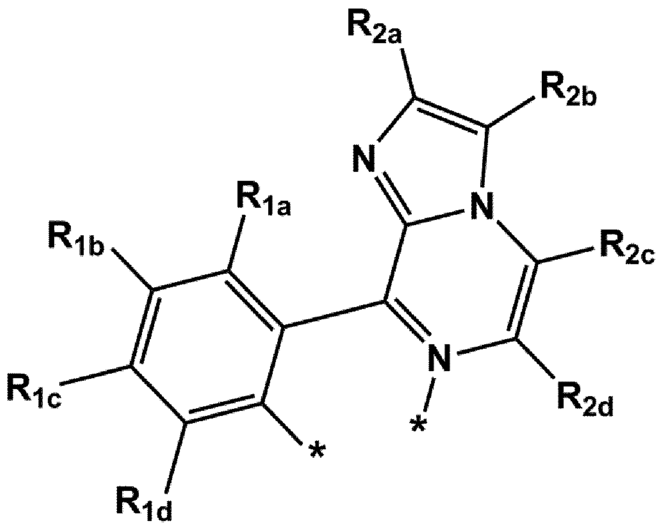

<Formule 2-1(2)>

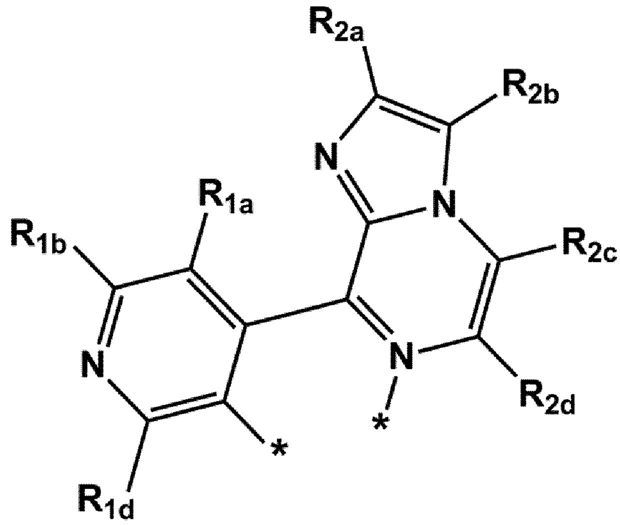

,

dans lequel, dans les Formules 2-1(1) et 2-1(2),
$R_{1a}$ à $R_{1d}$ et $R_{2a}$ à $R_{2d}$ sont chacun indépendamment identiques à ce qui est défini conjointement à $R_1$ et $R_2$ dans la revendication 1, et
* indique un site de liaison à M.

**7.** Composé organométallique selon l'une quelconque des revendications 1 à 6, dans lequel:

$L_2$ est un ligand représenté par la Formule 2-2 ou 2-3:

<Formule 2-2>

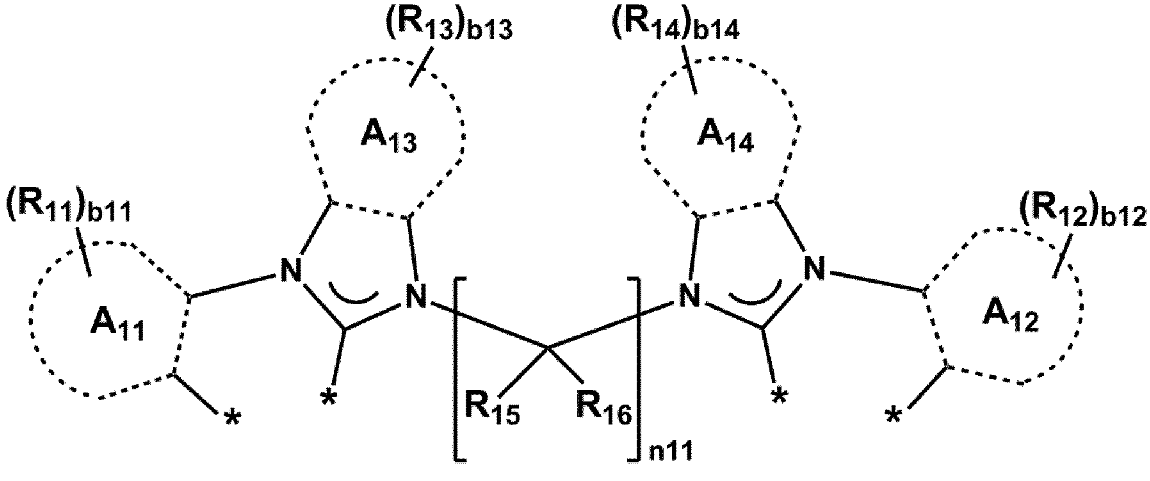

<Formule 2-3>

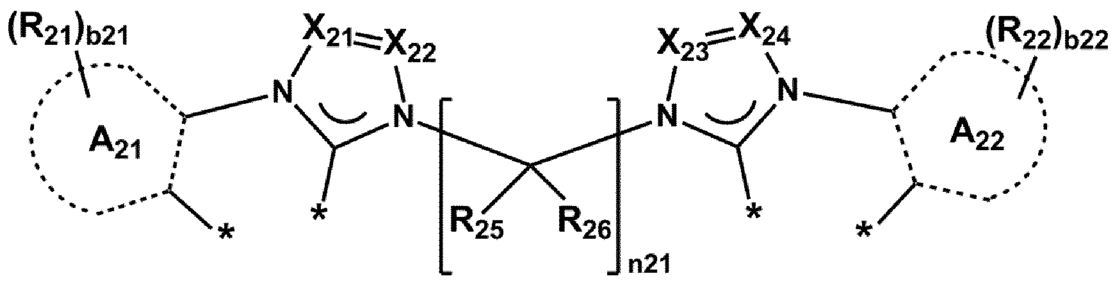

,

dans lequel, dans les Formules 2-2 et 2-3,
$X_{21}$ et $X_{22}$ sont chacun indépendamment $C(R_{23})$ ou N,
$X_{23}$ et $X_{24}$ sont chacun indépendamment $C(R_{24})$ ou N,
le cycle $A_{11}$ au cycle $A_{14}$, le cycle $A_{21}$, le cycle $A_{22}$, $R_{11}$ à $R_{16}$, $R_{21}$ à $R_{26}$, b11 à b14, b21, b22 et * sont chacun indépendamment identiques à ce qui est défini conjointement à $A_1$, $R_1$, b1 et * dans la revendication 1, et
n11 et n21 sont chacun indépendamment un nombre entier de 2 à 6.

**8.** Composé organométallique selon la revendication 7, dans lequel:

le cycle $A_{11}$ au cycle $A_{14}$, le cycle $A_{21}$ et le cycle $A_{22}$ dans les Formules 2-2 et 2-3 sont chacun indépendamment choisis parmi un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe thiophène, un groupe furane, un groupe pyrrole, un groupe indole, un groupe indène, un groupe benzosilole, un groupe benzothiophène, un groupe benzofurane, un groupe carbazole, un groupe fluorène, un groupe dibenzosilole, un groupe dibenzothiophène, un groupe dibenzofurane, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoléine, un groupe 5,6,7,8-tétrahydroquinoléine et un groupe benzoquinazoline; et/ou
$X_{21}$ et $X_{22}$ dans la Formule 2-3 sont chacun indépendamment $C(R_{23})$ et $X_{23}$ et $X_{24}$ dans la Formule 2-3 sont chacun indépendamment $C(R_{24})$.

**9.** Composé organométallique selon la revendication 7 ou la revendication 8, dans lequel:
$R_{11}$ à $R_{16}$ et $R_{21}$ à $R_{26}$ dans les Formules 2-2 et 2-3 sont chacun indépendamment choisis parmi:

un hydrogène, un deutérium, -F, -Cl, -Br, -I, un groupe hydroxyle, un groupe cyano, un groupe nitro, un groupe amidino, un groupe hydrazino, un groupe hydrazono, un groupe $C_1$-$C_{20}$ alkyle, un groupe $C_2$-$C_{20}$ alcényle, un groupe $C_2$-$C_{20}$ alcynyle et un groupe $C_1$-$C_{20}$ alcoxy;
un groupe $C_1$-$C_{20}$ alkyle, un groupe $C_2$-$C_{20}$ alcényle, un groupe $C_2$-$C_{20}$ alcynyle et un groupe $C_1$-$C_{20}$ alcoxy, chacun étant substitué avec au moins un choisi parmi un deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazino, un groupe hydrazono, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, un groupe pyrimidinyle, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$ et $-P(=O)(Q_{31})(Q_{32})$;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe acridinyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe acridinyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle et un groupe imidazopyrimidinyle, chacun étant substitué avec au moins un choisi parmi un deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazino, un groupe hydrazono, un groupe $C_1$-$C_{20}$ alkyle, un groupe $C_2$-$C_{20}$ alcényle, un groupe $C_2$-$C_{20}$ alcynyle, un groupe $C_1$-$C_{20}$ alcoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinoléinyle, un groupe isoquinoléinyle, un groupe benzoquinoléinyle, un groupe quinoxalinyle, un groupe quinazolinyle, un groupe cinnolinyle, un groupe carbazolyle, un groupe acridinyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$ et $-P(=O)(Q_{31})(Q_{32})$; et
$-Si(Q_1)(Q_2)(Q_3)$, $-N(Q_1)(Q_2)$, $-B(Q_1)(Q_2)$, $-C(=O)(Q_1)$, $-S(=O)_2(Q_1)$, $-P(Q_1)(Q_2)$ et $-P(=O)(Q_1)(Q_2)$, et
$Q_1$ à $Q_3$ et $Q_{31}$ à $Q_{33}$ sont chacun indépendamment choisis parmi:

un hydrogène, un deutérium, -F, -Cl, -Br, -I, un groupe cyano, un groupe $C_1$-$C_{20}$ alkyle, un groupe $C_2$-$C_{20}$ alcényle, un groupe $C_2$-$C_{20}$ alcynyle, un groupe $C_1$-$C_{20}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{20}$ aryle, un groupe $C_1$-$C_{20}$ hétéroaryle, un groupe polycyclique condensé non aromatique monovalent et un groupe hétéropolycyclique condensé non aromatique monovalent;
un groupe $C_1$-$C_{20}$ alkyle substitué avec au moins un choisi parmi un deutérium, -F et un groupe cyano;
un groupe $C_6$-$C_{20}$ aryle substitué avec au moins un choisi parmi un deutérium, -F et un groupe cyano; et
un groupe biphényle et un groupe terphényle.

**10.** Composé organométallique selon l'une quelconque des revendications 7 à 9, dans lequel:

$L_2$ est un ligand choisi dans des groupes représentés par les Formules 2-2(1) à 2-2(3) et 2-3(1):

<Formule 2-2(1)>

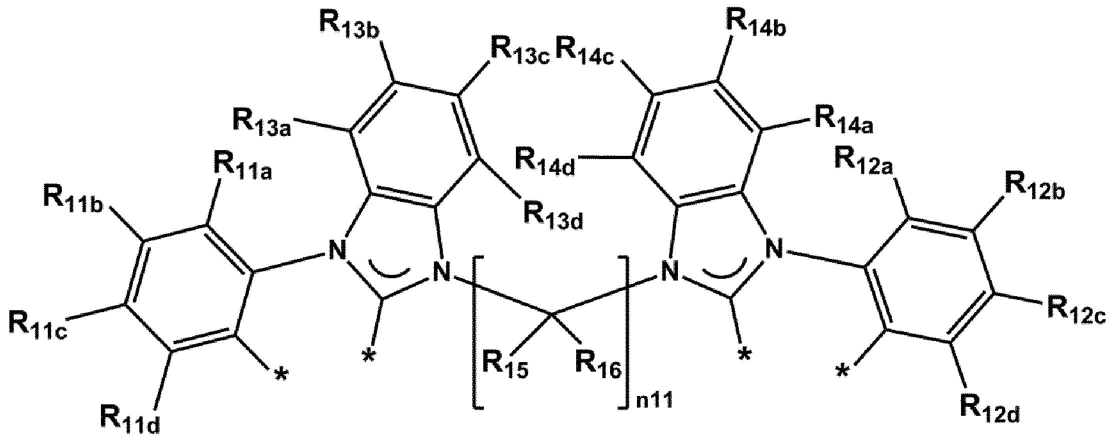

<Formule 2-2(2)>

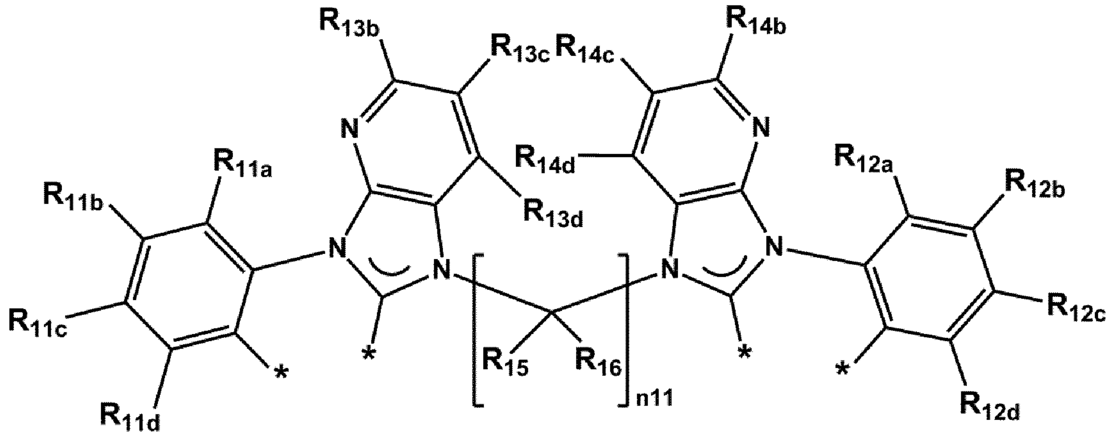

<Formule 2-2(3)>

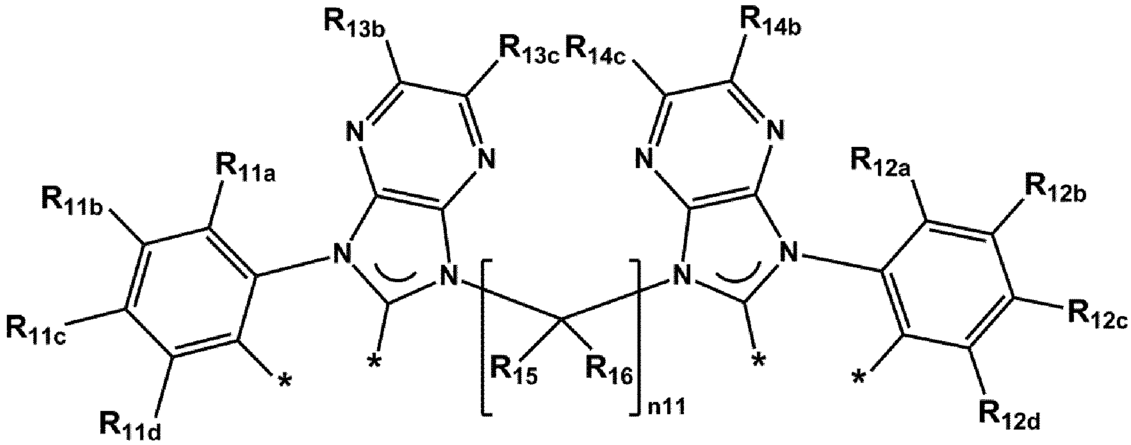

<Formule 2-3(1)>

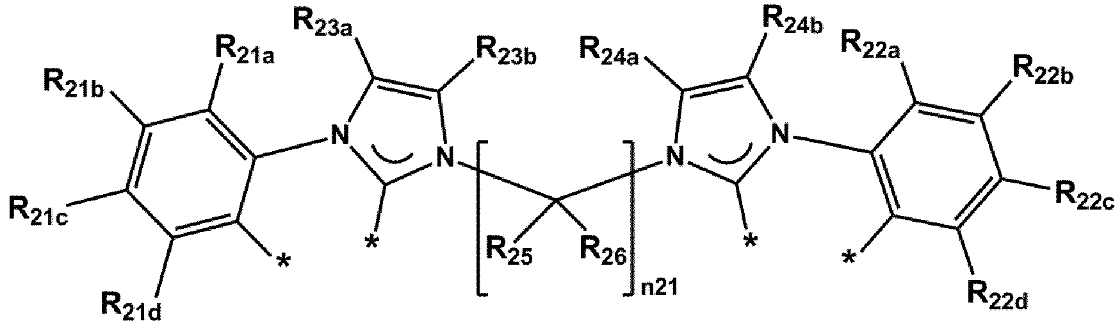

,

dans lequel, dans les Formules 2-2(1) à 2-2(3) et 2-3(1), $R_{11a}$ à $R_{11d}$, $R_{12a}$ à $R_{12d}$, $R_{13a}$ à $R_{13d}$, $R_{14a}$ à $R_{14d}$, $R_{21a}$ à $R_{21d}$, $R_{22a}$ à $R_{22d}$, $R_{23a}$, $R_{23b}$, $R_{24a}$, $R_{24b}$, n11 et n21 sont chacun indépendamment identiques à ce qui est défini conjointement à $R_{11}$ à $R_{16}$, $R_{21}$ à $R_{26}$, n11 et n21 dans la revendication 8, et
* indique un site de liaison à M.

**11.** Composé organométallique selon la revendication 1, où:

le composé organométallique est choisi parmi les Composés BD1 à BD59:

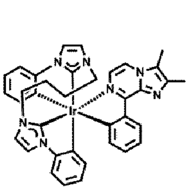

BD1

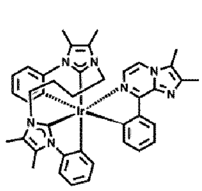

BD2

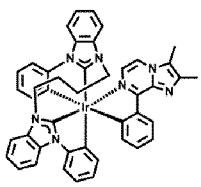

BD3

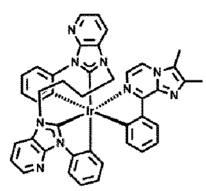

BD4

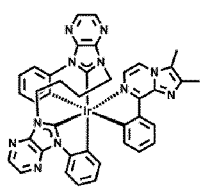

BD5

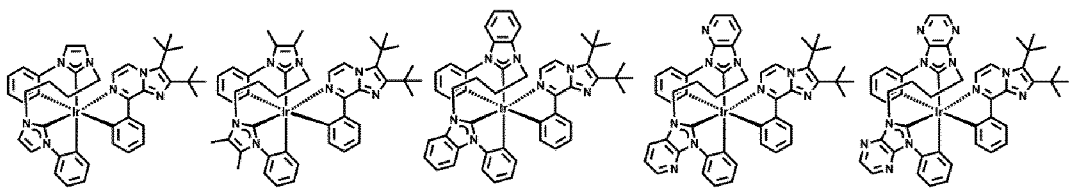

BD6 BD7 BD8 BD9 BD10

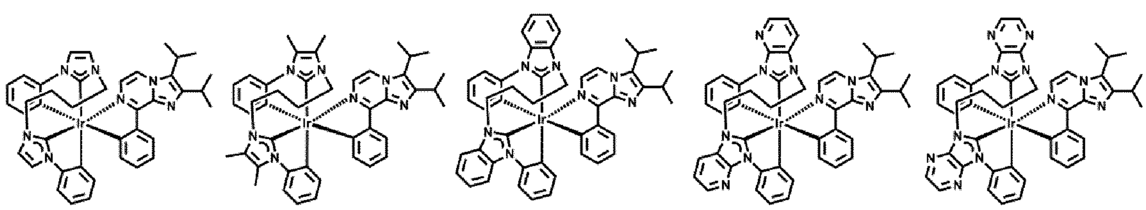

BD11 BD12 BD13 BD14 BD15

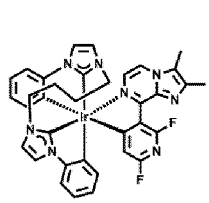
BD16
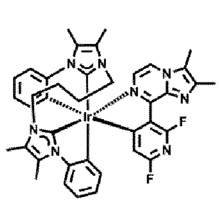
BD17
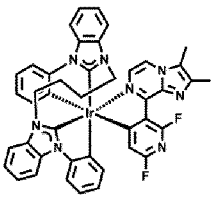
BD18
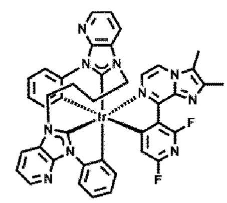
BD19
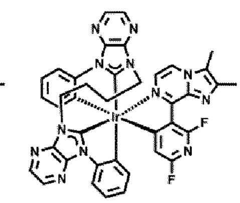
BD20

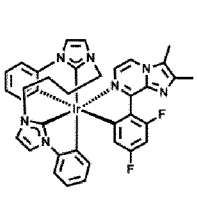
BD21
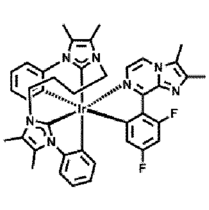
BD22
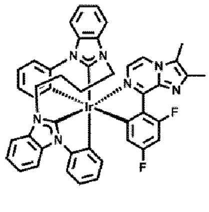
BD23
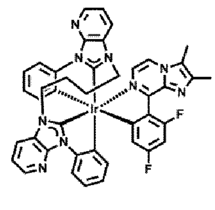
BD24
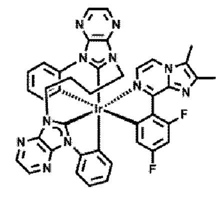
BD25

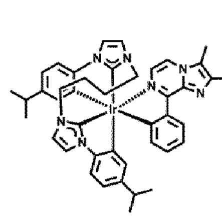
BD26
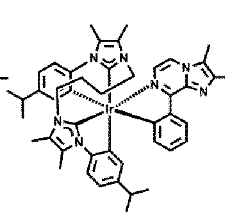
BD27
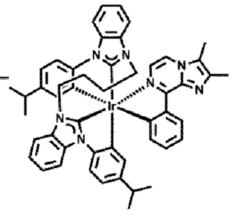
BD28
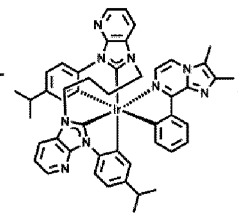
BD29
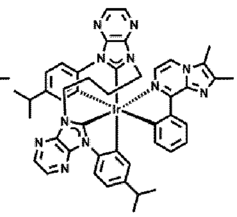
BD30

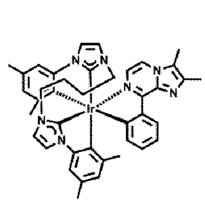
BD31
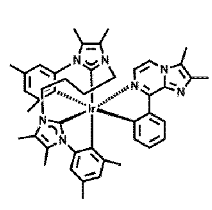
BD32
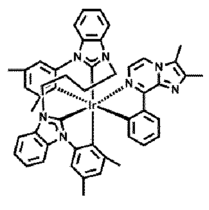
BD33
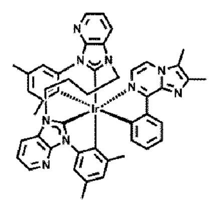
BD34
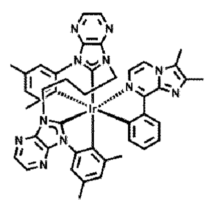
BD35

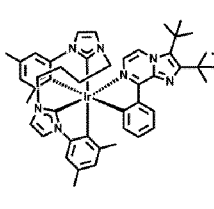
BD36
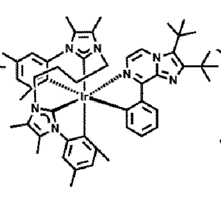
BD37
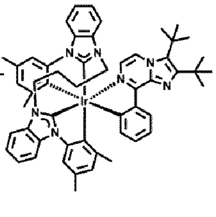
BD38
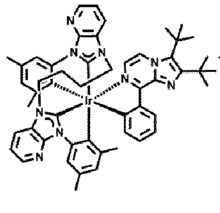
BD39
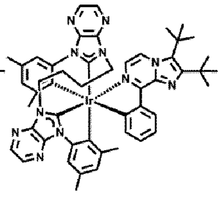
BD40

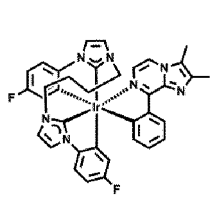 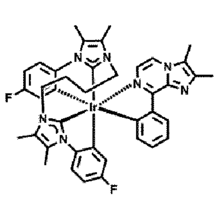 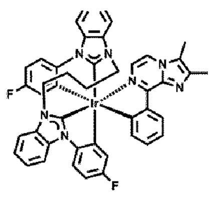 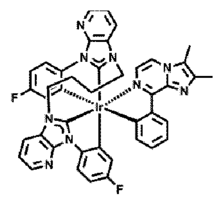 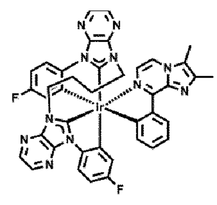

BD41 BD42 BD43 BD44 BD45

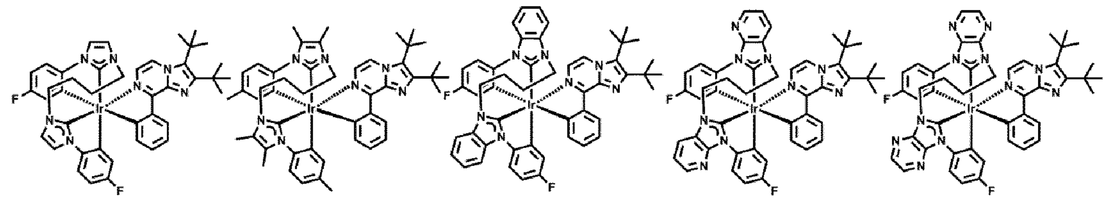

BD46 BD47 BD48 BD49 BD50

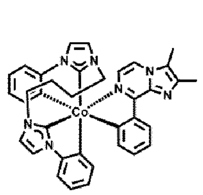 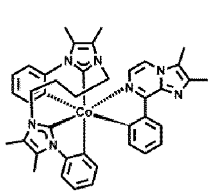 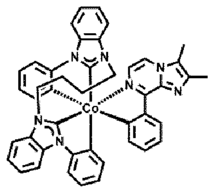 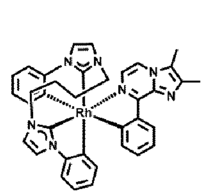 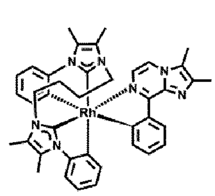

BD51 BD52 BD53 BD54 BD55

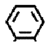 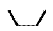 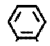

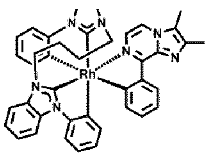 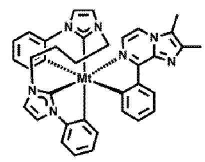 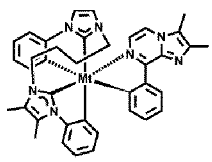 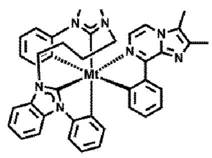

BD56 BD57 BD58 BD59

**12.** Dispositif électroluminescent organique comprenant:

une première électrode;
une deuxième électrode faisant face à la première électrode; et
une couche organique entre la première électrode et la deuxième électrode et comprenant une couche d'émission,
dans lequel la couche d'émission comprend au moins un du composé organométallique selon l'une quelconque des revendications 1 à 11,
la couche d'émission comprend en outre au moins un choisi parmi un deuxième composé et un troisième composé,
le composé organométallique, le deuxième composé et le troisième composé sont différents les uns des autres,
lorsque la couche d'émission comprend à la fois le deuxième composé et le troisième composé, le deuxième composé et le troisième composé forment un exciplexe, et
le composé organométallique et le deuxième composé et/ou le troisième composé ne forment pas un exciplexe, optionnellement dans lequel:

le deuxième composé et le troisième composé forment un exciplexe et la longueur d'onde ($\lambda_{max}$) d'émission maximum dans un spectre de photoluminescence (PL) de l'exciplexe est d'environ 390 nm ou plus et d'environ 500 nm ou moins, optionnellement dans lequel:

la différence en valeur absolue entre le niveau d'énergie de la plus basse orbitale moléculaire non occupée (LUMO) du composé organométallique et le niveau d'énergie LUMO du deuxième composé ou du troisième composé est dans un intervalle d'environ 0,1 eV à environ 10 eV, optionnellement dans lequel:

la différence en valeur absolue entre le niveau d'énergie de la plus haute orbitale moléculaire occupée (HOMO) du composé organométallique et le niveau d'énergie HOMO du deuxième composé ou du troisième composé est d'environ 1,25 eV ou moins.

**13.** Dispositif électroluminescent organique selon la revendication 12, dans lequel:

le deuxième composé est représenté par la Formule 3, et
le troisième composé est représenté par la Formule 4:

<Formule 3>

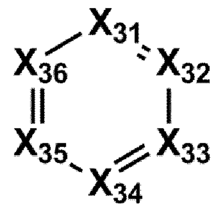

<Formule 4>

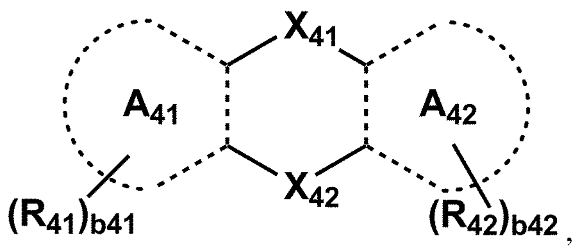

dans lequel, dans les Formules 3 et 4,
$X_{31}$ est choisi parmi $C(R_{31})$ et N, $X_{32}$ est choisi parmi $C(R_{32})$ et N, $X_{33}$ est choisi parmi $C(R_{33})$ et N, $X_{34}$ est choisi parmi $C(R_{34})$ et N, $X_{35}$ est choisi parmi $C(R_{35})$ et N et $X_{36}$ est choisi parmi $C(R_{36})$ et N, dans lequel au moins un choisi parmi $X_{31}$ à $X_{36}$ est N,
$R_{31}$ à $R_{36}$ sont chacun indépendamment choisis dans un groupe représenté par $*\text{-}(L_{31})_{a31}\text{-}(R_{37})_{b37}$, un hydrogène, un deutérium, -F, -Cl, -Br, -I, un groupe hydroxyle, un groupe cyano, un groupe nitro, un groupe amidino, un groupe hydrazino, un groupe hydrazono, un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe $C_1$-$C_{60}$ hétéroaryloxy substitué ou non substitué, un groupe $C_1$-$C_{60}$ hétéroarylthio substitué ou non substitué, un groupe polycyclique condensé non aromatique monovalent substitué ou non substitué, un groupe hétéropolycyclique condensé non aromatique monovalent substitué ou non substitué, $-Si(Q_1)(Q_2)(Q_3)$, $-B(Q_1)(Q_2)$, $-N(Q_1)(Q_2)$, - $P(Q_1)(Q_2)$, $-C(=O)(Q_1)$, $-S(=O)(Q_1)$, $-S(=O)_2(Q_1)$, $-P(=O)(Q_1)(Q_2)$ et $-P(=S)(Q_1)(Q_2)$, dans lequel au moins un choisi parmi $R_{31}$ à $R_{36}$ est un groupe représenté par $*\text{-}(L_{31})_{a31}\text{-}(R_{37})_{b37}$,
$L_{31}$ est choisi parmi un groupe $C_5$-$C_{60}$ carbocyclique substitué ou non substitué et un groupe $C_1$-$C_{60}$ hétérocyclique substitué ou non substitué,
a31 est un nombre entier de 0 à 6,
$R_{37}$ est choisi parmi un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle

substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe $C_1$-$C_{60}$ hétéroaryloxy substitué ou non substitué, un groupe $C_1$-$C_{60}$ hétéroarylthio substitué ou non substitué, un groupe polycyclique condensé non aromatique monovalent substitué ou non substitué, un groupe hétéropolycyclique condensé non aromatique monovalent substitué ou non substitué, $-Si(Q_1)(Q_2)(Q_3)$, - $B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, - $P(=O)(Q_1)(Q_2)$ et $-P(=S)(Q_1)(Q_2)$,

b37 est un nombre entier de 1 à 10,

$A_{41}$ et $A_{42}$ sont chacun indépendamment choisis parmi un groupe $C_5$-$C_{60}$ carbocyclique et un groupe $C_1$-$C_{60}$ hétérocyclique,

$X_{41}$ est choisi parmi une liaison simple, O, S, $B(R_{43})$, $N(R_{43})$, $C(R_{43})(R_{44})$ et $Si(R_{43})(R_{44})$ et $X_{42}$ est choisi parmi une liaison simple, O, S, $B(R_{45})$, $N(R_{45})$, $C(R_{45})(R_{46})$ et $Si(R_{45})(R_{46})$, dans lequel $X_{41}$ et $X_{42}$ ne sont pas une liaison simple en même temps,

$R_{41}$ à $R_{46}$ sont chacun indépendamment choisis dans un groupe représenté par $*-(L_{41})_{a41}-(R_{47})_{b47}$, un hydrogène, un deutérium, -F, -Cl, -Br, -I, un groupe hydroxyle, un groupe cyano, un groupe nitro, un groupe amidino, un groupe hydrazino, un groupe hydrazono, un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe $C_1$-$C_{60}$ hétéroaryloxy substitué ou non substitué, un groupe $C_1$-$C_{60}$ hétéroarylthio substitué ou non substitué, un groupe polycyclique condensé non aromatique monovalent substitué ou non substitué, un groupe hétéropolycyclique condensé non aromatique monovalent substitué ou non substitué, $-Si(Q_1)(Q_2)(Q_3)$, $-B(Q_1)(Q_2)$, $-N(Q_1)(Q_2)$, - $P(Q_1)(Q_2)$, $-C(=O)(Q_1)$, $-S(=O)(Q_1)$, $-S(=O)_2(Q_1)$, $-P(=O)(Q_1)(Q_2)$ et $-P(=S)(Q_1)(Q_2)$, dans lequel au moins un choisi parmi $R_{41}$ à $R_{46}$ est un groupe représenté par $*-(L_{41})_{a41}-(R_{47})_{b47}$,

$L_{41}$ est choisi parmi un groupe $C_5$-$C_{60}$ carbocyclique substitué ou non substitué et un groupe $C_1$-$C_{60}$ hétérocyclique substitué ou non substitué,

a41 est un nombre entier de 0 à 6,

$R_{47}$ est choisi parmi un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe $C_1$-$C_{60}$ hétéroaryloxy substitué ou non substitué, un groupe $C_1$-$C_{60}$ hétéroarylthio substitué ou non substitué, un groupe polycyclique condensé non aromatique monovalent substitué ou non substitué, un groupe hétéropolycyclique condensé non aromatique monovalent substitué ou non substitué, $-Si(Q_1)(Q_2)(Q_3)$, - $B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, - $P(=O)(Q_1)(Q_2)$ et $-P(=S)(Q_1)(Q_2)$,

b47 est un nombre entier de 1 à 10,

$Q_1$ à $Q_3$ sont chacun indépendamment choisis parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_6$-$C_{60}$ aryloxy, un groupe $C_6$-$C_{60}$ arylthio, un groupe $C_1$-$C_{60}$ hétéroaryle, un groupe $C_1$-$C_{60}$ hétéroaryloxy, un groupe $C_1$-$C_{60}$ hétéroarylthio, un groupe polycyclique condensé non aromatique monovalent, un groupe hétéropolycyclique condensé non aromatique monovalent, un groupe biphényle et un groupe terphényle, et

* indique un site de liaison à un atome voisin.

**14.** Dispositif électroluminescent organique selon la revendication 13, dans lequel:

le deuxième composé est choisi parmi les Composés ETH1 à ETH80 et le troisième composé est choisi parmi les Composés HTH1 à HTH28:

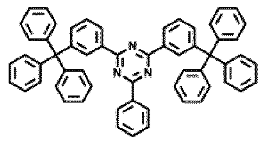
ETH1

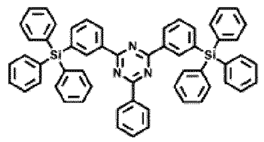
ETH2

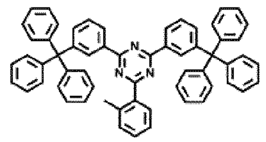
ETH3

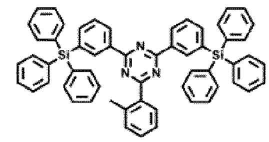
ETH4

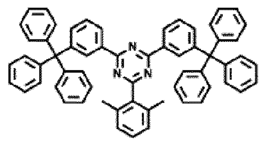
ETH5

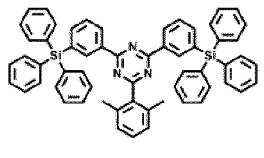
ETH6

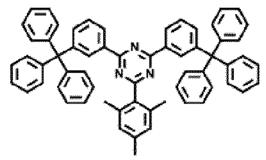
ETH7

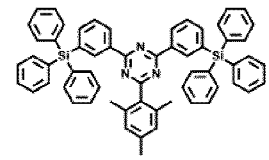
ETH8

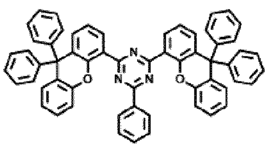
ETH9

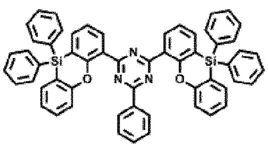
ETH10

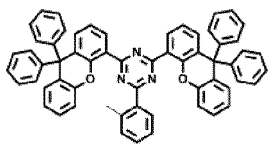
ETH11

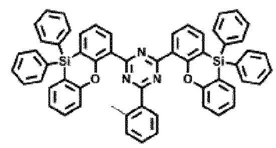
ETH12

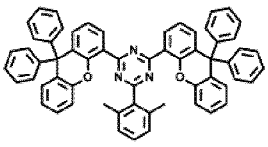
ETH13

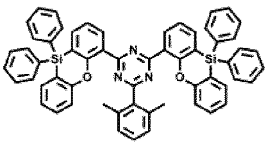
ETH14

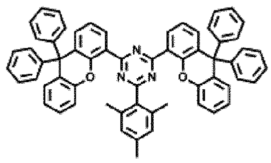
ETH15

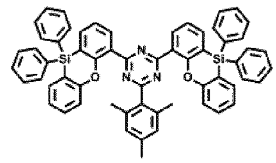
ETH16

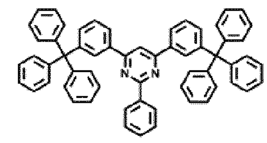
ETH17

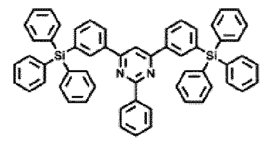
ETH18

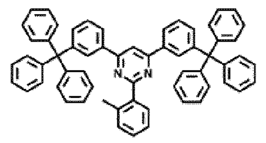
ETH19

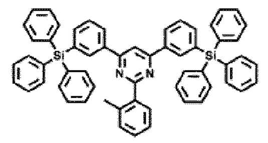
ETH20

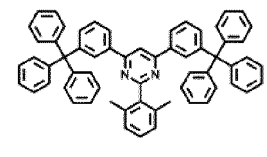
ETH21

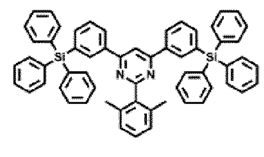
ETH22

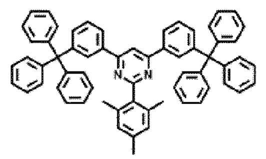
ETH23

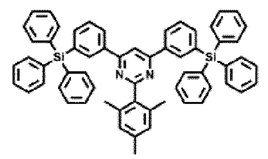
ETH24

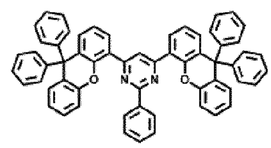
ETH25

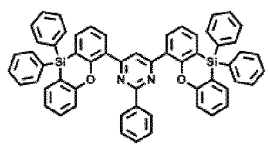
ETH26

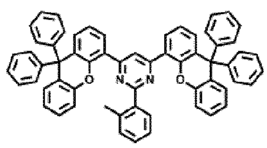
ETH27

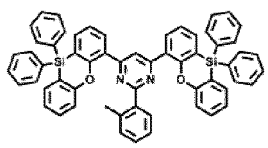
ETH28

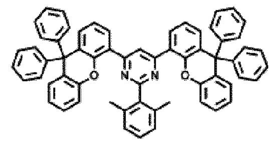 ETH29

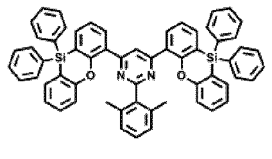 ETH30

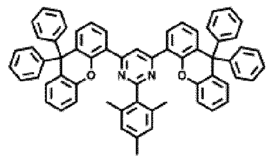 ETH31

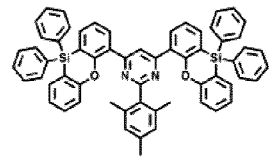 ETH32

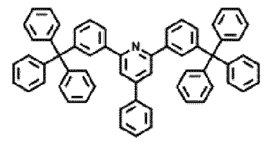 ETH33

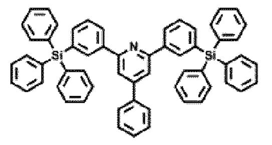 ETH34

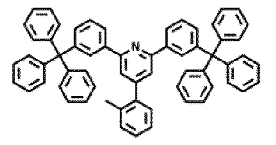 ETH35

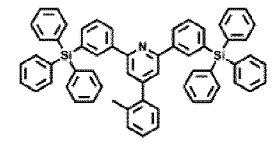 ETH36

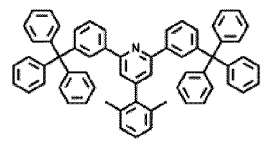 ETH37

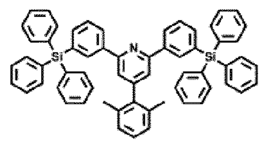 ETH38

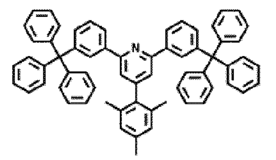 ETH39

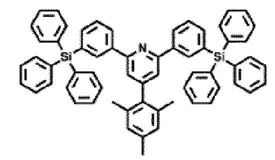 ETH40

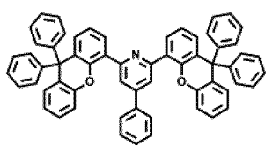 ETH41

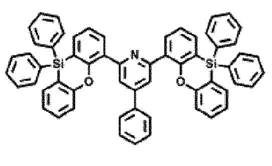 ETH42

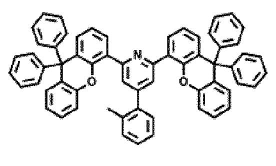 ETH43

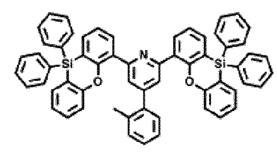 ETH44

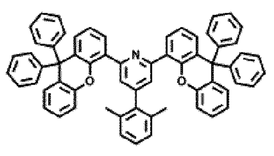 ETH45

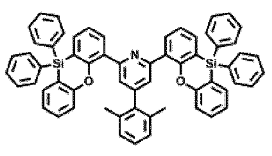 ETH46

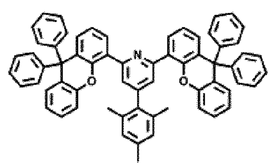 ETH47

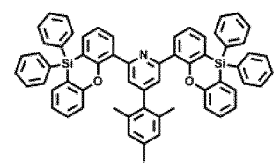 ETH48

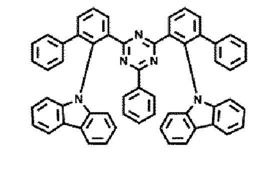 ETH49

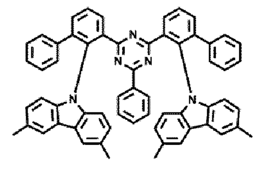 ETH50

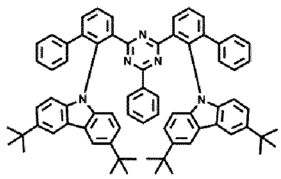 ETH51

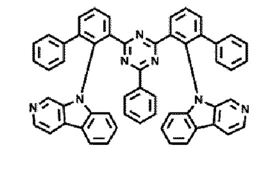 ETH52

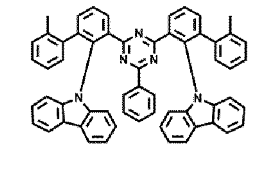 ETH53

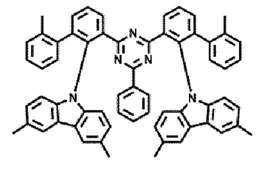 ETH54

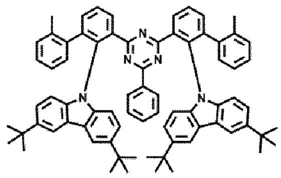 ETH55

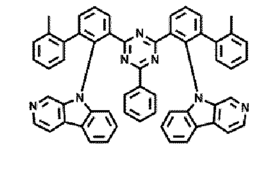 ETH56

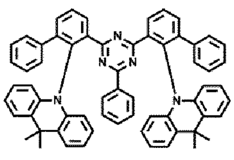
ETH57

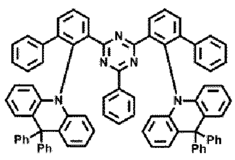
ETH58

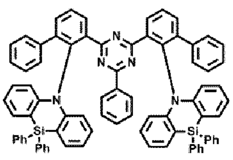
ETH59

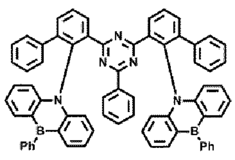
ETH60

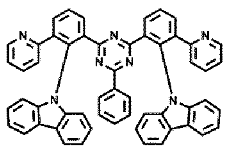
ETH61

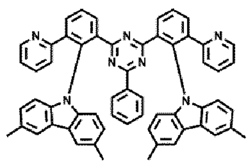
ETH62

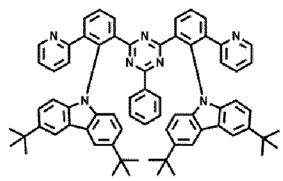
ETH63

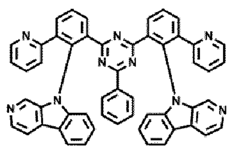
ETH64

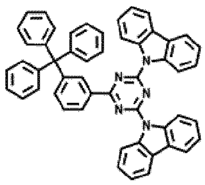
ETH65

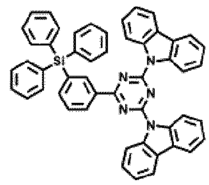
ETH66

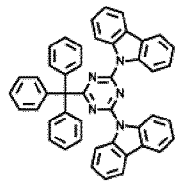
ETH67

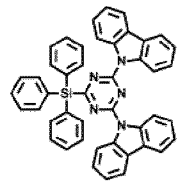
ETH68

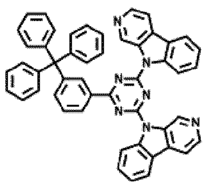
ETH69

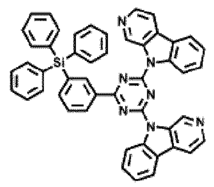
ETH70

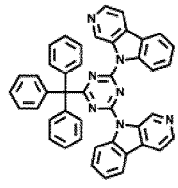
ETH71

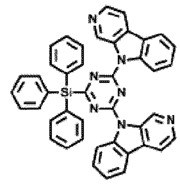
ETH72

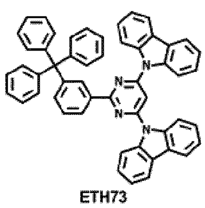
ETH73

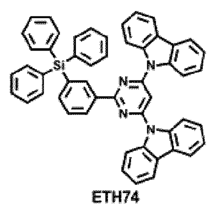
ETH74

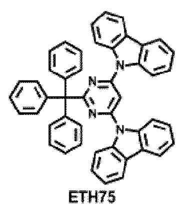
ETH75

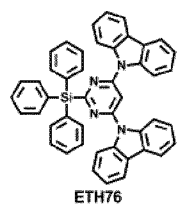
ETH76

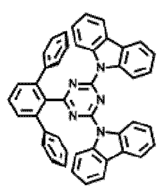
ETH77

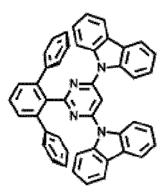
ETH78

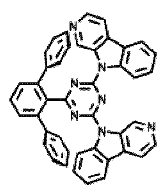
ETH79

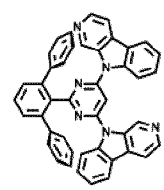
ETH80

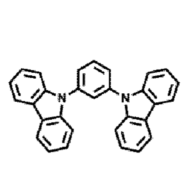
HTH1

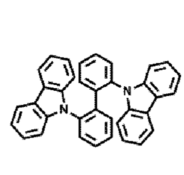
HTH2

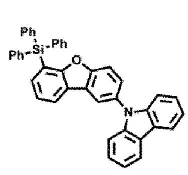
HTH3

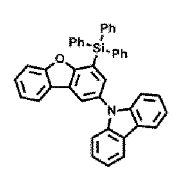
HTH4

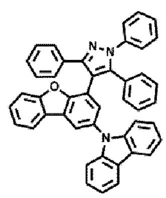
HTH5

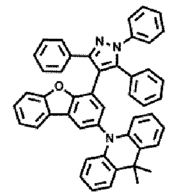
HTH6

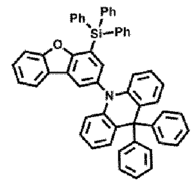
HTH7

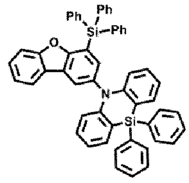
HTH8

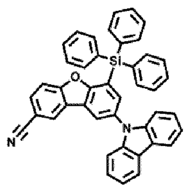
HTH9

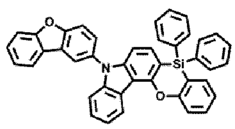
HTH10

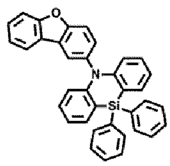
HTH11

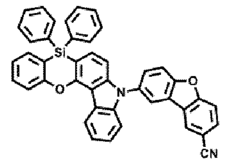
HTH12

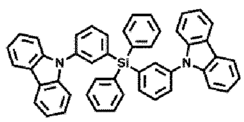
HTH13

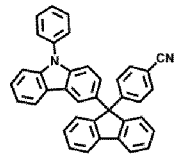
HTH14

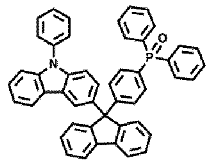
HTH15

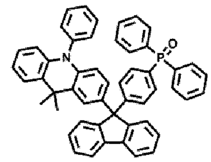
HTH16

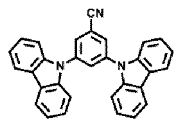
HTH17

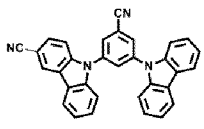
HTH18

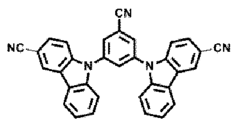
HTH19

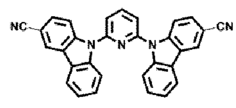
HTH20

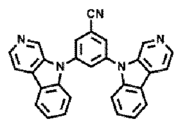
HTH21

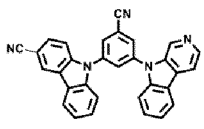
HTH22

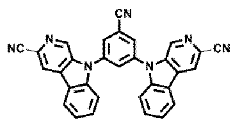
HTH23

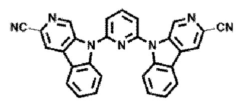
HTH24

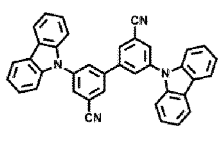
HTH25

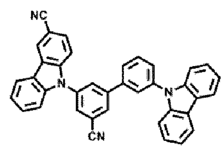
HTH26

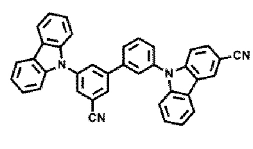
HTH27

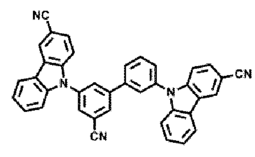
HTH28 .

**15.** Dispositif électroluminescent organique selon l'une quelconque des revendications 12 à 14, dans lequel: le temps de déclin de fluorescence retardée dans un spectre d'électroluminescence à résolution temporelle (TREL) du dispositif électroluminescent organique est d'environ 50 ns ou plus.

FIG. 1

10

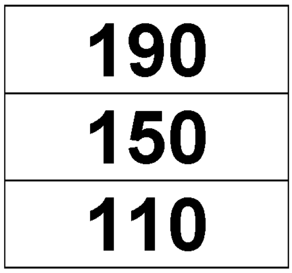

FIG. 2

20

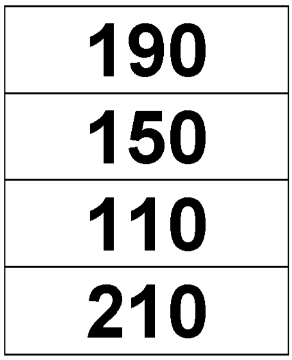

FIG. 3

30

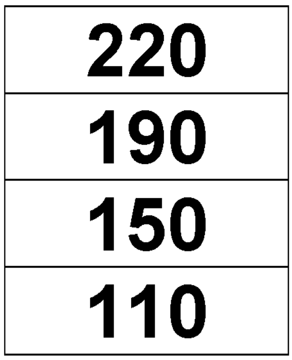

FIG. 4

40

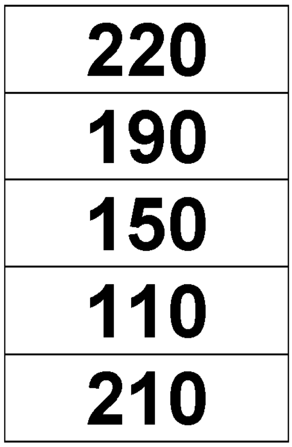

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2017170414 A1